# EUROPEAN PATENT APPLICATION

(11) **EP 4 199 127 A1**
(43) Date of publication of application: **21.06.2023**
(21) Application number: 21856103.3
(22) Date of filing: 28.07.2021
(51) Int. Cl.: H01L 51/00, H01L 51/50

(54) **ORGANIC LIGHT-EMITTING DEVICE AND COMPOSITION FOR FORMING ORGANIC MATERIAL LAYER**

(30) Priority: 14.08.2020 KR 20200102343
(71) Applicant: LT Materials Co., Ltd., Yongin-si, Gyeonggi-do 17118 (KR)
(72) Inventor: LEE, Yong-Hui, Yongin-si, Gyeonggi-do 17118 (KR); MO, Jun-Tae, Yongin-si, Gyeonggi-do 17118 (KR); BYUN, Ji-Yoon, Yongin-si, Gyeonggi-do 17118 (KR); KIM, Dong-Jun, Yongin-si, Gyeonggi-do 17118 (KR)
(74) Representative: Goddar, Heinz J.
(86) International application number: PCT/KR2021/009809
(87) International publication number: WO 2022/035097

(57) **Abstract**

The present specification relates to an organic light emitting device, and a composition for forming an organic material layer.

## Description

### [Technical Field]

The present specification relates to an organic light emitting device, and a composition for forming an organic material layer.

The present specification claims priority to and the benefits of Korean Patent Application No. 10-2020-0102343, filed with the Korean Intellectual Property Office on August 14, 2020, the entire contents of which are incorporated herein by reference.

### [Background Art]

An electroluminescent device is one type of self-emissive display devices, and has an advantage of having a wide viewing angle, and a high response speed as well as having an excellent contrast.

An organic light emitting device has a structure disposing an organic thin film between two electrodes. When a voltage is applied to an organic light emitting device having such a structure, electrons and holes injected from the two electrodes bind and pair in the organic thin film, and light emits as these annihilate. The organic thin film may be formed in a single layer or a multilayer as necessary.

A material of the organic thin film may have a light emitting function as necessary. For example, as a material of the organic thin film, compounds capable of forming a light emitting layer themselves alone may be used, or compounds capable of performing a role of a host or a dopant of a host-dopant-based light emitting layer may also be used. In addition thereto, compounds capable of performing roles of hole injection, hole transfer, electron blocking, hole blocking, electron transfer, electron injection and the like may also be used as a material of the organic thin film.

Development of an organic thin film material has been continuously required for enhancing performance, lifetime or efficiency of an organic light emitting device.

### [Disclosure]

### [Technical Problem]

The present specification is directed to providing an organic light emitting device, and a composition for forming an organic material layer.

### [Technical Solution]

One embodiment of the present specification provides an organic light emitting device including a first electrode; a second electrode; and an organic material layer provided between the first electrode and the second electrode, wherein the organic material layer includes a compound of the following Chemical Formula 1 and a compound of the following Chemical Formula 2. 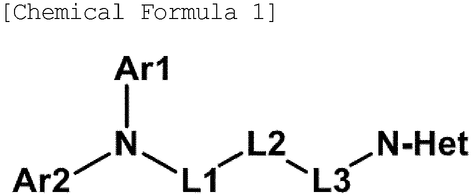 In Chemical Formula 1,
L1 to L3 are the same as or different from each other, and each independently a direct bond; a C6 to C60 arylene group; a monocyclic heteroarylene group including N; or a tricyclic or higher heteroarylene group including O,
Ar1 and Ar2 are the same as or different from each other, and each independently a substituted or unsubstituted C1 to C60 alkyl group; a substituted or unsubstituted C3 to C60 cycloalkyl group; a substituted or unsubstituted C6 to C60 aryl group; or a substituted or unsubstituted C2 to C60 heteroaryl group, and
N-Het is a C2 to C60 heteroaryl group substituted or unsubstituted and including N, 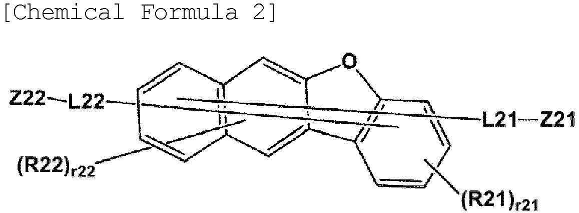 in Chemical Formula 2,
L21 and L22 are the same as or different from each other, and each independently a direct bond; a C6 to C60 arylene group; or a C2 to C60 heteroarylene group,
Z21 and Z22 are the same as or different from each other, and each independently a substituted or unsubstituted C6 to C60 aryl group; or a substituted or unsubstituted C2 to C60 heteroaryl group,
at least one of Z21 and Z22 is a C2 to C60 heteroaryl group substituted or unsubstituted and including N,
R21 and R22 are the same as or different from each other, and each independently hydrogen; deuterium; a halogen group; a cyano group; a substituted or unsubstituted C1 to C60 alkyl group; a substituted or unsubstituted C6 to C60 aryl group; or a substituted or unsubstituted C2 to C60 heteroaryl group,
r21 is an integer of 0 to 4,
r22 is an integer of 0 to 6, and
when r21 and r22 are each 2 or greater, substituents in the parentheses are the same as or different from each other.

Another embodiment of the present specification provides a composition for forming an organic material layer, the composition including the compound of Chemical Formula 1 and the compound of Chemical Formula 2.

### [Advantageous Effects]

An organic light emitting device of the present specification includes an organic material layer including a compound of Chemical Formula 1 and a compound of Chemical Formula 2, and the organic material layer including the compounds may be a hole injection layer, a hole transfer layer, a light emitting layer, an electron transfer layer, an electron injection layer, a charge generation layer or the like. Particularly, the organic material layer including the compounds may be a light emitting layer of the organic light emitting device.

When using the compound of Chemical Formula 1 and a compound of Chemical Formula 2 together as a material of a light emitting layer of the organic light emitting device, a driving voltage can be lowered, light emission efficiency can be enhanced, and lifetime properties can be enhanced in the device.

Specifically, by using the compound of Chemical Formula 1 including a heteroaryl group including N and an amine group, and the compound of Chemical Formula 2 having naphthobenzofuran as a core structure and substituted with a heteroaryl group including N together as a host material of a light emitting layer, driving voltage, light emission efficiency and lifetime properties are improved by enhancing mobility of electrons and holes, and enhancing a charge balance.

### [Description of Drawings]

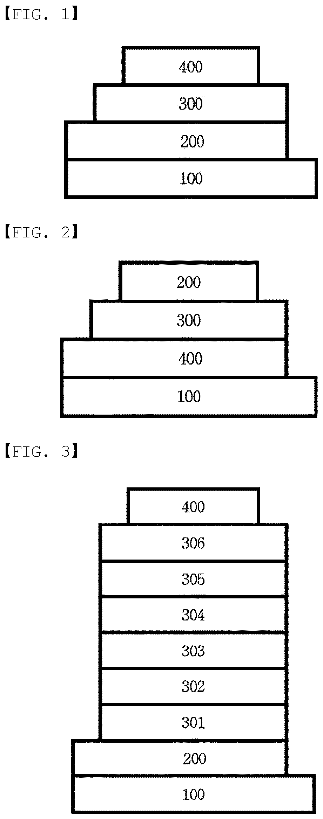

FIG. 1 to FIG. 3 are diagrams each illustrating a lamination structure of an organic light emitting device according to one embodiment of the present specification.
- 100:: Substrate
- 200:: Anode
- 300:: Organic Material Layer
- 301:: Hole Injection Layer
- 302:: Hole Transfer Layer
- 303:: Light Emitting Layer
- 304:: Hole Blocking Layer
- 305:: Electron Transfer Layer
- 306:: Electron Injection Layer
- 400:: Cathode

### [Mode for Disclosure]

Hereinafter, the present specification will be described in more detail.

In the present specification, a description of a certain part "including" certain constituents means capable of further including other constituents, and does not exclude other constituents unless particularly stated on the contrary.

A term "substitution" means a hydrogen atom bonding to a carbon atom of a compound being changed to another substituent, and the position of substitution is not limited as long as it is a position at which the hydrogen atom is substituted, that is, a position at which a substituent is capable of substituting, and when two or more substituents substitute, the two or more substituents may be the same as or different from each other.

In the present specification, "substituted or unsubstituted" means being substituted with one or more substituents selected from the group consisting of deuterium; a halogen group; a cyano group; a C1 to C60 alkyl group; a C2 to C60 alkenyl group; a C2 to C60 alkynyl group; a C3 to C60 cycloalkyl group; a C2 to C60 heterocycloalkyl group; a C6 to C60 aryl group; a C2 to C60 heteroaryl group; a silyl group; a phosphine oxide group; and an amine group, or being unsubstituted, or being substituted with a substituent linking two or more substituents selected from among the substituents illustrated above, or being unsubstituted.

In the present specification, a "case of a substituent being not indicated in a chemical formula or compound structure" means that a hydrogen atom bonds to a carbon atom. However, since deuterium (²H) is an isotope of hydrogen, some hydrogen atoms may be deuterium.

In one embodiment of the present application, a "case of a substituent being not indicated in a chemical formula or compound structure" may mean that positions that may come as a substituent may all be hydrogen or deuterium. In other words, since deuterium is an isotope of hydrogen, some hydrogen atoms may be deuterium that is an isotope, and herein, a content of the deuterium may be from 0% to 100%.

In one embodiment of the present application, in a "case of a substituent being not indicated in a chemical formula or compound structure", hydrogen and deuterium may be mixed in compounds when deuterium is not explicitly excluded such as a deuterium content being 0%, a hydrogen content being 100% or substituents being all hydrogen.

In one embodiment of the present application, deuterium is one of isotopes of hydrogen, is an element having deuteron formed with one proton and one neutron as a nucleus, and may be expressed as hydrogen-2, and the elemental symbol may also be written as D or ²H.

In one embodiment of the present application, an isotope means an atom with the same atomic number (Z) but with a different mass number (A), and may also be interpreted as an element with the same number of protons but with a different number of neutrons.

In one embodiment of the present application, a meaning of a content T% of a specific substituent may be defined as T2/T1×100=T% when the total number of substituents that a basic compound may have is defined as T1, and the number of specific substituents among these is defined as T2.

In other words, in one example, having a deuterium content of 20% in a phenyl group represented by 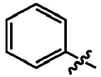 means that the total number of substituents that the phenyl group may have is 5 (T1 in the formula), and the number of deuterium among these is 1 (T2 in the formula). In other words, having a deuterium content of 20% in a phenyl group may be represented by the following structural formulae.

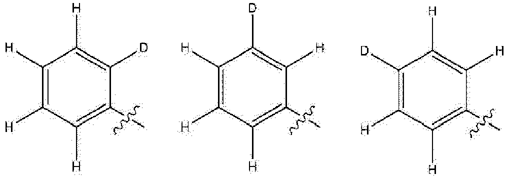

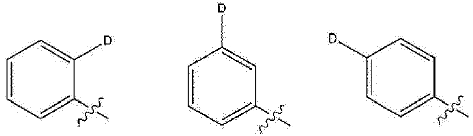

In addition, in one embodiment of the present application, "a phenyl group having a deuterium content of 0%" may mean a phenyl group that does not include a deuterium atom, that is, a phenyl group that has 5 hydrogen atoms.

In the present specification, the halogen may be fluorine, chlorine, bromine or iodine.

In the present specification, the alkyl group includes linear or branched, and may be further substituted with other substituents. The number of carbon atoms of the alkyl group may be from 1 to 60, specifically from 1 to 40 and more specifically from 1 to 20. Specific examples thereof may include a methyl group, an ethyl group, a propyl group, an n-propyl group, an isopropyl group, a butyl group, an n-butyl group, an isobutyl group, a tert-butyl group, a sec-butyl group, a 1-methyl-butyl group, a 1-ethyl-butyl group, a pentyl group, an n-pentyl group, an isopentyl group, a neopentyl group, a tert-pentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethylpropyl group, a 1,1-dimethyl-propyl group, an isohexyl group, a 2-methylpentyl group, a 4-methylhexyl group, a 5-methylhexyl group and the like, but are not limited thereto.

In the present specification, the alkenyl group includes linear or branched, and may be further substituted with other substituents. The number of carbon atoms of the alkenyl group may be from 2 to 60, specifically from 2 to 40 and more specifically from 2 to 20. Specific examples thereof may include a vinyl group, a 1-propenyl group, an isopropenyl group, a 1-butenyl group, a 2-butenyl group, a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group and the like, but are not limited thereto.

In the present specification, the alkynyl group includes linear or branched, and may be further substituted with other substituents. The number of carbon atoms of the alkynyl group may be from 2 to 60, specifically from 2 to 40 and more specifically from 2 to 20.

In the present specification, the cycloalkyl group includes monocyclic or polycyclic having 3 to 60 carbon atoms, and may be further substituted with other substituents. Herein, the polycyclic means a group in which the cycloalkyl group is directly linked to or fused with other cyclic groups. Herein, the other cyclic groups may be a cycloalkyl group, but may also be different types of cyclic groups such as a heterocycloalkyl group, an aryl group and a heteroaryl group. The number of carbon groups of the cycloalkyl group may be from 3 to 60, specifically from 3 to 40 and more specifically from 5 to 20. Specific examples thereof may include a cyclopropyl group, a cyclobutyl group, a cyclopentyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group, a cyclooctyl group and the like, but are not limited thereto.

In the present specification, the heterocycloalkyl group includes O, S, Se, N or Si as a heteroatom, includes monocyclic or polycyclic having 2 to 60 carbon atoms, and may be further substituted with other substituents. Herein, the polycyclic means a group in which the heterocycloalkyl group is directly linked to or fused with other cyclic groups. Herein, the other cyclic groups may be a heterocycloalkyl group, but may also be different types of cyclic groups such as a cycloalkyl group, an aryl group and a heteroaryl group. The number of carbon atoms of the heterocycloalkyl group may be from 2 to 60, specifically from 2 to 40 and more specifically from 3 to 20.

In the present specification, the aryl group includes monocyclic or polycyclic having 6 to 60 carbon atoms, and may be further substituted with other substituents. Herein, the polycyclic means a group in which the aryl group is directly linked to or fused with other cyclic groups. Herein, the other cyclic groups may be an aryl group, but may also be different types of cyclic groups such as a cycloalkyl group, a heterocycloalkyl group and a heteroaryl group. The aryl group includes a spiro group. The number of carbon atoms of the aryl group may be from 6 to 60, specifically from 6 to 40 and more specifically from 6 to 25. When the aryl group is dicyclic or higher, the number of carbon atoms may be from 8 to 60, 8 to 40, or 8 to 30. Specific examples of the aryl group may include a phenyl group, a biphenyl group, a terphenyl group, a naphthyl group, an anthryl group, a chrysenyl group, a phenanthrenyl group, a perylenyl group, a fluoranthenyl group, a triphenylenyl group, a phenalenyl group, a pyrenyl group, a tetracenyl group, a pentacenyl group, a fluorenyl group, an indenyl group, an acenaphthylenyl group, a benzofluorenyl group, a spirobifluorenyl group, a 2,3-dihydro-1H-indenyl group, a fused ring group thereof, and the like, but are not limited thereto.

In the present specification, the terphenyl group may be selected from among the following structures.

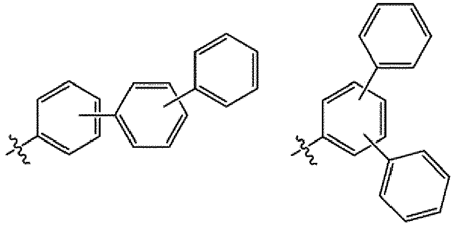

In the present specification, the fluorenyl group may be substituted, and adjacent substituents may bond to each other to form a ring.

When the fluorenyl group is substituted, 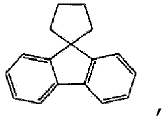 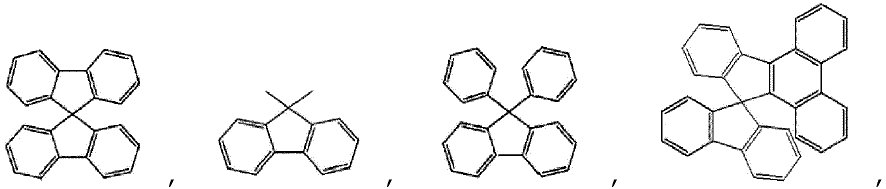 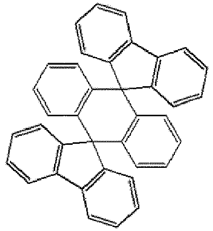 and the like may be included, however, the structure is not limited thereto.

In the present specification, the benzofluorenyl group is a group having a benzene ring fused to the fluorenyl group, and may be further substituted with an additional substituent.

In the present specification, the heteroaryl group includes O, S, SO₂, Se, N or Si as a heteroatom, includes monocyclic or polycyclic, and may be further substituted with other substituents. Herein, the polycyclic means a group in which the heteroaryl group is directly linked to or fused with other cyclic groups. Herein, the other cyclic groups may be a heteroaryl group, but may also be different types of cyclic groups such as a cycloalkyl group, a heterocycloalkyl group and an aryl group. The number of carbon atoms of the heteroaryl group may be from 2 to 60, specifically from 2 to 40 and more specifically from 3 to 25. When the heteroaryl group is dicyclic or higher, the number of carbon atoms may be from 4 to 60, 4 to 40, or 4 to 25. Specific examples of the heteroaryl group may include a pyridyl group, a pyrrolyl group, a pyrimidyl group, a pyridazinyl group, a furanyl group, a thiophene group, an imidazolyl group, a pyrazolyl group, an oxazolyl group, an isoxazolyl group, a thiazolyl group, an isothiazolyl group, a triazolyl group, a furazanyl group, an oxadiazolyl group, a thiadiazolyl group, a dithiazolyl group, a tetrazolyl group, a pyranyl group, a thiopyranyl group, a diazinyl group, an oxazinyl group, a thiazinyl group, a dioxynyl group, a triazinyl group, a tetrazinyl group, a quinolyl group, an isoquinolyl group, a quinazolinyl group, an isoquinazolinyl group, a qninozolinyl group, a naphthyridyl group, an acridinyl group, a phenanthridinyl group, an imidazopyridinyl group, a diazanaphthalenyl group, a triazaindene group, an indolyl group, an indolizinyl group, a benzothiazolyl group, a benzoxazolyl group, a benzimidazolyl group, a benzothiophene group, a benzofuran group, a dibenzothiophene group, a dibenzofuran group, a benzonaphthothiophene group, a naphthobenzofuran group, a carbazolyl group, a benzocarbazolyl group, a dibenzocarbazolyl group, a phenazinyl group, a dibenzosilole group, spirobi(dibenzosilole), a dihydrophenazinyl group, a phenoxazinyl group, a phenanthridyl group, an imidazopyridinyl group, a thienyl group, an indolo[2,3-a]carbazolyl group, an indolo[2,3-b]carbazolyl group, an indolinyl group, a 10,11-dihydro-dibenzo[b,f]azepine group, a 9,10-dihydroacridinyl group, a phenanthrazinyl group, a phenothiathiazinyl group, a phthalazinyl group, a naphthylidinyl group, a phenanthrolinyl group, a benzo[c][1,2,5]thiadiazolyl group, 5,10-dihydrobenzo[b,e][1,4]azasilinyl, a pyrazolo[1,5-c]quinazolinyl group, a pyrido[1,2-b]indazolyl group, a pyrido[1,2-a]imidazo[1,2-e]indolinyl group, a benzofuro[2,3-d]pyrimidyl group; a benzothieno[2,3-d]pyrimidyl group; a benzofuro[2,3-a]carbazolyl group, a benzothieno[2,3-a]carbazolyl group, a 1,3-dihydroindolo[2,3-a]carbazolyl group, a benzofuro[3,2-a]carbazolyl group, a benzothieno[3,2-a]carbazolyl group, a 1,3-dihydroindolo[3,2-a]carbazolyl group, a benzofuro[2,3-b]carbazolyl group, a benzothieno[2,3-b]carbazolyl group, a 1,3-dihydroindolo[2,3-b]carbazolyl group, a benzofuro[3,2-b]carbazolyl group, a benzothieno[3,2-b]carbazolyl group, a 1,3-dihydroindolo[3,2-b]carbazolyl group, a benzofuro[2,3-c]carbazolyl group, a benzothieno[2,3-c]carbazolyl group, a 1,3-dihydroindolo[2,3-c]carbazolyl group, a benzofuro[3,2-c]carbazolyl group, a benzothieno[3,2-c]carbazolyl group, a 1,3-dihydroindolo[3,2-c]carbazolyl group, a 1,3-dihydroindeno[2,1-b]carbazolyl group, a 5,11-dihydroindeno[1,2-b]carbazolyl group, a 5,12-dihydroindeno[1,2-c]carbazolyl group, a 5,8-dihydroindeno[2,1-c]carbazolyl group, a 7,12-dihydroindeno[1,2-a]carbazolyl group, a 11,12-dihydroindeno[2,1-a]carbazolyl group and the like, but are not limited thereto.

In the present specification, the naphthobenzofuran group is represented by any one of the following structures.

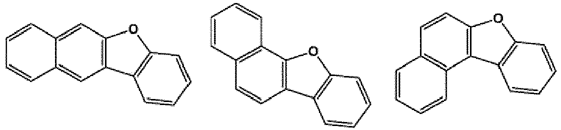

In the present specification, the silyl group is a substituent including Si, having the Si atom directly linked as a radical, and is represented by -Si (R101) (R102) (R103) . R101 to R103 are the same as or different from each other, and may be each independently a substituent formed with at least one of hydrogen; deuterium; a halogen group; an alkyl group; an alkenyl group; an alkoxy group; a cycloalkyl group; an aryl group; and a heteroaryl group. Specific examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group and the like, but are not limited thereto.

In the present specification, the phosphine oxide group is represented by -P (=O) (R104) (R105), and R104 and R105 may be each independently a substituent formed with at least one of an alkyl group; an alkenyl group; an alkoxy group; a cycloalkyl group; an aryl group; and a heteroaryl group. Examples of the phosphine oxide group may include a dimethylphosphine oxide group, a diphenylphosphine oxide group, a dinaphthylphosphine oxide group and the like, but are not limited thereto.

In the present specification, the amine group may be selected from the group consisting of a monoalkylamine group; a monoarylamine group; a monoheteroarylamine group; -NH₂; a dialkylamine group; a diarylamine group; a diheteroarylamine group; an alkylarylamine group; an alkylheteroarylamine group; and an arylheteroarylamine group, and although not particularly limited thereto, the number of carbon atoms is preferably from 1 to 30. Specific examples of the amine group may include a methylamine group, a dimethylamine group, an ethylamine group, a diethylamine group, a phenylamine group, a naphthylamine group, a biphenylamine group, a dibiphenylamine group, an anthracenylamine group, a 9-methyl-anthracenylamine group, a diphenylamine group, a phenylnaphthylamine group, a ditolylamine group, a phenyltolylamine group, a triphenylamine group, a biphenylnaphthylamine group, a phenylbiphenylamine group, a biphenylfluorenylamine group, a phenyltriphenylenylamine group, a biphenyltriphenylenylamine group and the like, but are not limited thereto.

In the present specification, the examples of the aryl group described above may be applied to the arylene group except that the arylene group is a divalent group.

In the present specification, the examples of the heteroaryl group described above may be applied to the heteroarylene group except that the heteroarylene group is a divalent group.

In the present specification, the examples of the aryl group and the heteroaryl group described above may be respectively applied to an aryl ring and a heteroring.

An organic light emitting device according to one embodiment of the present specification includes an organic material layer including a compound of Chemical Formula 1 and a compound of Chemical Formula 2.

In one embodiment of the present specification, L1 to L3 of Chemical Formula 1 are the same as or different from each other, and each independently a direct bond; a C6 to C60 arylene group; a monocyclic heteroarylene group including N; or a tricyclic or higher heteroarylene group including O.

In one embodiment of the present specification, L1 to L3 are the same as or different from each other, and each independently a direct bond; a C6 to C60 arylene group; a C2 to C5 monocyclic heteroarylene group including N; or a C12 to C60 tricyclic or higher heteroarylene group including O.

In one embodiment of the present specification, L1 to L3 are the same as or different from each other, and each independently a direct bond; a C6 to C30 arylene group; a monocyclic heteroarylene group including N; or a tricyclic or higher heteroarylene group including O.

In one embodiment of the present specification, L1 to L3 are the same as or different from each other, and may be each independently a direct bond; a phenylene group; a biphenylene group; a divalent pyridine group; a divalent dibenzofuran group; or a divalent naphthobenzofuran group.

In one embodiment of the present specification, L1 to L3 may all be a direct bond.

In one embodiment of the present specification, L1 and L3 are the same as or different from each other, and may be each independently a direct bond; a C6 to C60 arylene group; or a monocyclic heteroarylene group including N.

In one embodiment of the present specification, L1 and L3 are the same as or different from each other, and may be each independently a direct bond; a C6 to C30 arylene group; or a monocyclic heteroarylene group including N.

In one embodiment of the present specification, L1 and L3 are the same as or different from each other, and may be each independently a direct bond; a phenylene group; a biphenylene group; or a divalent pyridine group.

In one embodiment of the present specification, L2 may be a direct bond; or a tricyclic or higher heteroarylene group including O.

In one embodiment of the present specification, L2 may be a direct bond; a divalent dibenzofuran group; or a divalent naphthobenzofuran group.

In one embodiment of the present specification, when L2 is a divalent dibenzofuran group; or a divalent naphthobenzofuran group, Chemical Formula 1 may be represented by any one of the following Chemical Formulae 1-A to 1-C. 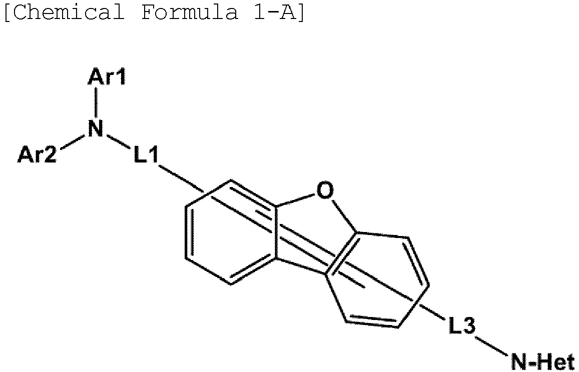 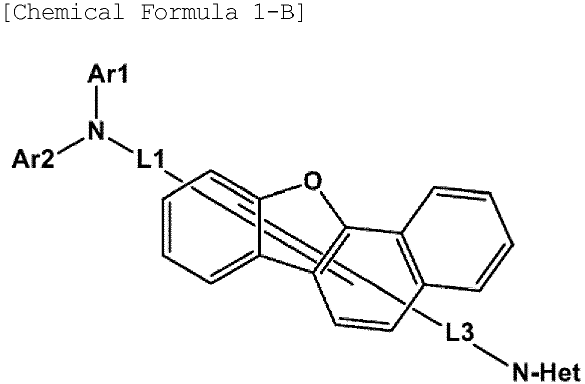 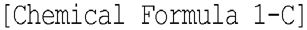 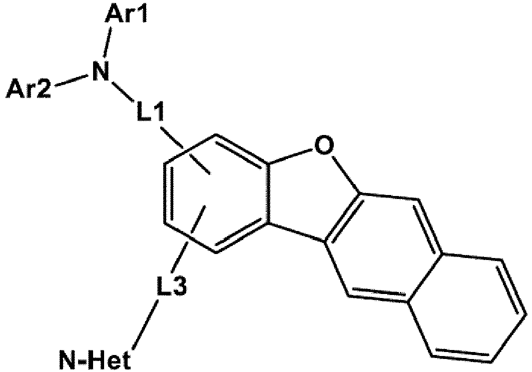 In Chemical Formulae 1-A to 1-C,
each substituent has the same definition as in Chemical Formula 1.

In one embodiment of the present specification, when Chemical Formula 1 is represented by Chemical Formula 1-C, the two substituents may substitute at a meta position to each other.

In one embodiment of the present specification, Ar1 and Ar2 of Chemical Formula 1 are the same as or different from each other, and each independently a substituted or unsubstituted C1 to C60 alkyl group; a substituted or unsubstituted C3 to C60 cycloalkyl group; a substituted or unsubstituted C6 to C60 aryl group; or a substituted or unsubstituted C2 to C60 heteroaryl group.

In one embodiment of the present specification, Ar1 and Ar2 are the same as or different from each other, and each independently a substituted or unsubstituted C6 to C60 aryl group; or a substituted or unsubstituted C2 to C60 heteroaryl group.

In one embodiment of the present specification, Ar1 and Ar2 are the same as or different from each other, and each independently a substituted or unsubstituted C6 to C40 aryl group; or a substituted or unsubstituted C2 to C40 heteroaryl group.

In one embodiment of the present specification, Ar1 and Ar2 are the same as or different from each other, and each independently a substituted or unsubstituted C6 to C20 aryl group; or a substituted or unsubstituted C2 to C20 heteroaryl group.

In one embodiment of the present specification, Ar1 and Ar2 are the same as or different from each other, and each independently a substituted or unsubstituted phenyl group; a substituted or unsubstituted biphenyl group; a substituted or unsubstituted terphenyl group; a substituted or unsubstituted naphthyl group; a substituted or unsubstituted fluorenyl group; a substituted or unsubstituted dibenzofuran group; a substituted or unsubstituted dibenzothiophene group; or a substituted or unsubstituted carbazole group.

In one embodiment of the present specification, Ar1 and Ar2 are the same as or different from each other, and each independently a phenyl group unsubstituted or substituted with an aryl group or a heteroaryl group; a biphenyl group; a terphenyl group; a naphthyl group; a dimethylfluorenyl group; a dibenzofuran group; a dibenzothiophene group; or a carbazole group unsubstituted or substituted with an aryl group.

In one embodiment of the present specification, N-Het of Chemical Formula 1 is a C2 to C60 heteroaryl group substituted or unsubstituted and including N.

In one embodiment of the present specification, N-Het is a C2 to C40 heteroaryl group substituted or unsubstituted and including N.

In one embodiment of the present specification, N-Het is a C2 to C20 heteroaryl group substituted or unsubstituted and including N.

In one embodiment of the present specification, N-Het is a C2 to C40 heteroaryl group substituted or unsubstituted and including -N=.

In one embodiment of the present specification, N-Het of Chemical Formula 1 is a C2 to C60 heteroaryl group substituted or unsubstituted and including -N=.

In one embodiment of the present specification, N-Het is a C2 to C20 heteroaryl group substituted or unsubstituted and including -N=.

In one embodiment of the present specification, N-Het is a C2 to C40 heteroaryl group substituted or unsubstituted and including -N=.

In one embodiment of the present specification, including -N= specifically means including a double bond of carbon and nitrogen (C=N). For example, pyrimidine, pyridine, triazine and the like include -N=, and carbazole does not include -N=.

In one embodiment of the present specification, N-Het may be represented by any one of the following Chemical Formulae 1-1 to 1-4. 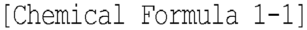 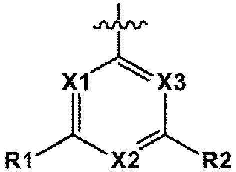 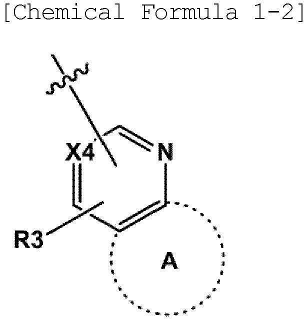 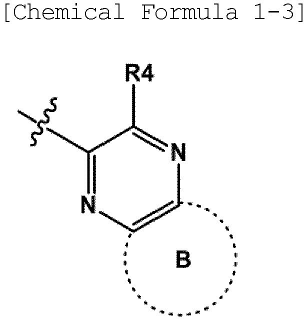 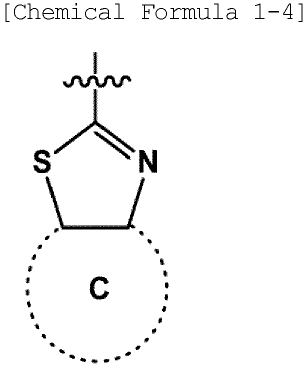 In Chemical Formulae 1-1 to 1-4,
X1 to X4 are each N or CR,
at least one of X1 to X3 is N,
A to C are the same as or different from each other, and each independently a substituted or unsubstituted monocyclic or polycyclic C6 to C60 aryl ring; or a substituted or unsubstituted monocyclic or polycyclic C2 to C60 heteroring, and
R and R1 to R4 are the same as or different from each other, and each independently hydrogen; deuterium; a halogen group; a cyano group; a substituted or unsubstituted C1 to C60 alkyl group; a substituted or unsubstituted C6 to C60 aryl group; or a substituted or unsubstituted C2 to C60 heteroaryl group.

In one embodiment of the present specification, X1 to X3 of Chemical Formula 1-1 are each N or CR, and at least one of X1 to X3 is N.

In one embodiment of the present specification, at least two of X1 to X3 are N.

In one embodiment of the present specification, X1 and X2 are N, X3 is CR, and R may be hydrogen.

In one embodiment of the present specification, X1 and X3 are N, X2 is CR, and R may be hydrogen.

In one embodiment of the present specification, X1 to X3 may all be N.

In one embodiment of the present specification, R1 and R2 of Chemical Formula 1-1 are the same as or different from each other, and each independently a substituted or unsubstituted C6 to C60 aryl group; or a substituted or unsubstituted C2 to C60 heteroaryl group.

In one embodiment of the present specification, R1 and R2 are the same as or different from each other, and each independently a substituted or unsubstituted C6 to C40 aryl group; or a substituted or unsubstituted C2 to C40 heteroaryl group.

In one embodiment of the present specification, R1 and R2 are the same as or different from each other, and each independently a substituted or unsubstituted C6 to C20 aryl group; or a substituted or unsubstituted C2 to C20 heteroaryl group.

In one embodiment of the present specification, R1 and R2 are the same as or different from each other, and may be each independently a substituted or unsubstituted phenyl group; a substituted or unsubstituted biphenyl group; a substituted or unsubstituted naphthyl group; a substituted or unsubstituted fluorenyl group; a substituted or unsubstituted dibenzofuran group; or a substituted or unsubstituted dibenzothiophene group.

In one embodiment of the present specification, R1 and R2 are the same as or different from each other, and may be each independently a phenyl group unsubstituted or substituted with an aryl group or a heteroaryl group; a substituted or unsubstituted biphenyl group; a substituted or unsubstituted naphthyl group; a fluorenyl group unsubstituted or substituted with an alkyl group; a substituted or unsubstituted dibenzofuran group; or a substituted or unsubstituted dibenzothiophene group.

In one embodiment of the present specification, R1 and R2 are the same as or different from each other, and may be each independently a phenyl group unsubstituted or substituted with a naphthyl group or a carbazole group; a biphenyl group; a naphthyl group; a dimethylfluorenyl group; a dibenzofuran group; or a dibenzothiophene group.

In one embodiment of the present specification, X4 of Chemical Formula 1-2 is N or CR.

In one embodiment of the present specification, X4 may be N.

In one embodiment of the present specification, X4 may be CR, and R may be hydrogen.

In one embodiment of the present specification, A of Chemical Formula 1-2 is a substituted or unsubstituted monocyclic aryl ring; or a substituted or unsubstituted polycyclic heteroring.

In one embodiment of the present specification, A may be a substituted or unsubstituted benzene ring; a substituted or unsubstituted quinoline ring; a substituted or unsubstituted indole ring; a substituted or unsubstituted benzofuran ring; or a substituted or unsubstituted benzothiophene ring.

In one embodiment of the present specification, A may be a benzene ring; a quinoline ring; an indole ring substituted with an aryl group; a benzofuran ring; or a benzothiophene ring.

In one embodiment of the present specification, R3 of Chemical Formula 1-2 is hydrogen; a substituted or unsubstituted C6 to C60 aryl group; or a substituted or unsubstituted C2 to C60 heteroaryl group.

In one embodiment of the present specification, R3 is hydrogen; a substituted or unsubstituted C6 to C30 aryl group; or a substituted or unsubstituted C2 to C30 heteroaryl group.

In one embodiment of the present specification, R3 may be hydrogen; a substituted or unsubstituted phenyl group; a substituted or unsubstituted biphenyl group; a substituted or unsubstituted naphthyl group; a substituted or unsubstituted dibenzofuran group; a substituted or unsubstituted dibenzothiophene group; or a substituted or unsubstituted naphthobenzofuran group.

In one embodiment of the present specification, R3 may be hydrogen; a phenyl group unsubstituted or substituted with an aryl group; a substituted or unsubstituted biphenyl group; a substituted or unsubstituted naphthyl group; a substituted or unsubstituted dibenzofuran group; a substituted or unsubstituted dibenzothiophene group; or a substituted or unsubstituted naphthobenzofuran group.

In one embodiment of the present specification, R3 may be hydrogen; a phenyl group unsubstituted or substituted with an aryl group; a biphenyl group; a naphthyl group; a dibenzofuran group; a dibenzothiophene group; or a naphthobenzofuran group.

In one embodiment of the present specification, R3 may be hydrogen; a phenyl group unsubstituted or substituted with a naphthyl group; a biphenyl group; a naphthyl group; a dibenzofuran group; a dibenzothiophene group; or a naphthobenzofuran group.

In one embodiment of the present specification, B of Chemical Formula 1-3 may be a substituted or unsubstituted monocyclic aryl ring.

In one embodiment of the present specification, B may be a substituted or unsubstituted benzene ring.

In one embodiment of the present specification, B may be a benzene ring.

In one embodiment of the present specification, R4 of Chemical Formula 1-3 may be hydrogen; deuterium; a substituted or unsubstituted C6 to C60 aryl group.

In one embodiment of the present specification, R4 may be hydrogen; deuterium; a substituted or unsubstituted C6 to C40 aryl group.

In one embodiment of the present specification, R4 may be hydrogen; deuterium; a substituted or unsubstituted C6 to C20 aryl group.

In one embodiment of the present specification, R4 may be hydrogen; deuterium; a substituted or unsubstituted phenyl group; or a substituted or unsubstituted biphenyl group.

In one embodiment of the present specification, R4 may be hydrogen; deuterium; a phenyl group; or a biphenyl group.

In one embodiment of the present specification, C of Chemical Formula 1-4 may be a substituted or unsubstituted monocyclic aryl ring.

In one embodiment of the present specification, C may be a substituted or unsubstituted benzene ring.

In one embodiment of the present specification, C may be a benzene ring.

In one embodiment of the present specification, Chemical Formula 1 may be represented by any one of the following compounds, but is not limited thereto.

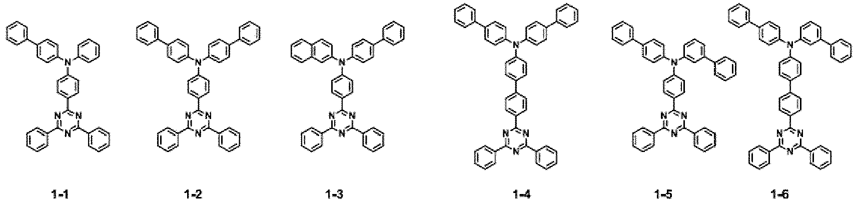

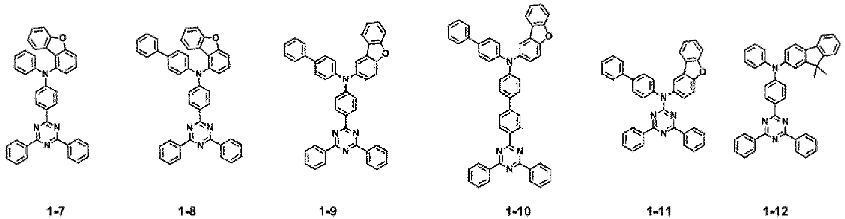

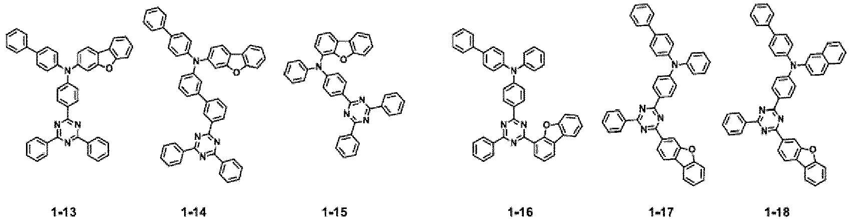

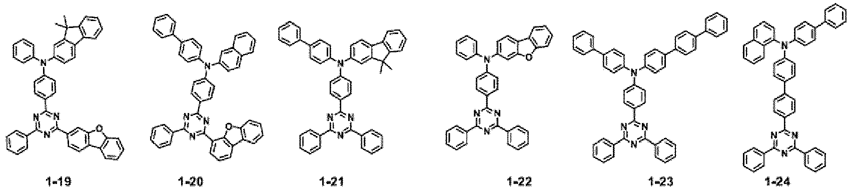

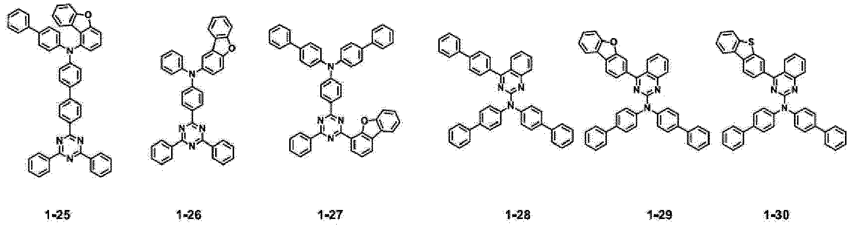

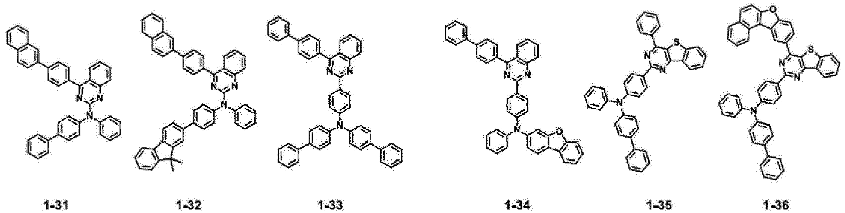

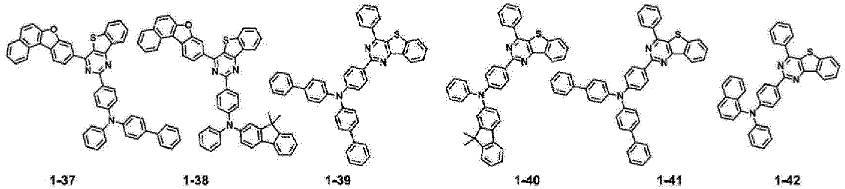

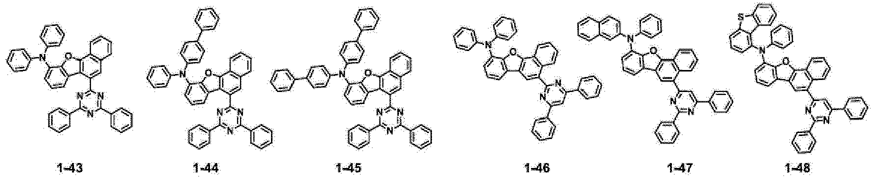

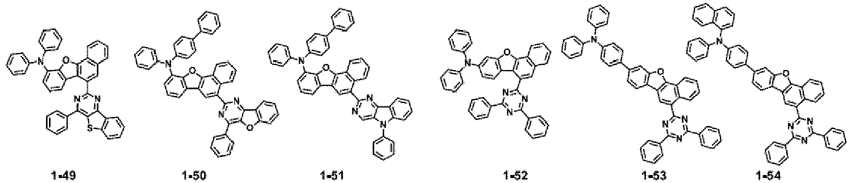

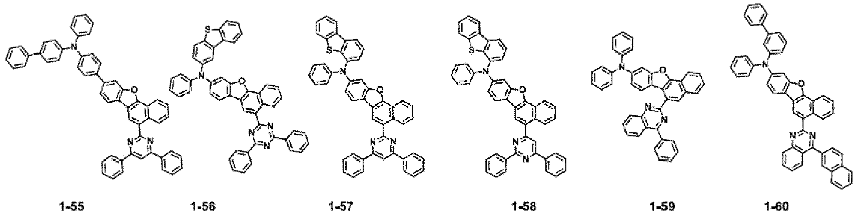

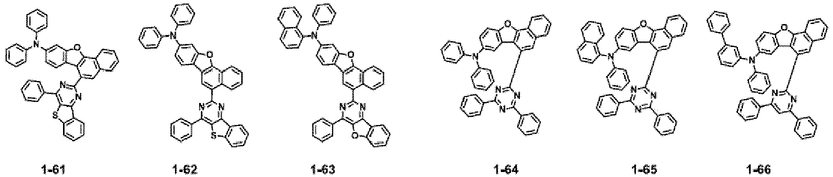

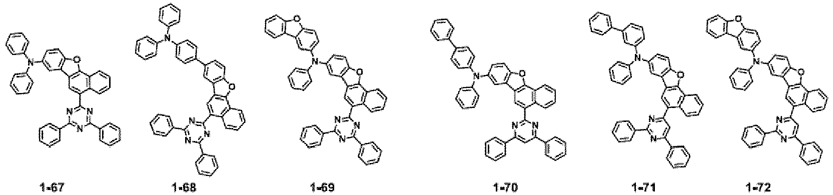

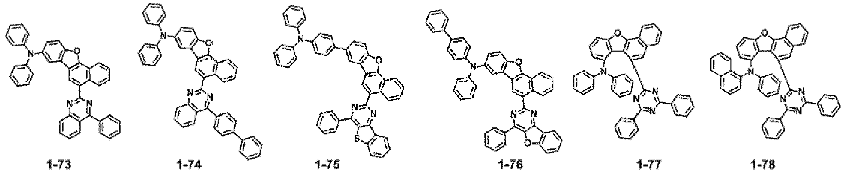

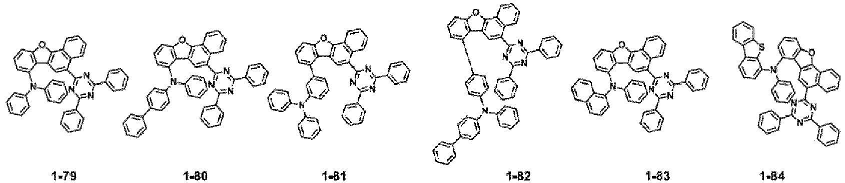

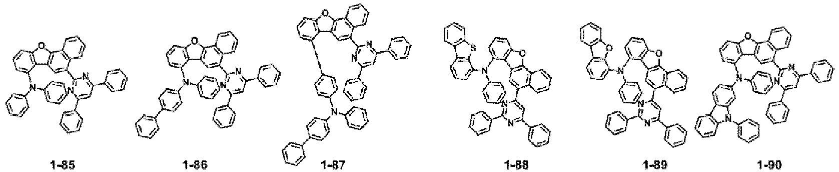

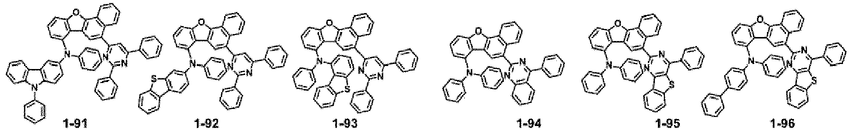

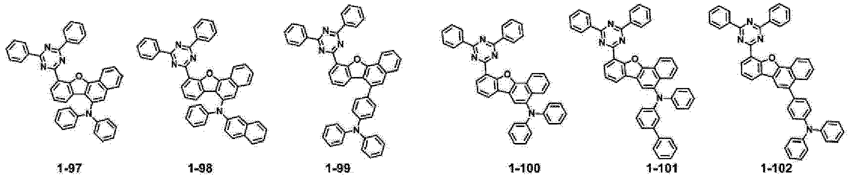

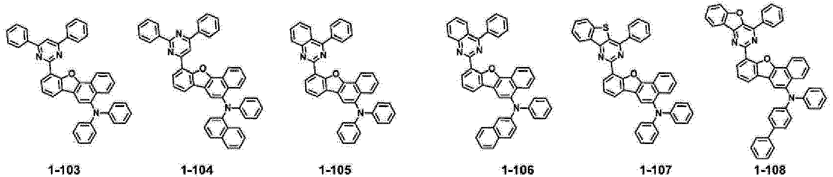

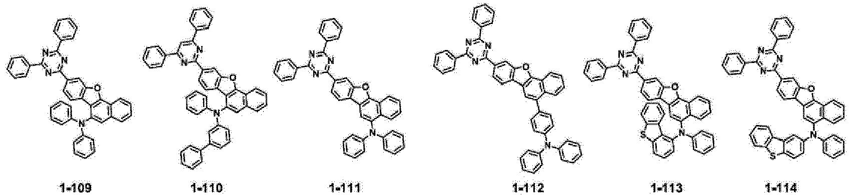

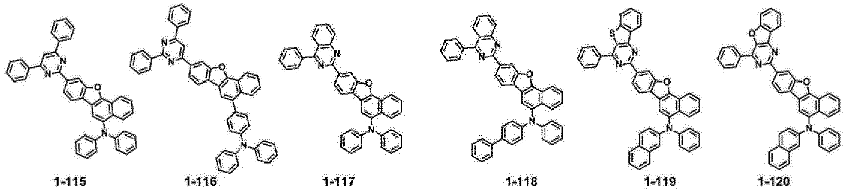

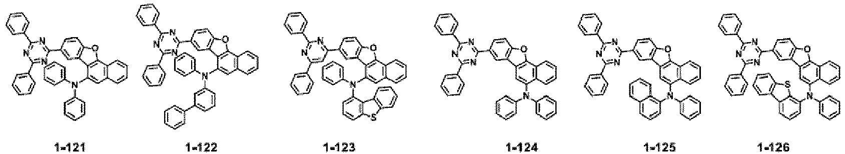

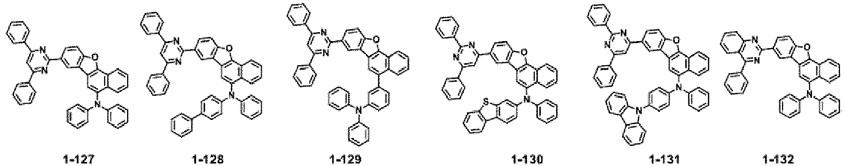

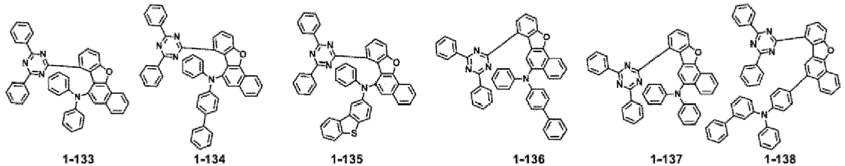

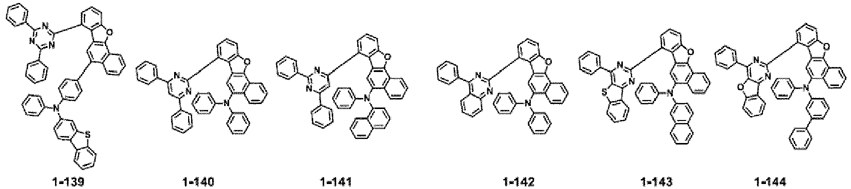

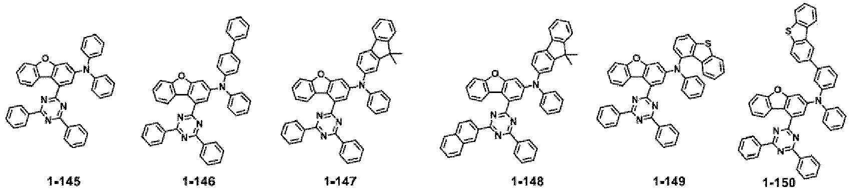

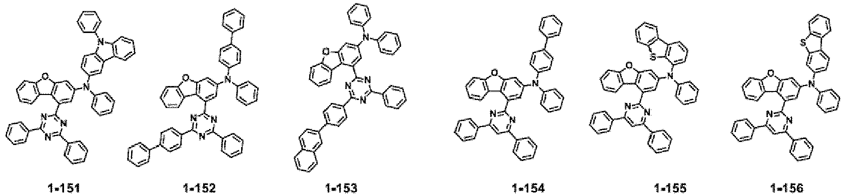

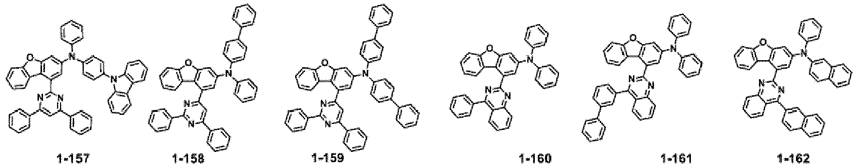

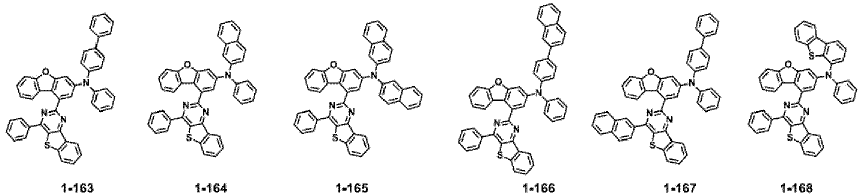

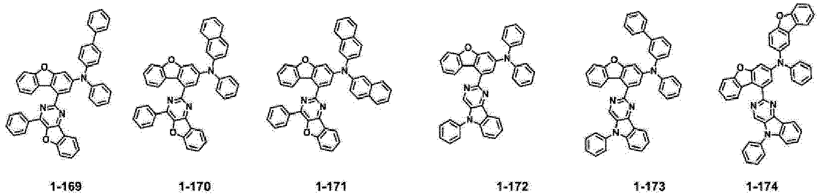

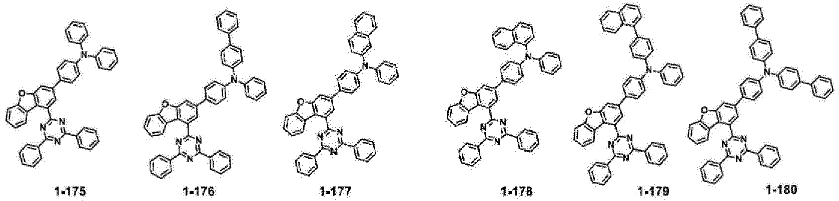

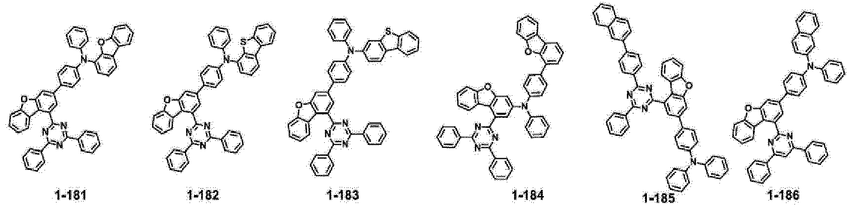

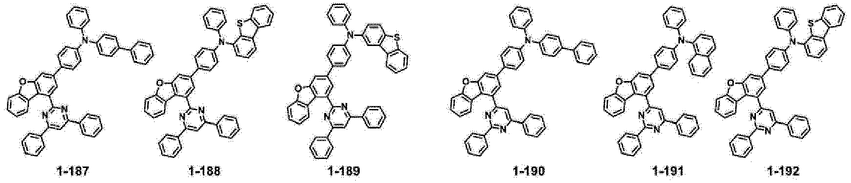

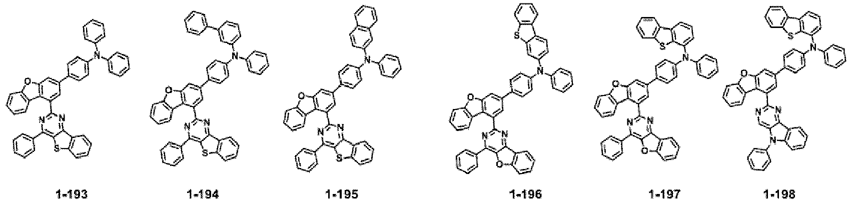

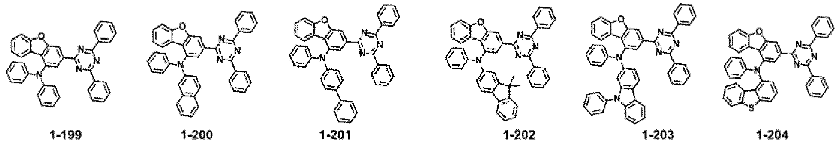

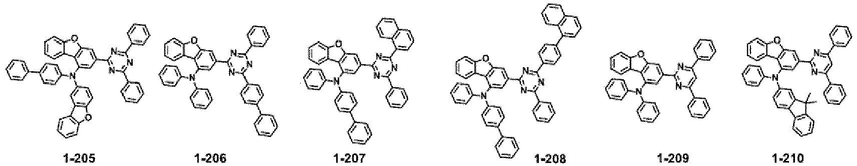

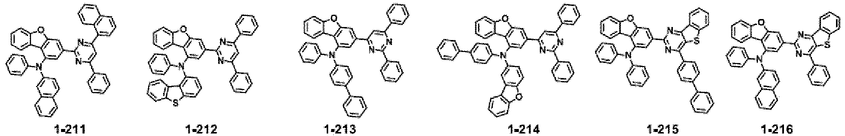

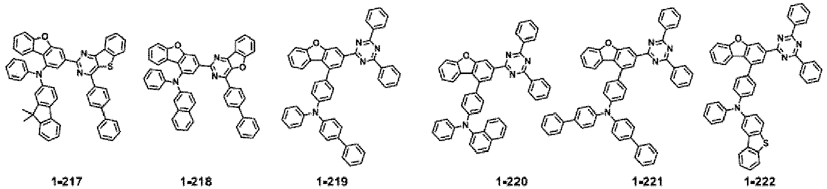

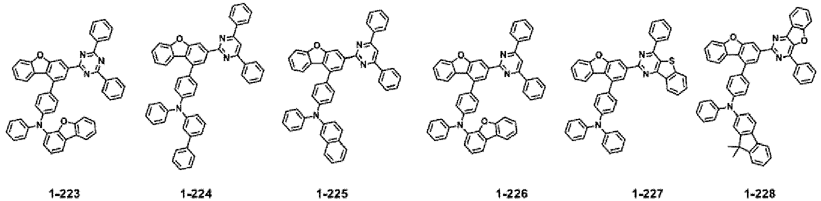

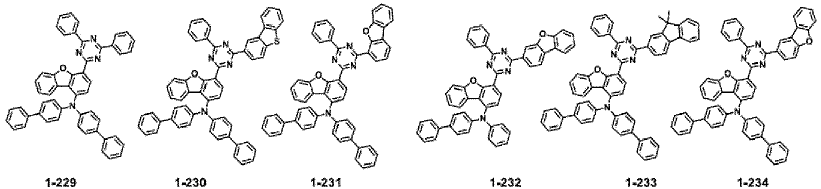

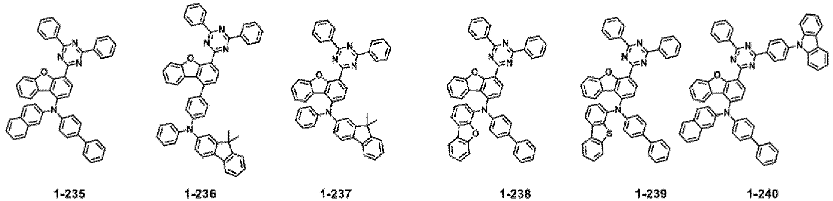

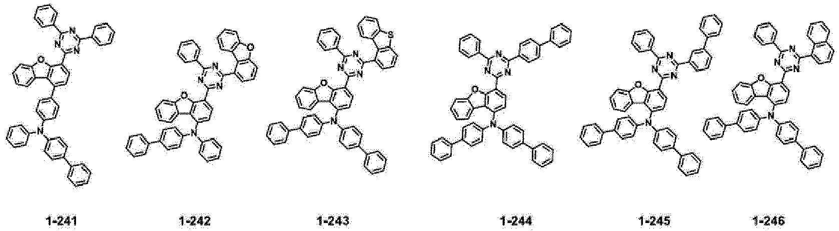

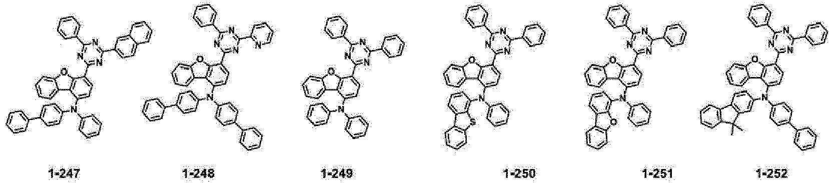

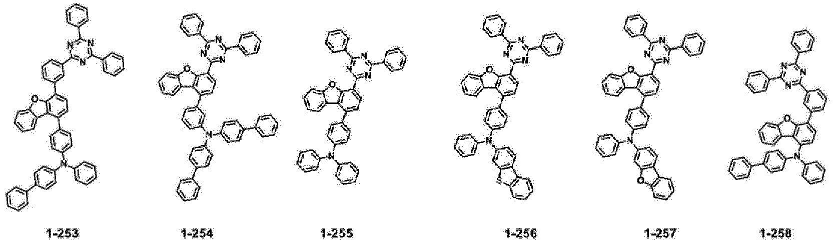

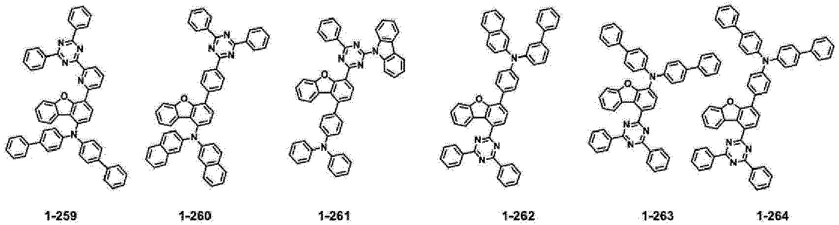

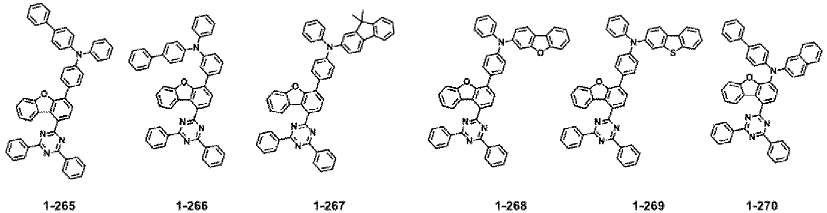

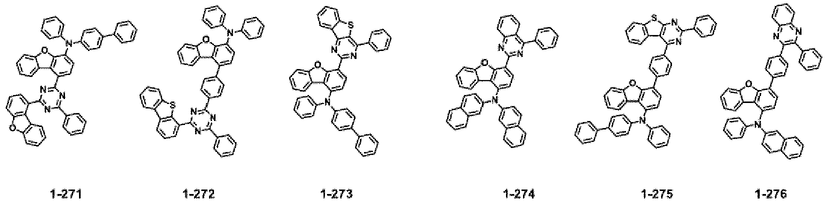

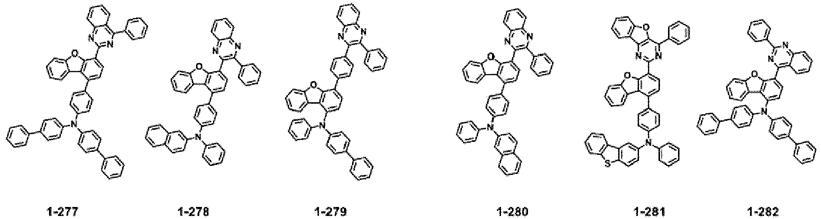

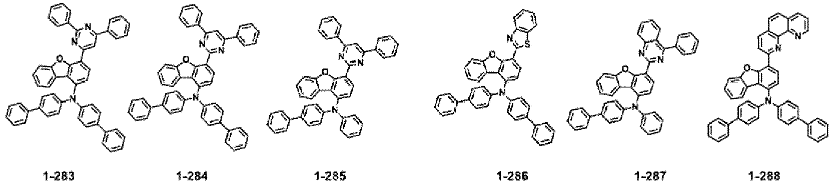

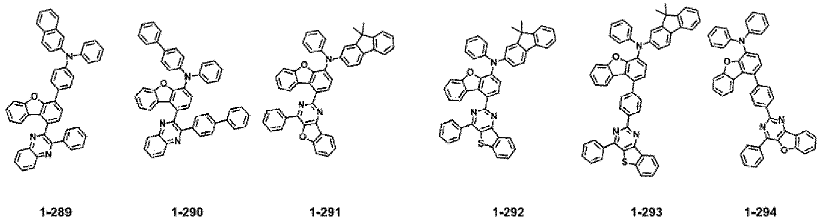

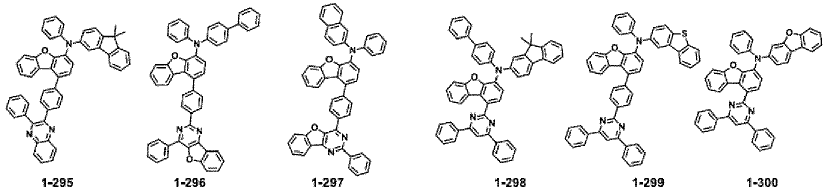

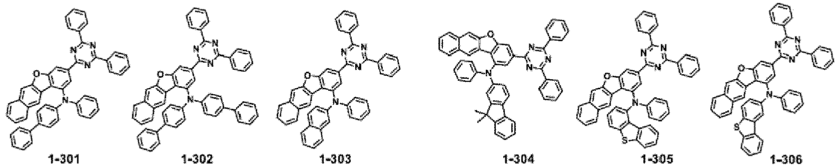

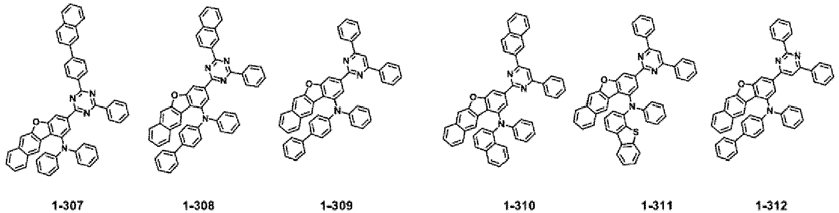

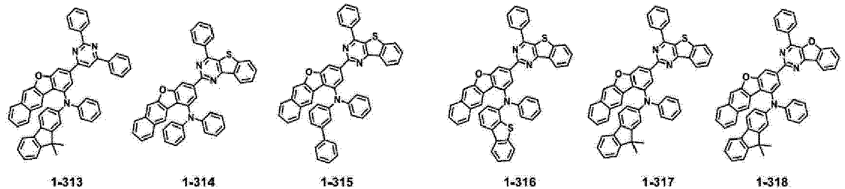

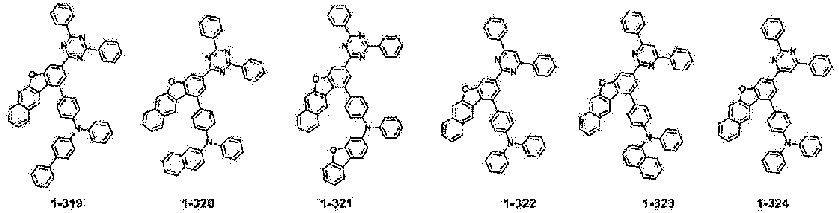

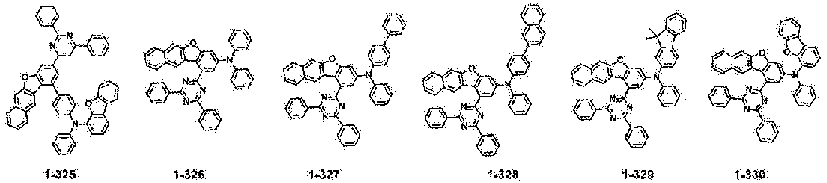

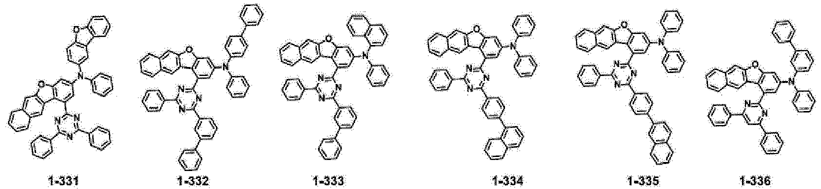

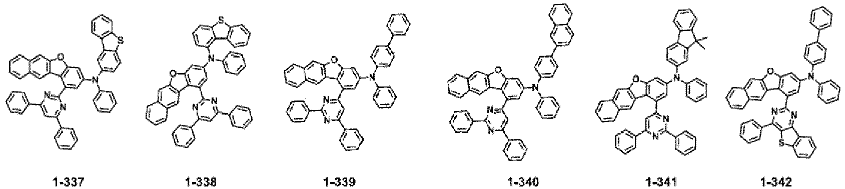

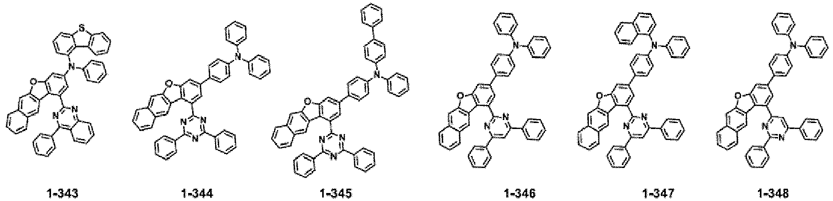

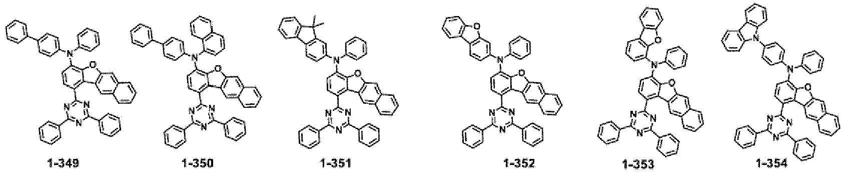

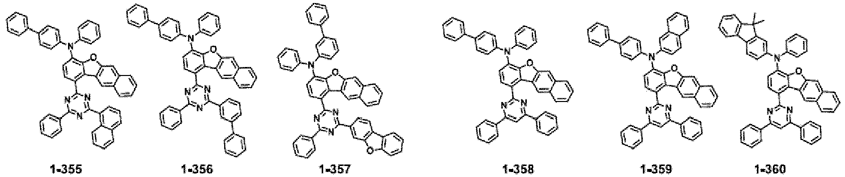

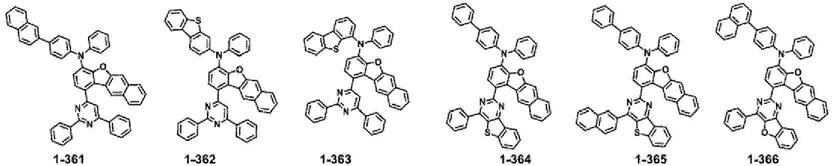

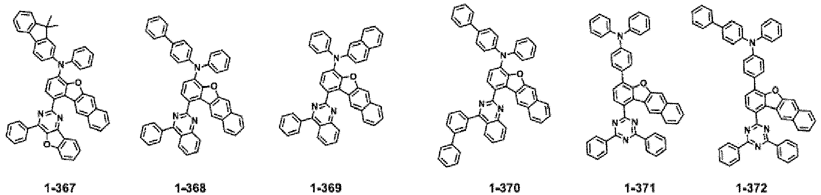

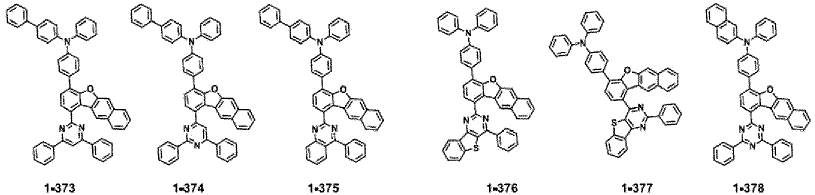

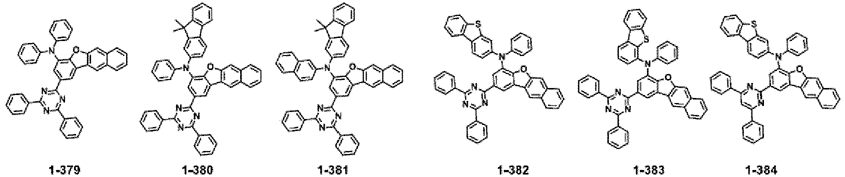

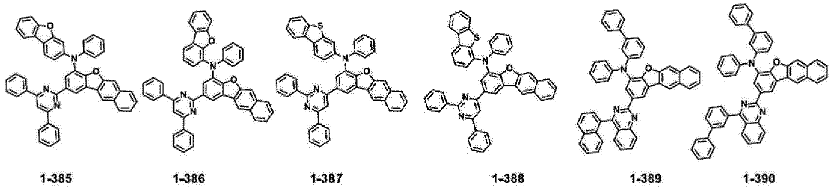

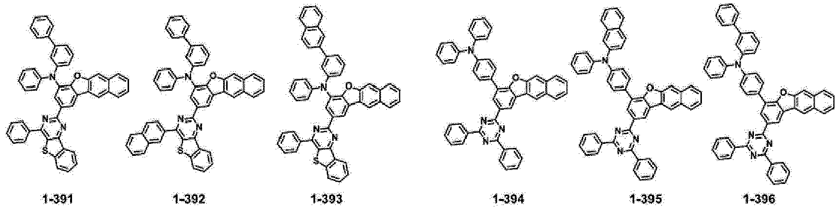

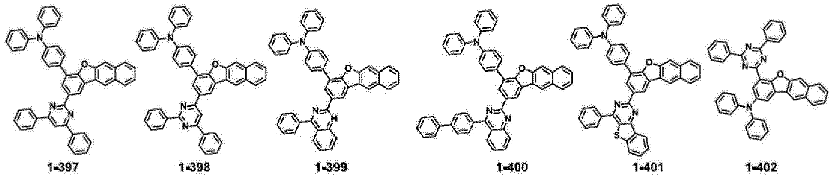

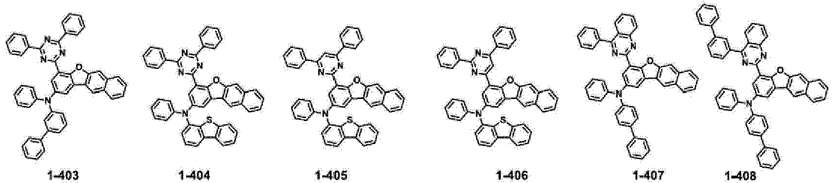

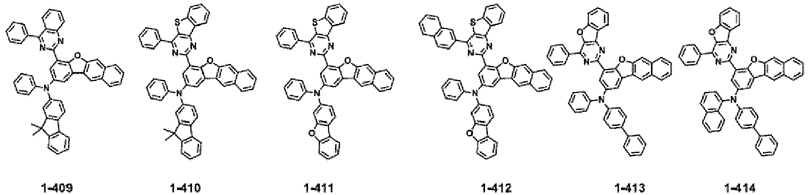

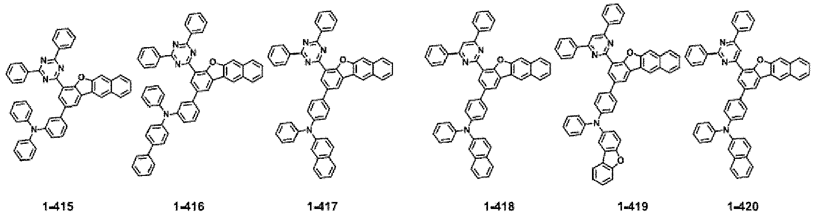

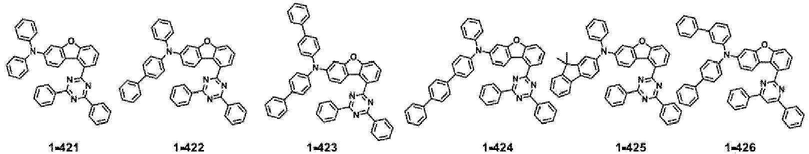

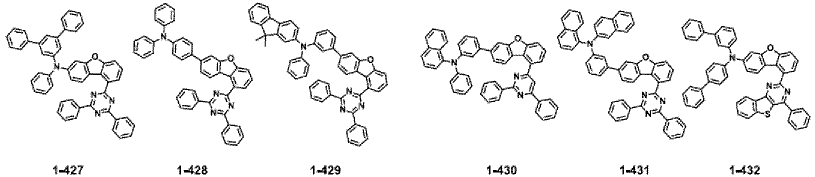

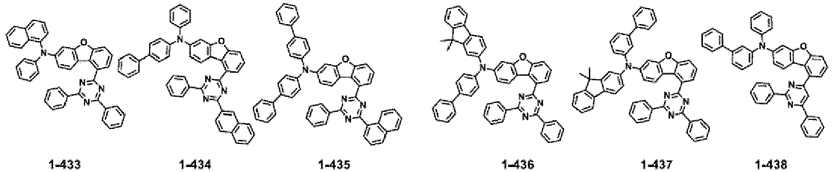

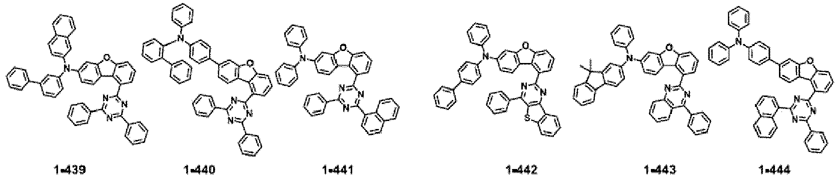

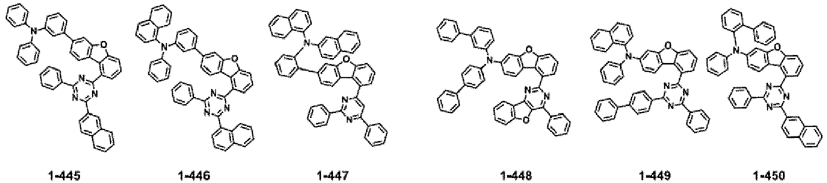

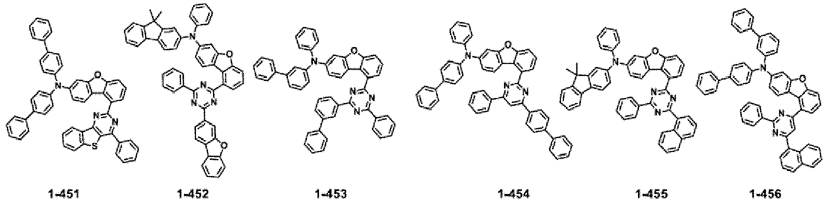

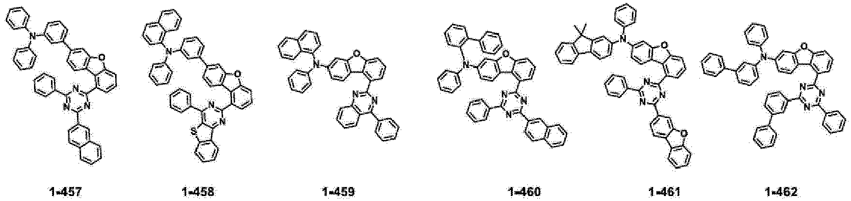

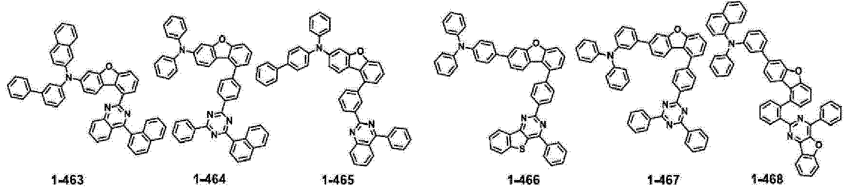

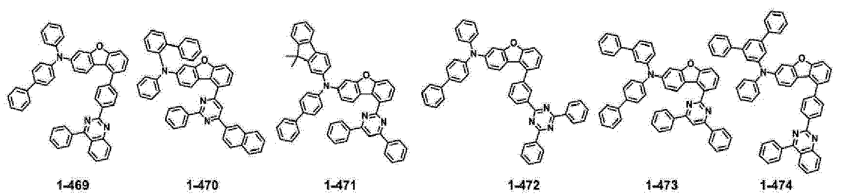

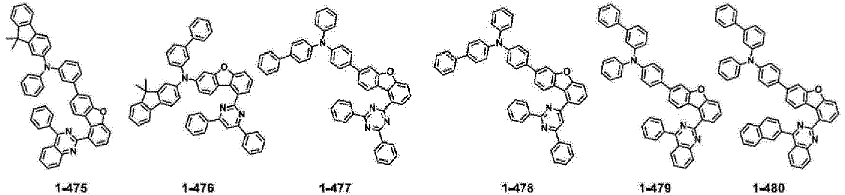

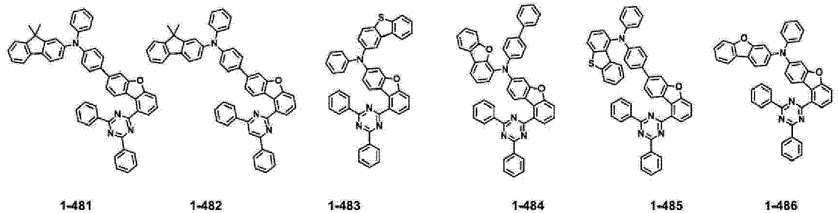

In one embodiment of the present specification, L21 and L22 of Chemical Formula 2 are the same as or different from each other, and each independently a direct bond; a C6 to C60 arylene group; or a C2 to C60 heteroarylene group.

In one embodiment of the present specification, L21 and L22 are the same as or different from each other, and each independently a direct bond; a C6 to C40 arylene group; or a C2 to C40 heteroarylene group.

In one embodiment of the present specification, L21 and L22 are the same as or different from each other, and each independently a direct bond; a C6 to C20 arylene group; or a C2 to C20 heteroarylene group.

In one embodiment of the present specification, L21 and L22 are the same as or different from each other, and may be each independently a direct bond; or a C6 to C40 arylene group.

In one embodiment of the present specification, L21 and L22 are the same as or different from each other, and may be each independently a direct bond; or a C6 to C20 arylene group.

In one embodiment of the present specification, L21 and L22 are the same as or different from each other, and may be each independently a direct bond; a phenylene group; or a naphthylene group.

In one embodiment of the present specification, Z21 and Z22 of Chemical Formula 2 are the same as or different from each other and each independently a substituted or unsubstituted C6 to C60 aryl group; or a substituted or unsubstituted C2 to C60 heteroaryl group, and at least one of Z21 and Z22 is a C2 to C60 heteroaryl group substituted or unsubstituted and including N.

In one embodiment of the present specification, Z21 and Z22 are the same as or different from each other and each independently a substituted or unsubstituted C6 to C40 aryl group; or a substituted or unsubstituted C2 to C40 heteroaryl group, and at least one of Z21 and Z22 is a C2 to C40 heteroaryl group substituted or unsubstituted and including N.

In one embodiment of the present specification, Z21 and Z22 are the same as or different from each other and each independently a substituted or unsubstituted C6 to C20 aryl group; or a substituted or unsubstituted C2 to C20 heteroaryl group, and at least one of Z21 and Z22 is a C2 to C20 heteroaryl group substituted or unsubstituted and including N.

In one embodiment of the present specification, Z21 and Z22 are the same as or different from each other and may be each independently a substituted or unsubstituted phenyl group; a substituted or unsubstituted biphenyl group; a substituted or unsubstituted naphthyl group; a substituted or unsubstituted fluorenyl group; a substituted or unsubstituted dibenzofuran group; a substituted or unsubstituted dibenzothiophene group; a substituted or unsubstituted pyrimidine group; a substituted or unsubstituted triazine group; a substituted or unsubstituted quinazoline group; a substituted or unsubstituted benzofuropyrimidine group; or a substituted or unsubstituted benzothienopyrimidine group, and at least one of Z21 and Z22 may be a substituted or unsubstituted pyrimidine group; a substituted or unsubstituted triazine group; a substituted or unsubstituted quinazoline group; a substituted or unsubstituted benzofuropyrimidine group; or a substituted or unsubstituted benzothienopyrimidine group.

In one embodiment of the present specification, Z21 may be a substituted or unsubstituted pyrimidine group; a substituted or unsubstituted triazine group; a substituted or unsubstituted quinazoline group; a substituted or unsubstituted benzofuropyrimidine group; or a substituted or unsubstituted benzothienopyrimidine group.

In one embodiment of the present specification, Z21 may be a pyrimidine group unsubstituted or substituted with an aryl group; a triazine group unsubstituted or substituted with one or more substituents selected from the group consisting of an aryl group and a heteroaryl group; a quinazoline group unsubstituted or substituted with one or more substituents selected from the group consisting of an aryl group and a heteroaryl group; a benzofuropyrimidine group unsubstituted or substituted with one or more substituents selected from the group consisting of an aryl group and a heteroaryl group; or a benzothienopyrimidine group unsubstituted or substituted with one or more substituents selected from the group consisting of an aryl group and a heteroaryl group.

In one embodiment of the present specification, Z22 may be a substituted or unsubstituted phenyl group; a substituted or unsubstituted biphenyl group; a substituted or unsubstituted naphthyl group; a substituted or unsubstituted fluorenyl group; a substituted or unsubstituted dibenzofuran group; or a substituted or unsubstituted dibenzothiophene group.

In one embodiment of the present specification, Z22 may be a phenyl group unsubstituted or substituted with an aryl group; a biphenyl group; a naphthyl group unsubstituted or substituted with an aryl group; a fluorenyl group unsubstituted or substituted with an alkyl group; a dibenzofuran group; or a dibenzothiophene group.

In one embodiment of the present specification, R21 and R22 of Chemical Formula 2 are the same as or different from each other, and each independently hydrogen; deuterium; a halogen group; a cyano group; a substituted or unsubstituted C1 to C60 alkyl group; a substituted or unsubstituted C6 to C60 aryl group; or a substituted or unsubstituted C2 to C60 heteroaryl group, or adjacent groups may bond to each other to form a substituted or unsubstituted C2 to C60 ring.

In one embodiment of the present specification, R21 may be hydrogen; deuterium; a halogen group; a cyano group; a substituted or unsubstituted C1 to C20 alkyl group; a substituted or unsubstituted C6 to C30 aryl group; or a substituted or unsubstituted C2 to C30 heteroaryl group.

In one embodiment of the present specification, R22 is hydrogen; deuterium; a halogen group; a cyano group; a substituted or unsubstituted C1 to C20 alkyl group; a substituted or unsubstituted C6 to C20 aryl group; or a substituted or unsubstituted C2 to C20 heteroaryl group, or adjacent groups may bond to each other to form a substituted or unsubstituted C2 to C20 ring.

In one embodiment of the present specification, R22 is hydrogen; deuterium; a halogen group; a cyano group; a substituted or unsubstituted C1 to C20 alkyl group; a substituted or unsubstituted C6 to C20 aryl group; or a substituted or unsubstituted C2 to C20 heteroaryl group, or adjacent groups may bond to each other to form a C2 to C20 ring.

In one embodiment of the present specification, R22 is hydrogen; deuterium; a halogen group; a cyano group; a substituted or unsubstituted C1 to C20 alkyl group; a substituted or unsubstituted C6 to C20 aryl group; or a substituted or unsubstituted C2 to C20 heteroaryl group, or adjacent groups may bond to each other to form a benzene ring.

In one embodiment of the present specification, R21 and R22 are the same as or different from each other, and may be each independently hydrogen; or deuterium.

In one embodiment of the present specification, r21 is an integer of 0 to 4 and r22 is an integer of 0 to 6 in Chemical Formula 2.

In one embodiment of the present specification, r21 is an integer of 1 to 4 and r22 is an integer of 1 to 6 in Chemical Formula 2.

In one embodiment of the present specification, Chemical Formula 2 is represented by the following Chemical Formula 2-1. 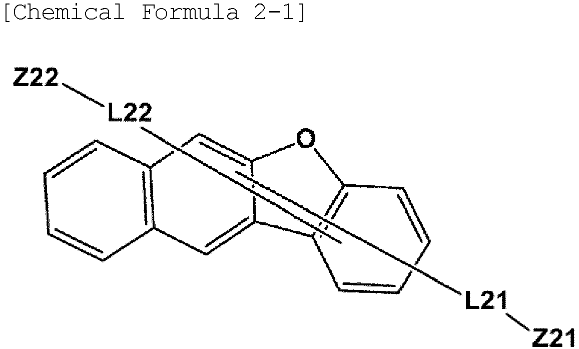 In Chemical Formula 2-1,
each substituent has the same definition as in Chemical Formula 2.

In one embodiment of the present specification, Chemical Formula 2 may be represented by the following Chemical Formula 2-2. 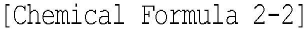 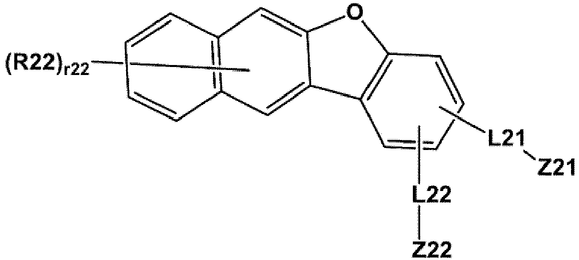 In Chemical Formula 2-2,
each substituent has the same definition as in Chemical Formula 2.

In one embodiment of the present specification, Chemical Formula 2 may be represented by any one of the following compounds, but is not limited thereto.

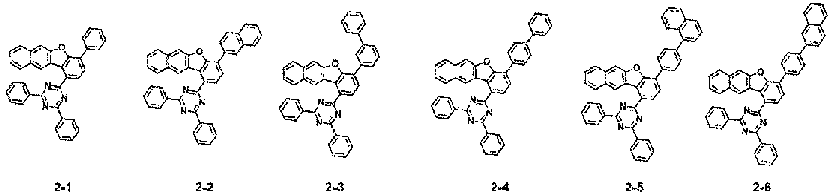

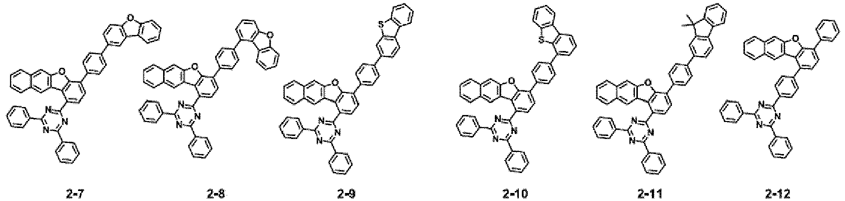

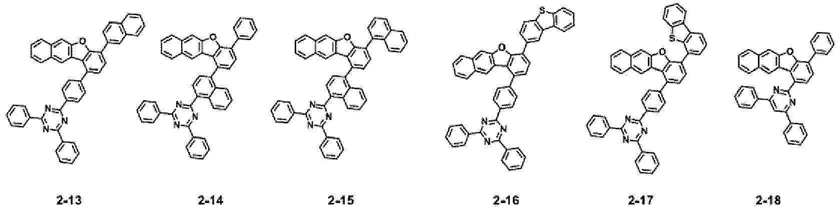

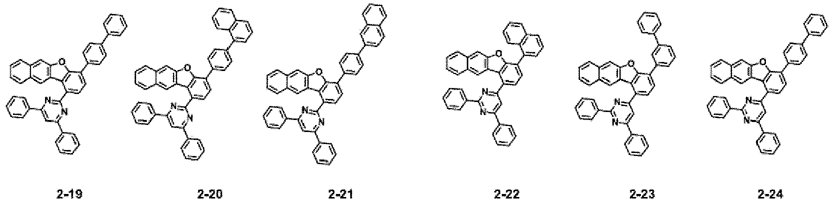

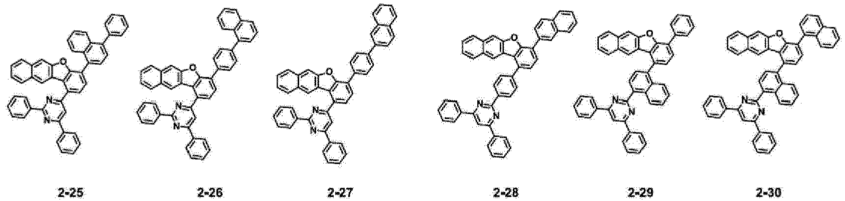

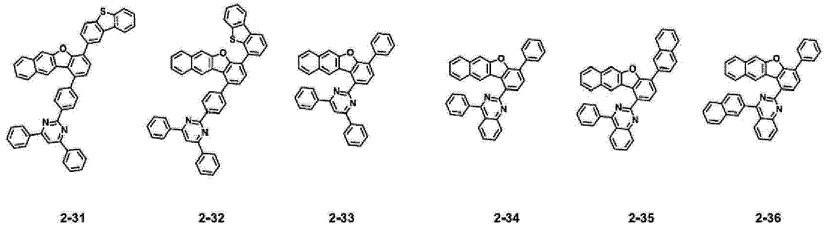

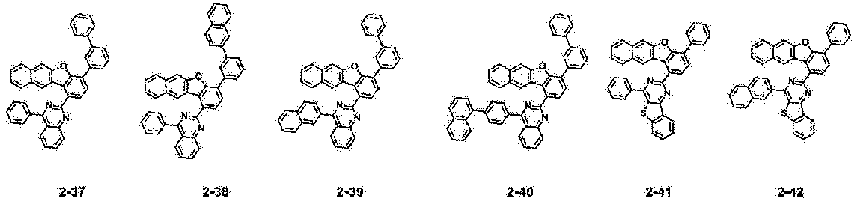

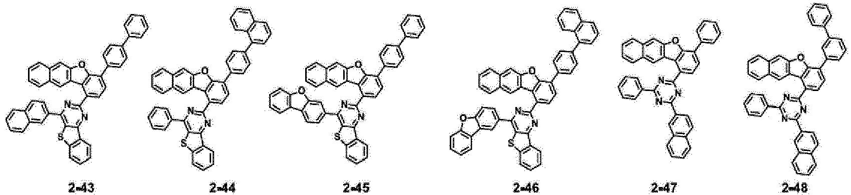

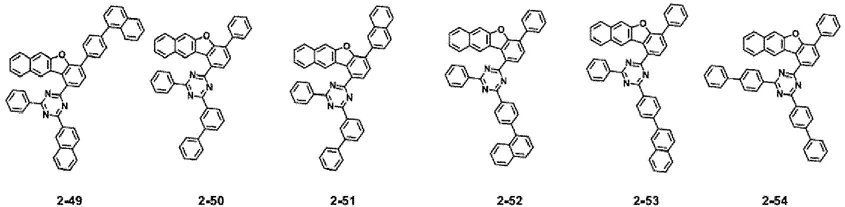

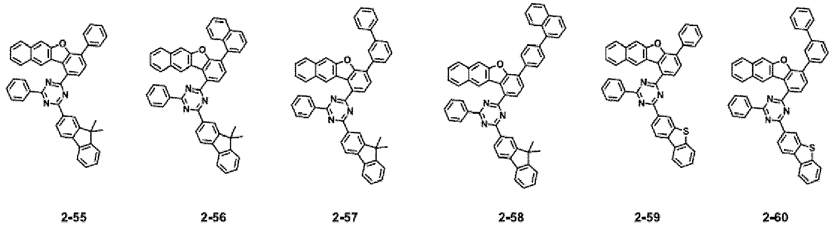

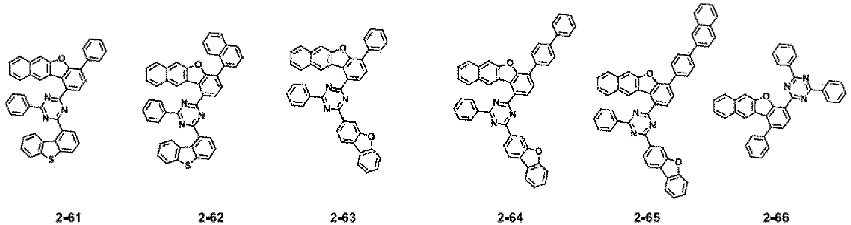

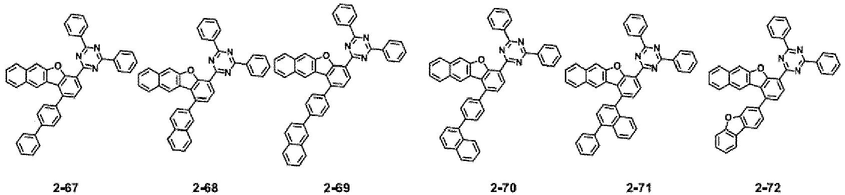

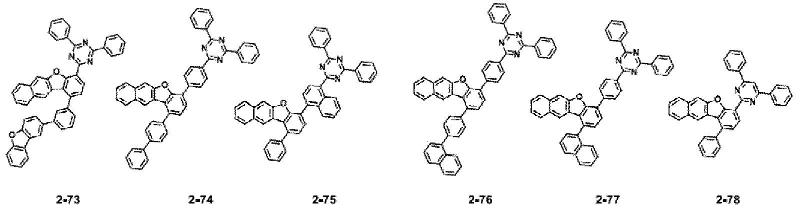

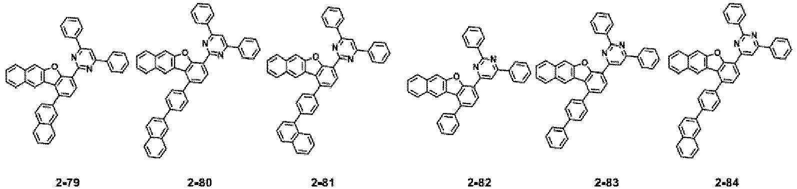

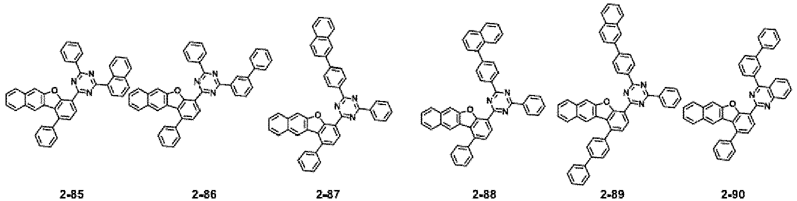

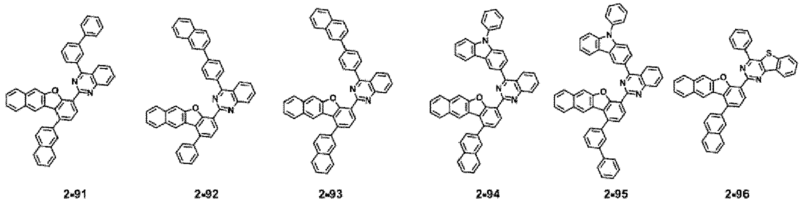

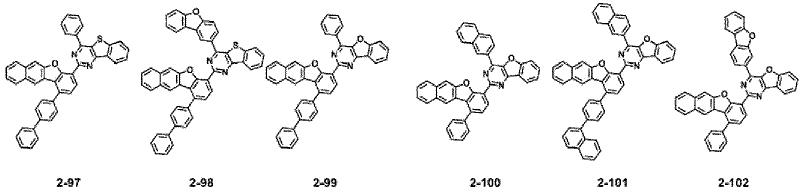

In addition, by introducing various substituents to the structure of Chemical Formula 1, compounds having unique properties of the introduced substituents may be synthesized. For example, by introducing substituents normally used as hole injection layer materials, hole transfer layer materials, light emitting layer materials, electron transfer layer materials and charge generation layer materials used for manufacturing an organic light emitting device to the core structure, materials satisfying conditions required for each organic material layer may be synthesized.

In addition, by introducing various substituents to the structure of Chemical Formula 1, the energy band gap may be finely controlled, and meanwhile, properties at interfaces between organic materials are enhanced, and material applications may become diverse.

In one embodiment of the present specification, the organic material layer includes a light emitting layer, and the light emitting layer includes the compound of Chemical Formula 1 and the compound of Chemical Formula 2.

In one embodiment of the present specification, the organic material layer includes a light emitting layer, the light emitting layer includes a host material, and the host material includes the compound of Chemical Formula 1 and the compound of Chemical Formula 2.

In one embodiment of the present specification, the first electrode may be an anode, and the second electrode may be a cathode.

In another embodiment of the present specification, the first electrode may be a cathode, and the second electrode may be an anode.

The organic light emitting device according to one embodiment of the present specification may be a blue organic light emitting device, and the compound of Chemical Formula 1 and the compound of Chemical Formula 2 may be used as a material of the blue organic light emitting device. For example, the compound of Chemical Formula 1 and the compound of Chemical Formula 2 may be included in a light emitting layer of the blue organic light emitting device.

The organic light emitting device according to one embodiment of the present specification may be a green organic light emitting device, and the compound of Chemical Formula 1 and the compound of Chemical Formula 2 may be used as a material of the green organic light emitting device. For example, the compound of Chemical Formula 1 and the compound of Chemical Formula 2 may be included in a light emitting layer of the green organic light emitting device.

The organic light emitting device according to one embodiment of the present specification may be a red organic light emitting device, and the compound of Chemical Formula 1 and the compound of Chemical Formula 2 may be used as a material of the red organic light emitting device. For example, the compound of Chemical Formula 1 and the compound of Chemical Formula 2 may be included in a light emitting layer of the red organic light emitting device.

The organic light emitting device of the present specification may be manufactured using common organic light emitting device manufacturing methods and materials except that one or more organic material layers are formed using the compound described above.

The compound may be formed into an organic material layer using a solution coating method as well as a vacuum deposition method when manufacturing the organic light emitting device. Herein, the solution coating method means spin coating, dip coating, inkjet printing, screen printing, a spray method, roll coating and the like, but is not limited thereto.

The organic material layer of the organic light emitting device of the present specification may be formed in a single layer structure, but may be formed in a multilayer structure in which two or more organic material layers are laminated. For example, the organic light emitting device of the present disclosure may have a structure including a hole injection layer, a hole transfer layer, a light emitting layer, an electron transfer layer, an electron injection layer and the like as the organic material layer. However, the structure of the organic light emitting device is not limited thereto, and may include a smaller number of organic material layers.

The organic light emitting device of the present disclosure may further include one, two or more layers selected from the group consisting of a light emitting layer, a hole injection layer, a hole transfer layer, an electron injection layer, an electron transfer layer, an electron blocking layer and a hole blocking layer.

In one embodiment of the present specification, the organic material layer may further include an electron transfer layer and a hole transfer layer.

In one embodiment of the present specification, the organic material layer includes an electron transfer layer, and the electron transfer layer may include a compound of the following Chemical Formula 3. 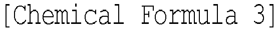 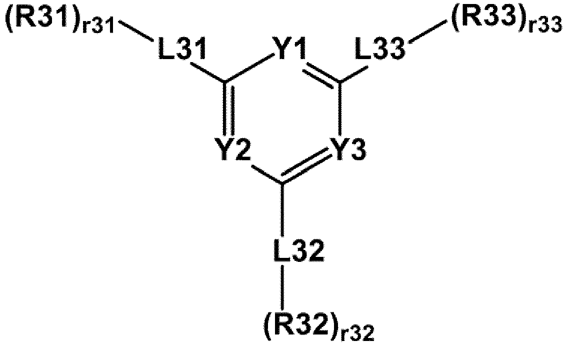 In Chemical Formula 3,
Y1 to Y3 are the same as or different from each other, and each independently N or CH,
at least one of Y1 to Y3 is N,
L31 to L33 are the same as or different from each other, and each independently a direct bond; a C6 to C60 arylene group; or a C2 to C60 heteroarylene group,
R31 to R33 are the same as or different from each other, and each independently a cyano group; a substituted or unsubstituted C6 to C60 aryl group; or a substituted or unsubstituted C2 to C60 heteroaryl group, and
r31 to r33 are each an integer of 0 to 5, and when each 2 or greater, substituents in the parentheses are the same as or different from each other.

In one embodiment of the present specification, Y1 to Y3 of Chemical Formula 3 are the same as or different from each other and each independently N or CH, and two or more of Y1 to Y3 are preferably N.

In one embodiment of the present specification, Y1 to Y3 are the same as or different from each other and each independently N or CH, and two of Y1 to Y3 may be N.

In one embodiment of the present specification, Y1 to Y3 may all be N.

In one embodiment of the present specification, L31 to L33 of Chemical Formula 3 are the same as or different from each other, and each independently a direct bond; a C6 to C30 arylene group; or a C2 to C30 heteroarylene group.

In one embodiment of the present specification, L31 to L33 are the same as or different from each other, and each independently a direct bond; or a C6 to C30 arylene group.

In one embodiment of the present specification, L31 to L33 are the same as or different from each other, and each independently a direct bond; a phenylene group; a biphenylene group; or a naphthylene group.

In one embodiment of the present specification, R31 to R33 of Chemical Formula 3 are the same as or different from each other, and each independently a cyano group; a substituted or unsubstituted C6 to C30 aryl group; or a substituted or unsubstituted C2 to C30 heteroaryl group.

In one embodiment of the present specification, R31 to R33 are the same as or different from each other, and may be each independently a cyano group; a substituted or unsubstituted phenyl group; a substituted or unsubstituted biphenyl group; a substituted or unsubstituted terphenyl group; a substituted or unsubstituted naphthyl group; a substituted or unsubstituted phenanthrenyl group; a substituted or unsubstituted fluorenyl group; a substituted or unsubstituted benzofluorenyl group; a substituted or unsubstituted pyridine group; a substituted or unsubstituted quinoline group; a substituted or unsubstituted phenanthridine group; a substituted or unsubstituted dibenzofuran group; or a substituted or unsubstituted dibenzothiophene group.

In one embodiment of the present specification, R31 to R33 are the same as or different from each other, and may be each independently a cyano group; a phenyl group unsubstituted or substituted with one or more substituents selected from the group consisting of a cyano group, an aryl group and a heteroaryl group; a biphenyl group unsubstituted or substituted with a heteroaryl group; a terphenyl group unsubstituted or substituted with a heteroaryl group; a naphthyl group unsubstituted or substituted with an aryl group; a substituted or unsubstituted phenanthrenyl group; a fluorenyl group unsubstituted or substituted with one or more substituents selected from the group consisting of a cyano group, an alkyl group and an aryl group; a benzofluorenyl group unsubstituted or substituted with an alkyl group; a substituted or unsubstituted pyridine group; a substituted or unsubstituted quinoline group; a substituted or unsubstituted phenanthridine group; a substituted or unsubstituted dibenzofuran group; or a substituted or unsubstituted dibenzothiophene group.

In one embodiment of the present specification, R31 to R33 are the same as or different from each other, and may be each independently a cyano group; a phenyl group unsubstituted or substituted with one or more substituents selected from the group consisting of a cyano group, an aryl group and a heteroaryl group; a biphenyl group unsubstituted or substituted with a pyridine group; a terphenyl group unsubstituted or substituted with a pyridine group; a naphthyl group unsubstituted or substituted with a phenyl group; a phenanthrenyl group; a dimethylfluorenyl group unsubstituted or substituted with a cyano group; a diphenylfluorenyl group; a spirobifluorenyl group; a dimethylbenzofluorenyl group; a pyridine group; a quinoline group; a phenanthridine group; a dibenzofuran group; or a dibenzothiophene group.

In one embodiment of the present specification, r31 to r33 are each an integer of 1 to 5, and when each 2 or greater, substituents in the parentheses are the same as or different from each other.

In one embodiment of the present specification, Chemical Formula 3 may be represented by any one of the following compounds, but is not limited thereto.

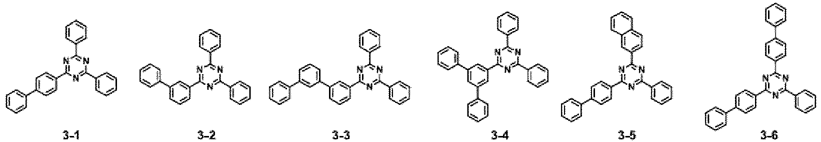

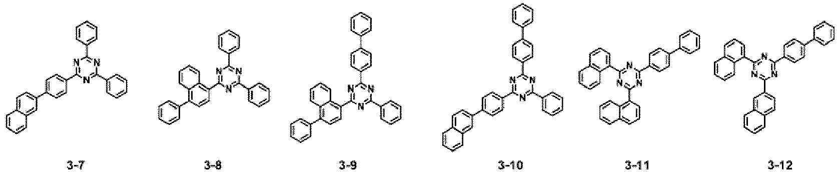

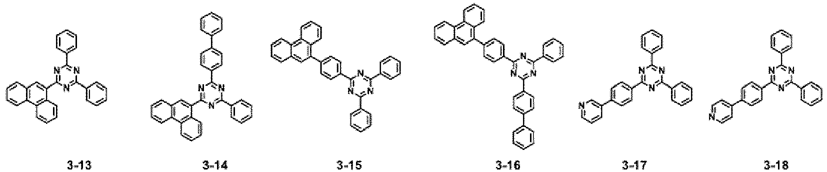

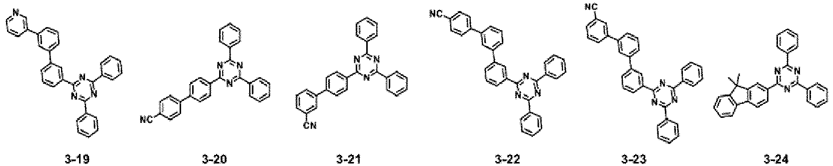

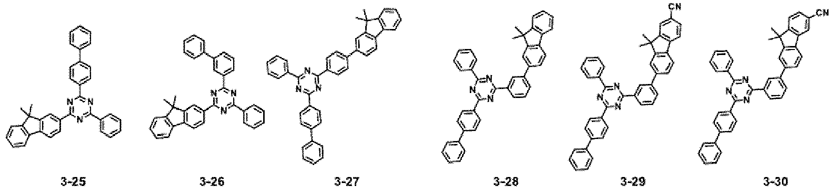

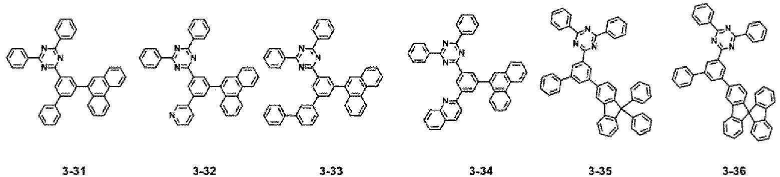

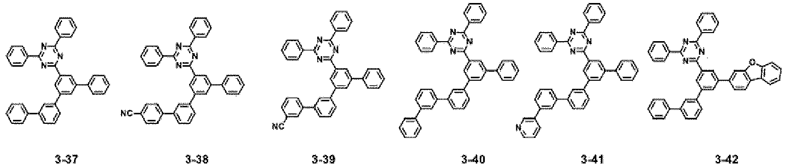

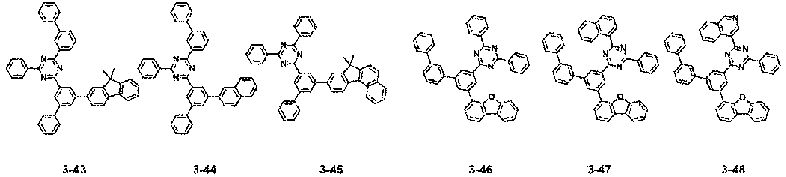

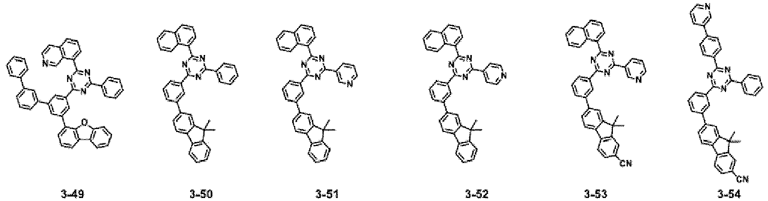

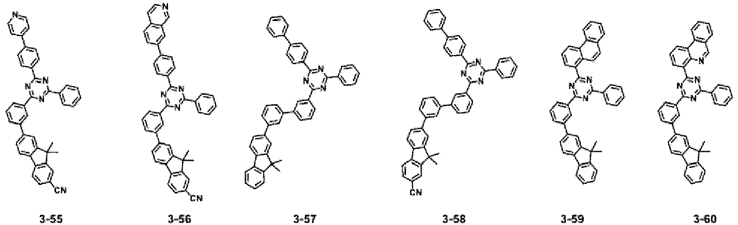

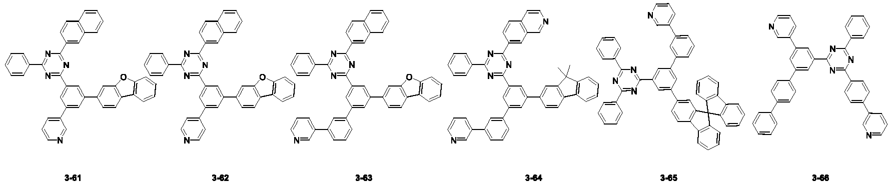

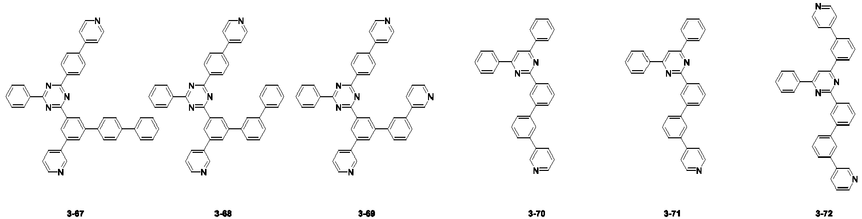

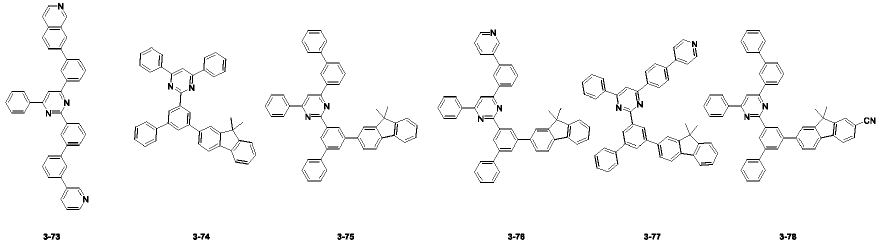

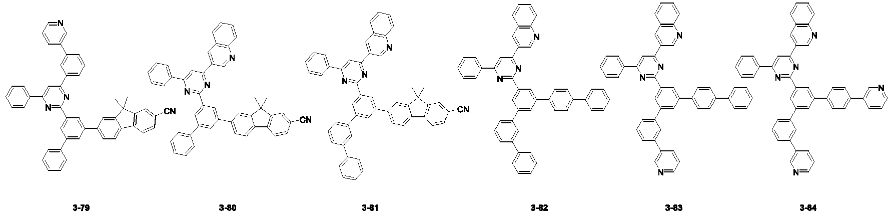

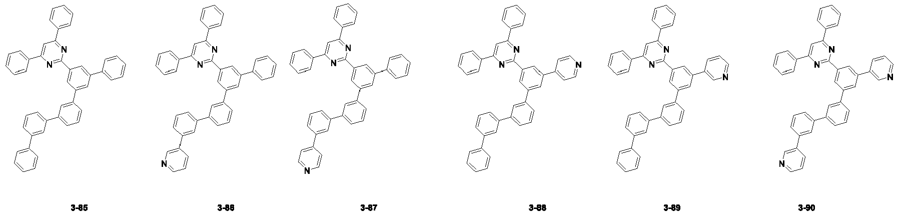

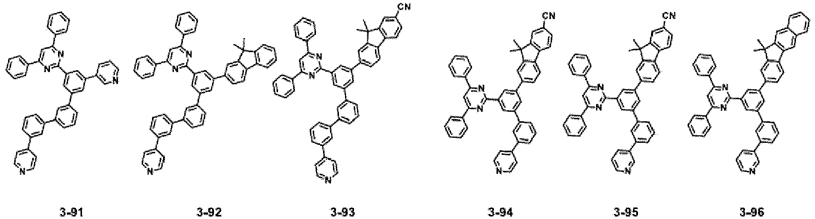

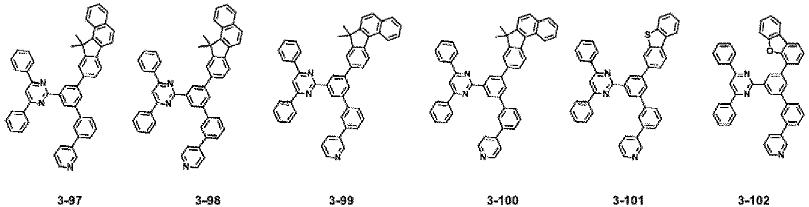

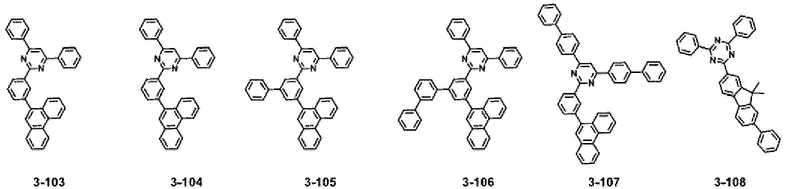

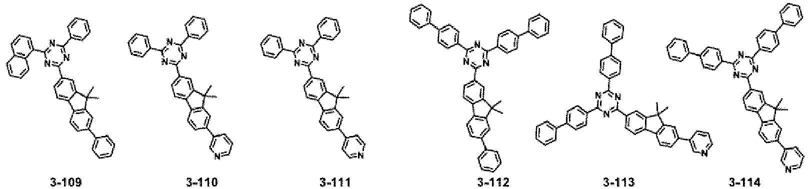

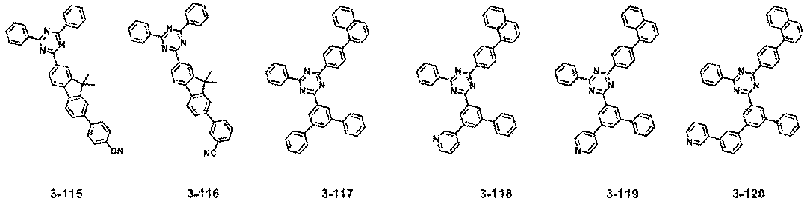

In one embodiment of the present specification, the organic material layer includes a hole transfer layer, and the hole transfer layer may include a compound of the following Chemical Formula 4. 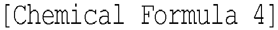 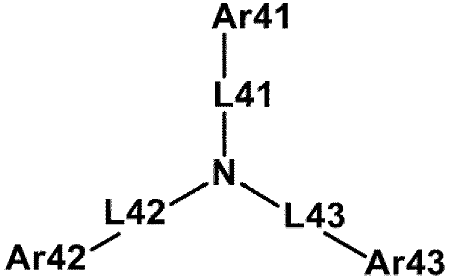 In Chemical Formula 4,
L41 to L43 are the same as or different from each other, and each independently a direct bond; or a C6 to C60 arylene group, and
Ar41 to Ar43 are the same as or different from each other, and each independently a substituted or unsubstituted C6 to C60 aryl group; or a substituted or unsubstituted C2 to C60 heteroaryl group.

In one embodiment of the present specification, L41 to L43 of Chemical Formula 4 are the same as or different from each other, and each independently a direct bond; or a C6 to C30 arylene group.

In one embodiment of the present specification, L41 to L43 are the same as or different from each other, and each independently a direct bond; a phenylene group; a biphenylene group; or a naphthylene group.

In one embodiment of the present specification, Ar41 to Ar43 of Chemical Formula 4 are the same as or different from each other, and each independently a substituted or unsubstituted C6 to C30 aryl group; or a substituted or unsubstituted C2 to C30 heteroaryl group.

In one embodiment of the present specification, Ar41 to Ar43 are the same as or different from each other, and may be each independently a substituted or unsubstituted phenyl group; a substituted or unsubstituted biphenyl group; a substituted or unsubstituted terphenyl group; a substituted or unsubstituted naphthyl group; a substituted or unsubstituted phenanthrenyl group; a substituted or unsubstituted fluorenyl group; a substituted or unsubstituted benzofluorenyl group; a substituted or unsubstituted carbazole group; a substituted or unsubstituted dibenzofuran group; or a substituted or unsubstituted dibenzothiophene group.

In one embodiment of the present specification, Ar41 to Ar43 are the same as or different from each other, and may be each independently a phenyl group unsubstituted or substituted with an aryl group; a substituted or unsubstituted biphenyl group; a substituted or unsubstituted terphenyl group; a substituted or unsubstituted naphthyl group; a substituted or unsubstituted phenanthrenyl group; a fluorenyl group unsubstituted or substituted with one or more substituents selected from the group consisting of an alkyl group and an aryl group; a benzofluorenyl group unsubstituted or substituted with an alkyl group; a carbazole group unsubstituted or substituted with an aryl group; a substituted or unsubstituted dibenzofuran group; or a substituted or unsubstituted dibenzothiophene group.

In one embodiment of the present specification, Ar41 to Ar43 are the same as or different from each other, and may be each independently a phenyl group unsubstituted or substituted with an aryl group; a biphenyl group; a terphenyl group; a naphthyl group; a phenanthrenyl group; a dimethylfluorenyl group; a diphenylfluorenyl group; a spirobifluorenyl group unsubstituted or substituted with an alkyl group; a dimethylbenzofluorenyl group; a carbazole group unsubstituted or substituted with an aryl group; a dibenzofuran group; or a dibenzothiophene group.

In one embodiment of the present specification, Chemical Formula 4 may be represented by any one of the following compounds, but is not limited thereto.

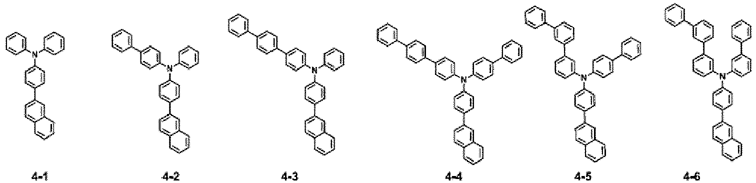

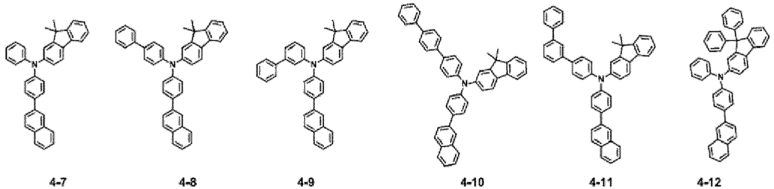

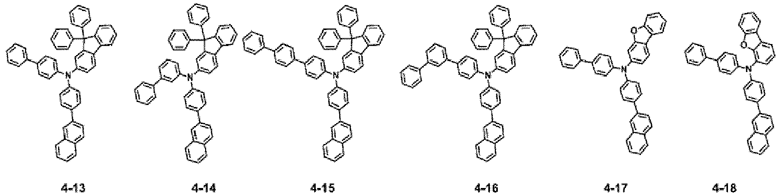

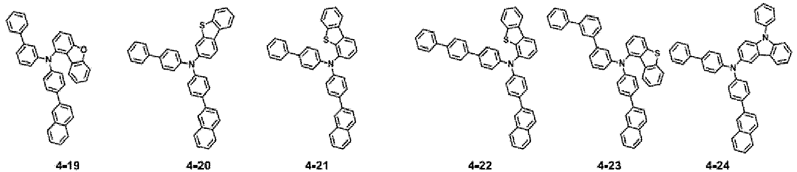

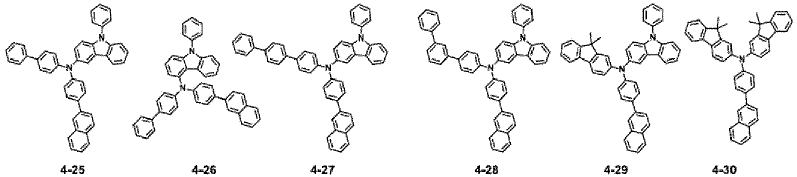

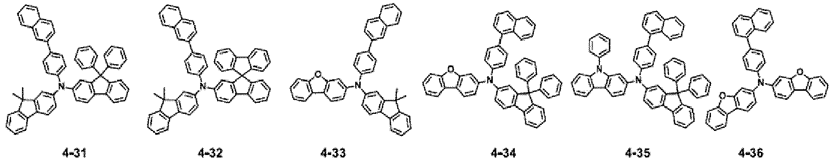

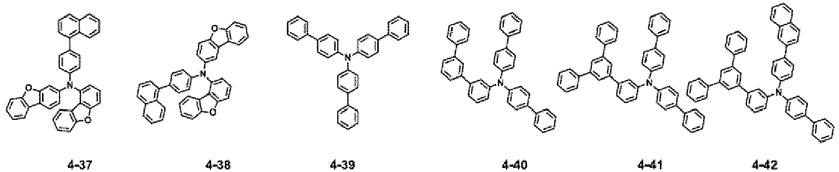

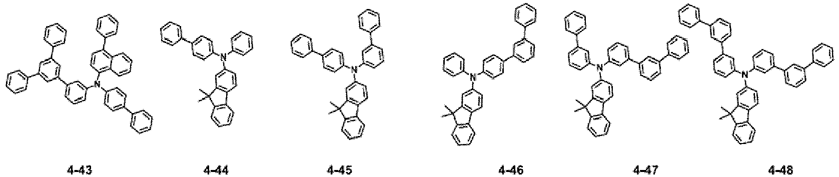

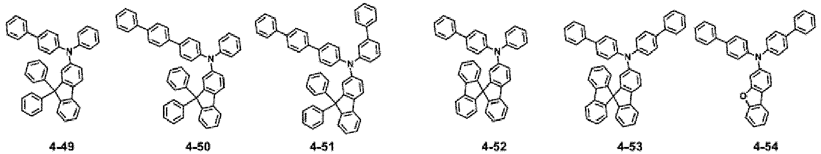

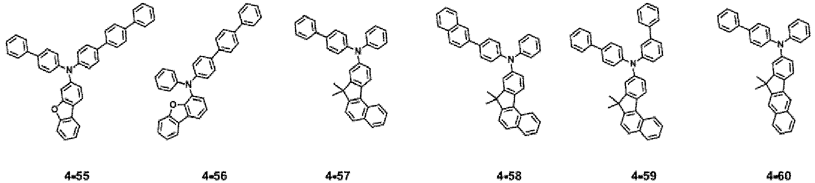

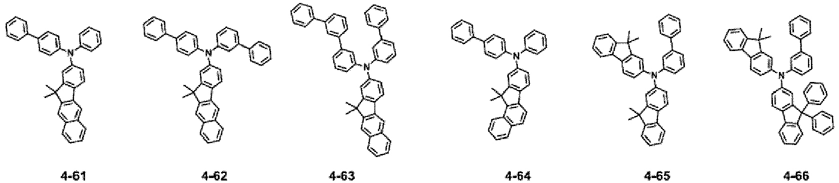

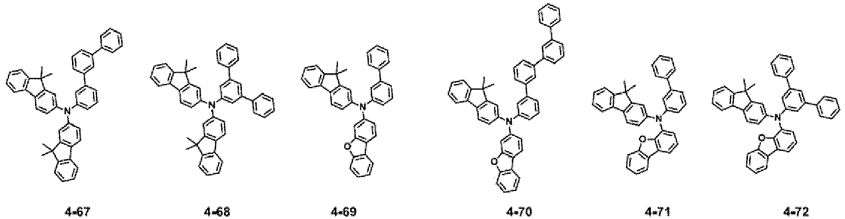

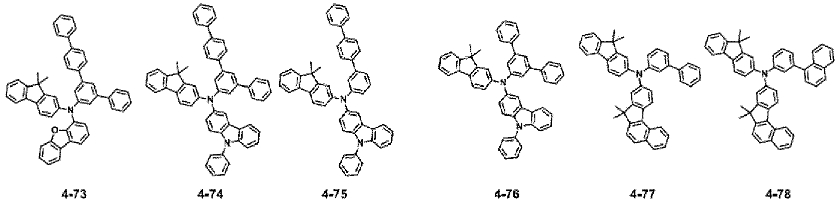

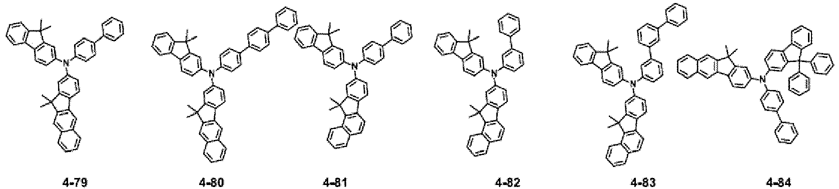

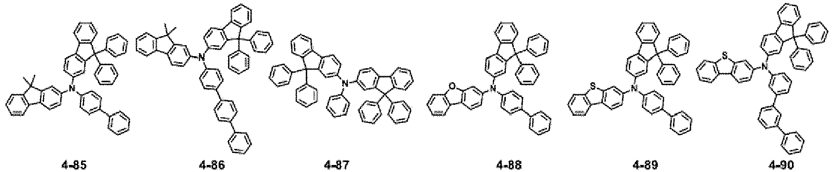

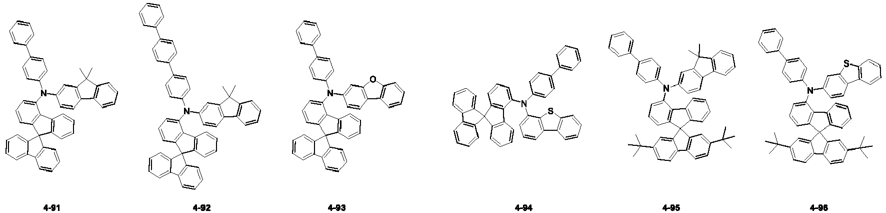

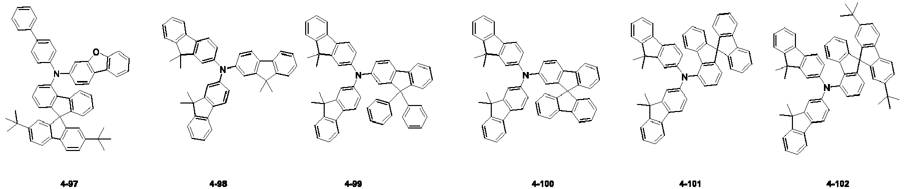

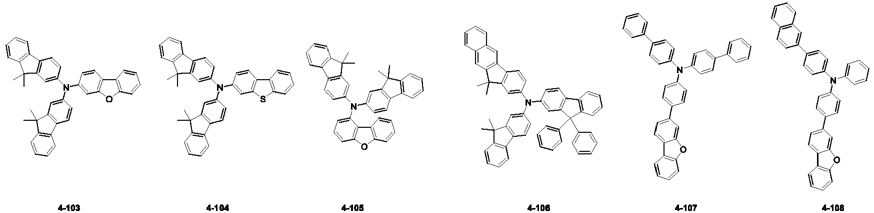

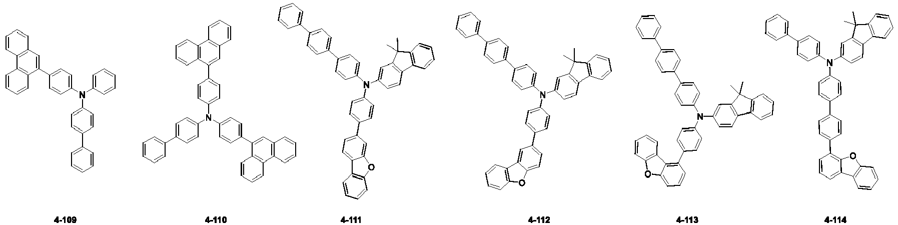

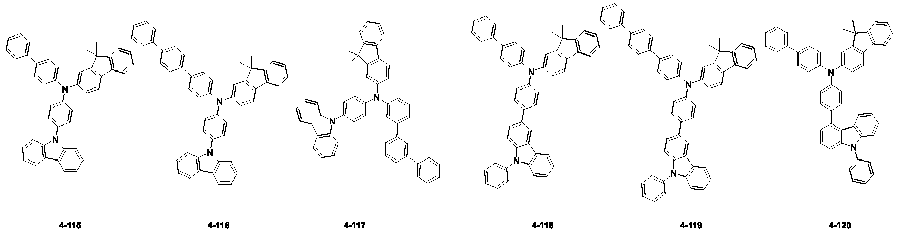

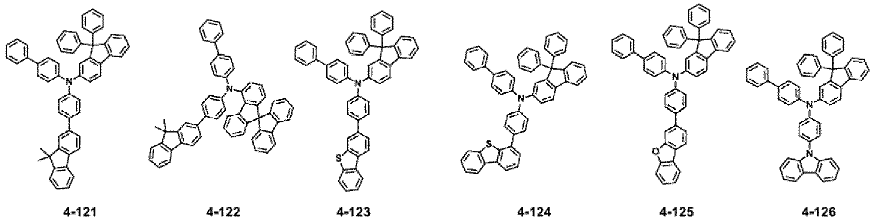

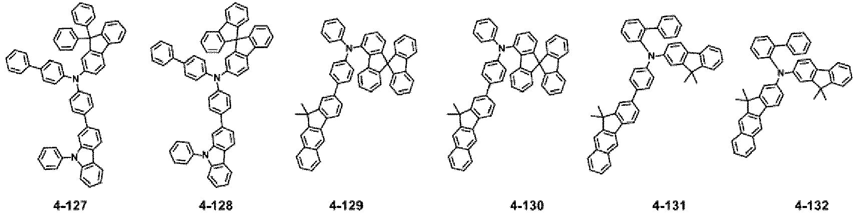

FIG. 1 to FIG. 3 illustrate a lamination order of electrodes and organic material layers of the organic light emitting device according to one embodiment of the present specification. However, the scope of the present application is not limited to these diagrams, and structures of organic light emitting devices known in the art may also be used in the present application.

FIG. 1 illustrates an organic light emitting device in which an anode (200), an organic material layer (300) and a cathode (400) are consecutively laminated on a substrate (100). However, the structure is not limited to such a structure, and as illustrated in FIG. 2, an organic light emitting device in which a cathode, an organic material layer and an anode are consecutively laminated on a substrate may also be obtained.

FIG. 3 illustrates a case of the organic material layer being a multilayer. The organic light emitting device according to FIG. 3 includes a hole injection layer (301), a hole transfer layer (302), a light emitting layer (303), a hole blocking layer (304), an electron transfer layer (305) and an electron injection layer (306). However, the scope of the present application is not limited to such a lamination structure, and as necessary, layers other than the light emitting layer may not be included, and other necessary functional layers may be further added.

The organic material layer including the compound of Chemical Formula 1 may further include other materials as necessary.

In the organic light emitting device according to one embodiment of the present specification, materials other than the compound of Chemical Formula 1 are illustrated below, however, these are for illustrative purposes only and not for limiting the scope of the present application, and may be replaced by materials known in the art.

As the anode material, materials having relatively large work function may be used, and transparent conductive oxides, metals, conductive polymers or the like may be used. Specific examples of the anode material include metals such as vanadium, chromium, copper, zinc and gold, or alloys thereof; metal oxides such as zinc oxide, indium oxide, indium tin oxide (ITO) and indium zinc oxide (IZO); combinations of metals and oxides such as ZnO:Al or SnO₂:Sb; conductive polymers such as poly(3-methylthiophene), poly[3,4-(ethylene-1,2-dioxy)thiophene] (PEDOT), polypyrrole and polyaniline, and the like, but are not limited thereto.

As the cathode material, materials having relatively small work function may be used, and metals, metal oxides, conductive polymers or the like may be used. Specific examples of the cathode material include metals such as magnesium, calcium, sodium, potassium, titanium, indium, yttrium, lithium, gadolinium, aluminum, silver, tin and lead, or alloys thereof; multilayer structure materials such as LiF/Al or LiO₂/Al, and the like, but are not limited thereto.

As the hole injection material, known hole injection materials may be used, and for example, phthalocyanine compounds such as copper phthalocyanine disclosed in US Patent No. 4,356,429, or starburst-type amine derivatives such as tris(4-carbazoyl-9-ylphenyl)amine (TCTA), 4,4',4"-tri[phenyl(m-tolyl)amino]triphenylamine (m-MTDATA) or 1,3,5-tris[4-(3-methylphenylphenylamino)phenyl]benzene (m-MTDAPB) described in the literature [Advanced Material, 6, p.677 (1994)], polyaniline/dodecylbenzene sulfonic acid, poly(3,4-ethylenedioxythiophene)/poly(4-styrenesulfonate), polyaniline/camphor sulfonic acid or polyaniline/poly(4-styrenesulfonate) that are conductive polymers having solubility, and the like, may be used.

As the hole transfer material, pyrazoline derivatives, arylamine-based derivatives, stilbene derivatives, triphenyldiamine derivatives and the like may be used in addition to the compound of Chemical Formula 4, and low molecular or high molecular materials may also be used.

As the electron transfer material, metal complexes of oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, 8-hydroxyquinoline and derivatives thereof, and the like, may be used in addition to the compound of Chemical Formula 3, and high molecular materials may also be used as well as low molecular materials.

As examples of the electron injection material, LiF is typically used in the art, however, the present application is not limited thereto.

As the light emitting material, red, green or blue light emitting materials may be used, and as necessary, two or more light emitting materials may be mixed and used. Herein, two or more light emitting materials may be used by being deposited as individual sources of supply or by being premixed and deposited as one source of supply. In addition, fluorescent materials may also be used as the light emitting material, however, phosphorescent materials may also be used. As the light emitting material, materials emitting light by bonding electrons and holes injected from an anode and a cathode, respectively, may be used alone, however, materials having a host material and a dopant material involving in light emission together may also be used.

When mixing light emitting material hosts, same series hosts may be mixed, or different series hosts may be mixed. For example, any two or more types of materials among N-type host materials or P-type host materials may be selected and used as a host material of a light emitting layer.

In the present specification, the compound of Chemical Formula 1 and the compound of Chemical Formula 2 are used as the host material, and a phosphorescent dopant may be used as the dopant material.

In the present specification, the phosphorescent dopant may be (piq)₂(Ir)(acac).

In the present specification, the compound of Chemical Formula 1 may be a P-type host material.

In the present specification, the compound of Chemical Formula 2 may be an N-type host material.

The organic light emitting device according to one embodiment of the present specification may be a top-emission type, a bottom-emission type or a dual-emission type depending on the materials used.

The compound according to one embodiment of the present specification may also be used in an organic electronic device including an organic solar cell, an organic photo conductor, an organic transistor and the like under a similar principle used in the organic light emitting device.

One embodiment of the present specification provides a composition for forming an organic material layer, the composition including the compound of Chemical Formula 1 and the compound of Chemical Formula 2.

The composition for forming an organic material layer according to one embodiment of the present specification may include the compound of Chemical Formula 1 and the compound of Chemical Formula 2 in a weight ratio of 1:10 to 10:1, and specifically, in a weight ratio of 1:5 to 5:1 and 1:3 to 3:1.

The composition for forming an organic material layer according to one embodiment of the present specification may be used as a material of a light emitting layer of an organic light emitting device.

Hereinafter, the present specification will be described in more detail with reference to examples, however, these are for illustrative purposes only, and the scope of the present application is not limited thereto.

### [Synthesis Method]

### Synthesis Method 1. Synthesis of Compound 1-1

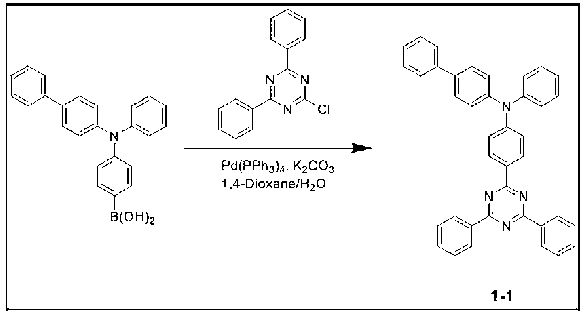

(4-([1,1'-Biphenyl]-4-yl(phenyl)amino)phenyl)boronic acid (10.0 g, 27.4 mM), 2-chloro-4,6-diphenyl-1,3,5-triazine (8.1 g, 30.1 mM), Pd(PPh₃)₄ (tetrakis(triphenylphosphine)palladium(0)) (1.6 g, 1.4 mM) and K₂CO₃ (9.5 g, 68.5 mM) were dissolved in 1,4-dioxane/H₂O (100 mL/20 mL), and refluxed for 1 hour. After the reaction was completed, the result was extracted at room temperature, and the solvent was removed from the filtrate using a rotary evaporator. The reaction material was purified by column chromatography (dichloromethane (DCM):hexane (Hex)=1:1), and recrystallized with methanol to obtain target Compound 1-1 (13.5 g, 89.1%).

Target compounds were prepared in the same manner as in Synthesis Method 1 except that Intermediates A and B of the following Table 1 were used instead of (4-([1,1'-biphenyl]-4-yl(phenyl)amino)phenyl)boronic acid and 2-chloro-4,6-diphenyl-1,3,5-triazine.

**[Table 1]**

| Compou nd | Intermediate A | Intermediate B | Target Compound | Yield |
|---|---|---|---|---|
| 1-1 | 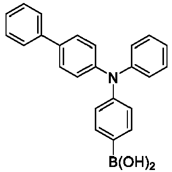 | 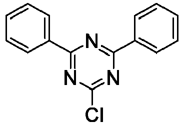 | 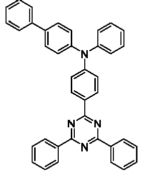 | 89.1% |
| 1-2 | 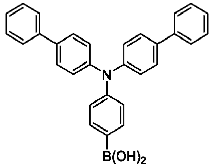 | 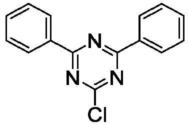 | 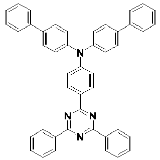 | 88.9% |
| 1-16 | 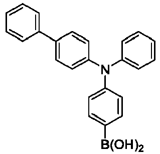 | 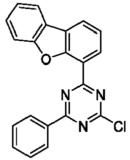 | 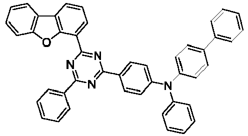 | 85.9% |
| 1-39 | 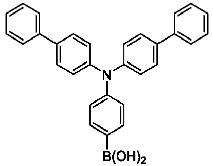 | 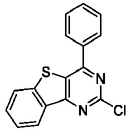 | 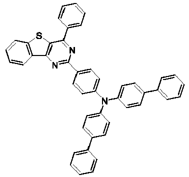 | 87.8% |
| 1-40 | 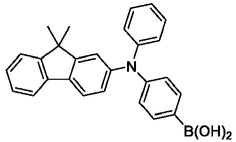 | 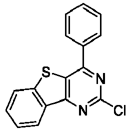 | 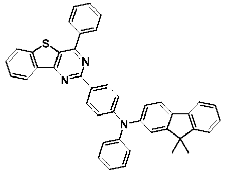 | 86.3% |

### Synthesis Method 2. Synthesis of Compound 1-28

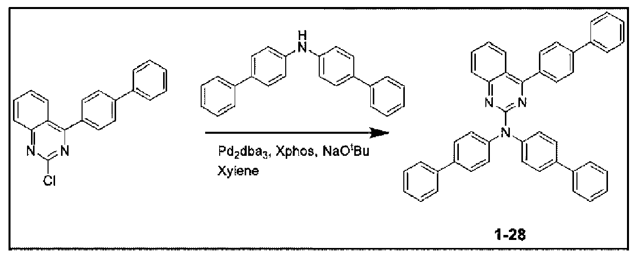

4-([1,1'-Biphenyl]-4-yl)-2-chloroquinazoline (10.0 g, 5 31.6 mM), di([1,1'-biphenyl]-4-yl)amine (10.2 g, 31.6 mM), Pd₂(dba)₃ (tris(dibenzylideneacetone)dipalladium(0)) (1.5 g, 1.6 mM), Xphos (2-dicyclohexylphosphino-2',4',6'-triisopropylbiphenyl) (1.5 g, 3.2 mM) and NaO^{t}Bu (9.1 g, 94.8 mM) were dissolved in xylene (100 mL), and refluxed for 1 hour. After the reaction was completed, the result was celite filtered at room temperature, and the solvent was removed from the filtrate using a rotary evaporator. The reaction material was purified by column chromatography (DCM:Hex=1:1), and recrystallized with methanol to obtain target Compound 1-28 (18.1 g, 94.9%).

Target compounds were prepared in the same manner as in Synthesis Method 2 except that Intermediates C and D of the following Table 2 were used instead of 4-([1,1'-biphenyl]-4-yl)-2-chloroquinazoline and di([1,1'-biphenyl]-4-yl)amine.

**[Table 2]**

| Compou nd | Intermediate C | Intermediate D | Target Compound | Yield |
|---|---|---|---|---|
| 1-28 | 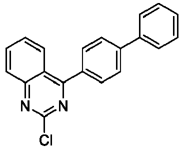 | 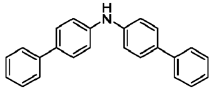 | 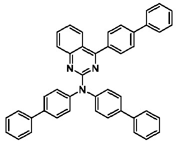 | 94.9% |
| 1-29 | 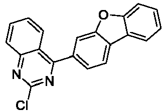 | 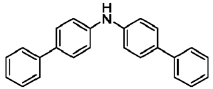 | 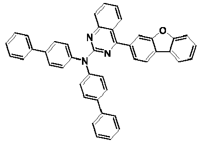 | 91.3% |

### Synthesis Method 3. Synthesis of Compound 1-82

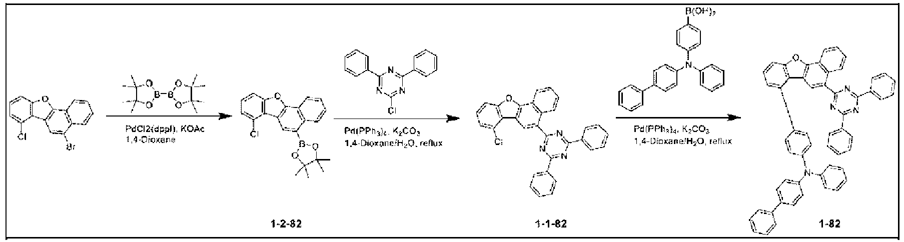

### 3-1) Synthesis of Compound 1-2-82

5-Bromo-7-chloronaphtho[1,2-b]benzofuran (10.0 g, 30.2 mM), 4,4,4',4',5,5,5',5'-octamethyl-2,2'-bi(1,3,2-dioxaborolane) (11.5 g, 45.3 mM), PdCl₂(dppf) ([1,1'-bis(diphenylphosphino)ferrocene]dichloropalladium(II)) (1.1 g, 1.5 mM) and potassium acetate (KOAc) (5.9 g, 60.4 mM) were dissolved in 1,4-dioxane (100 mL), and refluxed for 1 hour. After the reaction was completed, the result was celite filtered at room temperature, and the solvent was removed from the filtrate using a rotary evaporator. The reaction material was purified by column chromatography (DCM:Hex=1:5), and recrystallized with methanol to obtain Compound 1-2-82 (10.1 g, 88.4%).

### 3-2) Synthesis of Compound 1-1-82

Compound 1-2-82 (10.0 g, 26.4 mM), 2-chloro-4,6-diphenyl-1,3,5-triazine (7.8 g, 29.0 mM), Pd(PPh₃)₄ (1.5 g, 1.3 mM) and K₂CO₃ (9.1 g, 66.0 mM) were dissolved in 1,4-dioxane/H₂O (100 mL/20 mL), and refluxed for 1 hour. After the reaction was completed, the result was filtered under vacuum at room temperature. After that, the result was stirred for 30 minutes in distilled water, and then dried to obtain Compound 1-1-82 (11.5 g, 90.1%).

### 3-3) Synthesis of Compound 1-82

Compound 1-1-82 (10.0 g, 20.7 mM), (4-([1,1'-biphenyl]-4-yl(phenyl)amino)phenyl)boronic acid (8.3 g, 22.8 mM), Pd(PPh₃)₄ (1.2 g, 1.0 mM) and K₂CO₃ (7.2 g, 51.8 mM) were dissolved in 1,4-dioxane/H₂O (100 mL/20 mL), and refluxed for 1 hour. After the reaction was completed, the result was celite filtered at room temperature, and the solvent was removed from the filtrate using a rotary evaporator. The reaction material was purified by column chromatography (DCM:Hex=1:5), and recrystallized with methanol to obtain target Compound 1-82 (14.3 g, 89.9%).

Target compounds were prepared in the same manner as in Synthesis Method 3 except that Intermediates E and F of the following Table 3 were used instead of 2-chloro-4,6-diphenyl-1,3,5-triazine and (4-([1,1'-biphenyl]-4-yl(phenyl)amino)phenyl)boronic acid.

**[Table 3]**

| Compou nd | Intermediate E | Intermediate F | Target Compound | Yield |
|---|---|---|---|---|
| 1-82 | 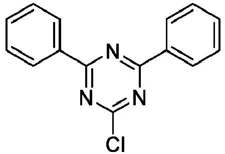 | 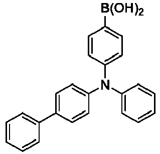 | 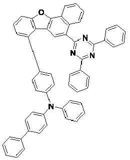 | 89.9% |
| 1-87 | 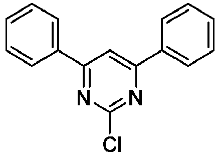 | 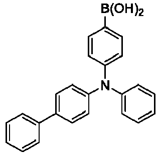 | 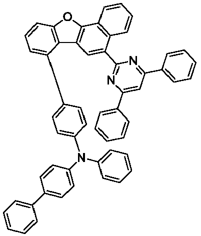 | 88.3% |

### Synthesis Method 4. Synthesis of Compound 1-80

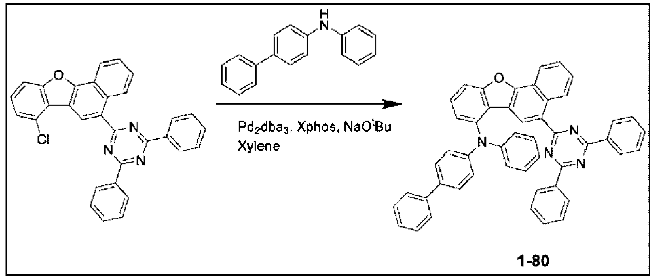

Compound 1-1-82 (10.0 g, 20.7 mM), N-phenyl-[1,1'-biphenyl]-4-amine (5.6 g, 22.8 mM), Pd₂(dba)₃ (0.9 g, 1.0 mM), Xphos (1.0 g, 2.1 mM) and NaO^{t}Bu (6.0 g, 62.1 mM) were dissolved in xylene (100 mL), and refluxed for 1 hour. After the reaction was completed, the result was celite filtered at room temperature, and the solvent was removed from the filtrate using a rotary evaporator. The reaction material was purified by column chromatography (DCM:Hex=1:1), and recrystallized with methanol to obtain target Compound 1-80 (13.5 g, 94.2%).

Target compounds were prepared in the same manner as in Synthesis Methods 3 and 4 except that Intermediate G of the following Table 4 was used instead of 2-chloro-4,6-diphenyl-1,3,5-triazine in Synthesis Method 3, and Intermediate H of the following Table 4 was used instead of N-phenyl-[1,1'-biphenyl]-4-amine in Synthesis Method 4.

**[Table 4]**

| Compou nd | Intermediate G | Intermediate H | Target Compound | Yield |
|---|---|---|---|---|
| 1-80 | 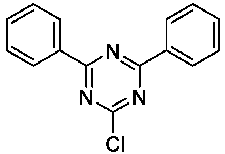 | 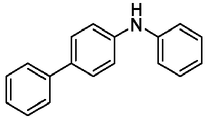 | 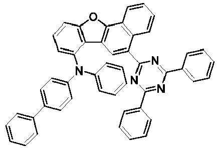 | 94.2% |
| 1-84 | 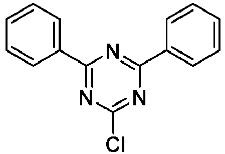 | 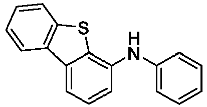 | 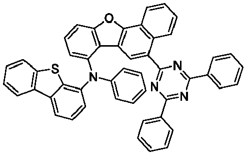 | 90.5% |
| 1-94 | 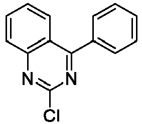 | 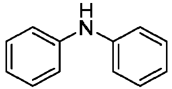 | 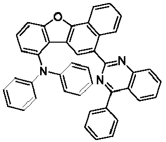 | 90.1% |
| 1-95 | 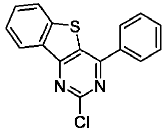 | 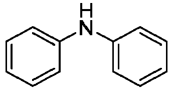 | 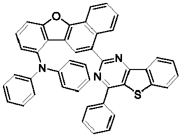 | 90.9% |

### Synthesis Method 5. Synthesis of Compound 1-136

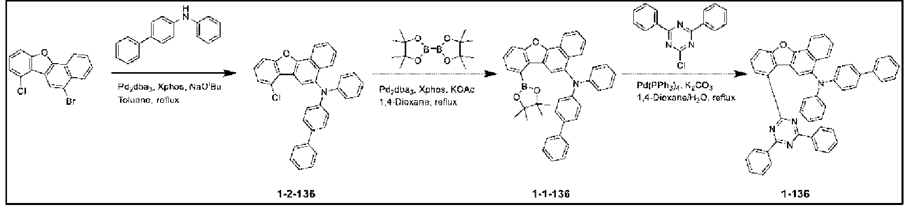

### 5-1) Synthesis of Compound 1-2-136

5-Bromo-7-chloronaphtho[1,2-b]benzofuran (10.0 g, 30.2 mM), N-phenyl-[1,1'-biphenyl]-4-amine (7.4 g, 30.2 mM), Pd₂(dba)₃ (1.4 g, 1.5 mM), Xphos (1.4 g, 3.0 mM) and NaO^{t}Bu (5.8 g, 60.4 mM) were dissolved in toluene (100 mL), and refluxed for 1 hour. After the reaction was completed, the result was celite filtered at room temperature, and the solvent was removed from the filtrate using a rotary evaporator. The reaction material was purified by column chromatography (DCM:Hex=1:5), and recrystallized with methanol to obtain Compound 1-2-136 (12.3 g, 82.1%).

### 5-2) Synthesis of Compound 1-1-136

Compound 1-2-136 (10.0 g, 20.2 mM), 4,4,4',4',5,5,5',5'-octamethyl-2,2'-bi(1,3,2-dioxaborolane) (7.7 g, 30.3 mM), Pd₂(dba)₃ (0.9 g, 1.0 mM), Xphos (1.0 g, 2.0 mM) and KOAc (4.0 g, 40.4 mM) were dissolved in 1,4-dioxane (100 mL), and refluxed for 1 hour. After the reaction was completed, the result was celite filtered at room temperature, and the solvent was removed from the filtrate using a rotary evaporator. The reaction material was purified by column chromatography (DCM:Hex=1:3), and recrystallized with methanol to obtain Compound 1-1-136 (10.5 g, 88.6%).

### 5-3) Synthesis of Compound 1-136

Compound 1-1-136 (10.0 g, 17.0 mM), 2-chloro-4,6-diphenyl-1,3,5-triazine (5.0 g, 18.7 mM), Pd(PPh₃)₄ (1.0 g, 0.9 mM) and K₂CO₃ (5.9 g, 42.5 mM) were dissolved in 1,4-dioxane/H₂O (100 mL/20 mL), and refluxed for 1 hour. After the reaction was completed, the result was extracted at room temperature, and the solvent was removed from the filtrate using a rotary evaporator. The reaction material was purified by column chromatography (DCM:Hex=1:1), and recrystallized with methanol to obtain target Compound 1-136 (10.5 g, 88.8%).

Target compounds were prepared in the same manner as in Synthesis Method 5 except that Intermediates I and J of the following Table 5 were used instead of N-phenyl-[1,1'-biphenyl]-4-amine and 2-chloro-4,6-diphenyl-1,3,5-triazine.

**[Table 5]**

| Compound | Intermediate I | Intermediate J | Target Compound | Yield |
|---|---|---|---|---|
| 1-136 | 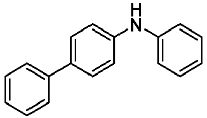 | 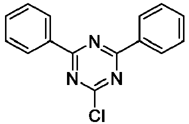 | 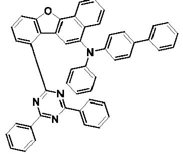 | 88.8% |
| 1-140 | 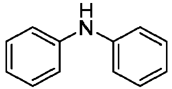 | 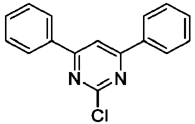 | 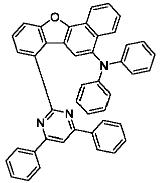 | 87.5% |
| 1-142 | 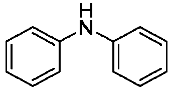 | 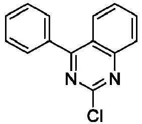 | 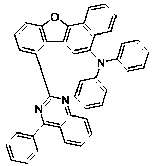 | 86.3% |

### Synthesis Method 6. Synthesis of Compound 1-177

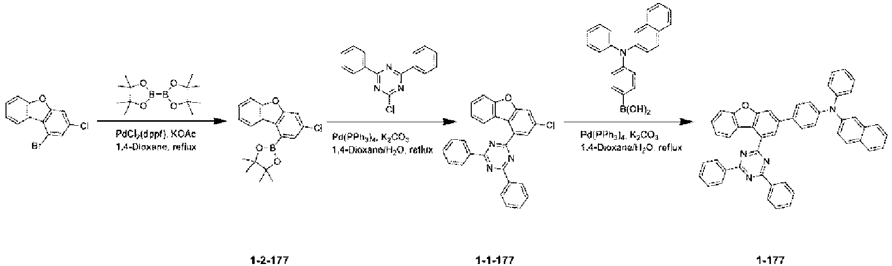

### 6-1) Synthesis of Compound 1-2-177

1-Bromo-3-chlorodibenzo[b,d]furan (10.0 g, 35.5 mM), 4,4,4',4',5,5,5',5'-octamethyl-2,2'-bi(1,3,2-dioxaborolane) (13.5 g, 53.3 mM), PdCl₂(dppf) (1.3 g, 1.8 mM) and KOAc (7.0 g, 71.0 mM) were dissolved in 1,4-dioxane (100 mL), and refluxed for 1 hour. After the reaction was completed, the result was celite filtered at room temperature, and the solvent was removed from the filtrate using a rotary evaporator. The reaction material was purified by column chromatography (DCM:Hex=1:5), and recrystallized with methanol to obtain Compound 1-2-177 (10.3 g, 88.2%).

### 6-2) Synthesis of Compound 1-1-177

Compound 1-2-177 (10.0 g, 30.4 mM), 2-chloro-4,6-diphenyl-1,3,5-triazine (8.9 g, 33.4 mM), Pd(PPh₃)₄ (1.7 g, 1.5 mM) and K₂CO₃ (10.5 g, 76.0 mM) were dissolved in 1,4-dioxane/H₂O (100 mL/20 mL), and refluxed for 1 hour. After the reaction was completed, the result was filtered under vacuum at room temperature. After that, the result was stirred for 30 minutes in distilled water, and then dried to obtain Compound 1-1-177 (11.5 g, 87.2%).

### 6-3) Synthesis of Compound 1-177

Compound 1-1-177 (10.0 g, 23.0 mM), (4-(naphthalen-2-yl(phenyl)amino)phenyl)boronic acid (8.6 g, 25.3 mM), Pd(PPh₃)₄ (1.4 g, 1.2 mM) and K₂CO₃ (7.9 g, 57.5 mM) were dissolved in 1,4-dioxane/H₂O (100 mL/20 mL), and refluxed for 1 hour. After the reaction was completed, the result was celite filtered at room temperature, and the solvent was removed from the filtrate using a rotary evaporator. The reaction material was purified by column chromatography (DCM:Hex=1:1), and recrystallized with methanol to obtain target Compound 1-177 (14.1 g, 88.7%).

Target compounds were prepared in the same manner as in Synthesis Method 6 except that Intermediates K and L of the following Table 6 were used instead of 2-chloro-4,6-diphenyl-1,3,5-triazine and (4-(naphthalen-2-yl(phenyl)amino)phenyl)boronic acid.

**[Table 6]**

| Compound | Intermediate K | Intermediate L | Target Compound | Yield |
|---|---|---|---|---|
| 1-176 | 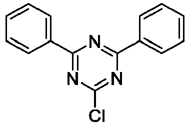 | 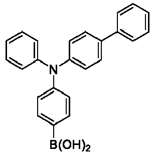 | 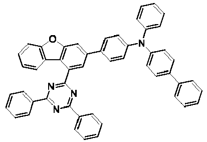 | 88.9% |
| 1-177 | 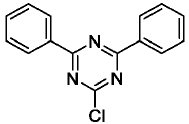 | 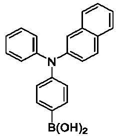 | 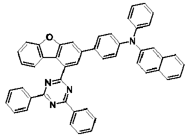 | 88.7% |
| 1-180 | 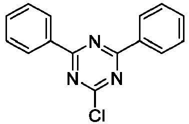 | 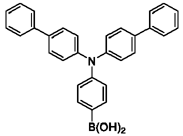 | 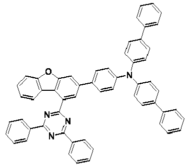 | 85.3% |
| 1-181 | 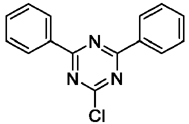 | 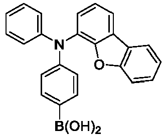 | 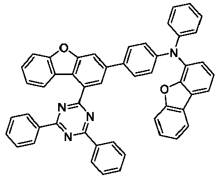 | 81.3% |
| 1-182 | 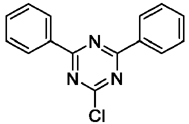 | 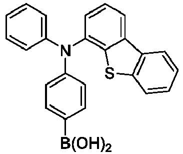 | 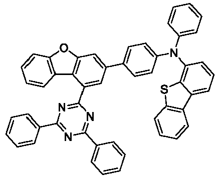 | 81.1% |
| 1-183 | 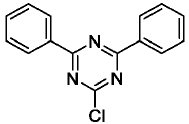 | 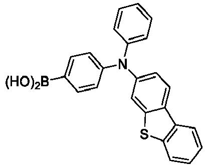 | 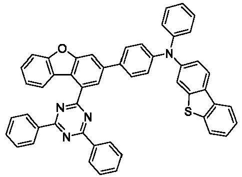 | 80.1% |
| 1-187 | 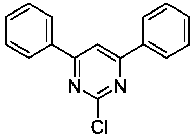 | 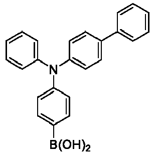 | 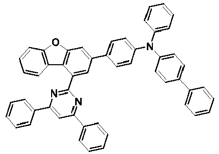 | 82.3% |
| 1-190 | 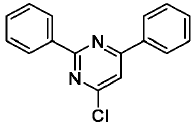 | 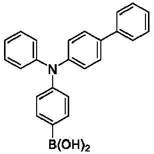 | 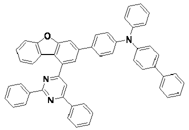 | 83.3% |
| 1-193 | 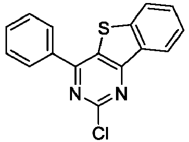 | 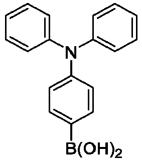 | 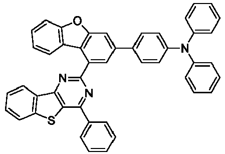 | 84.1% |
| 1-194 | 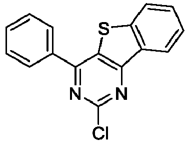 | 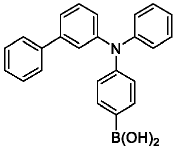 | 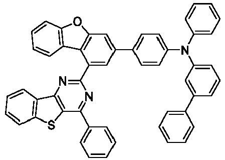 | 82.1% |

### Synthesis Method 7. Synthesis of Compound 1-201

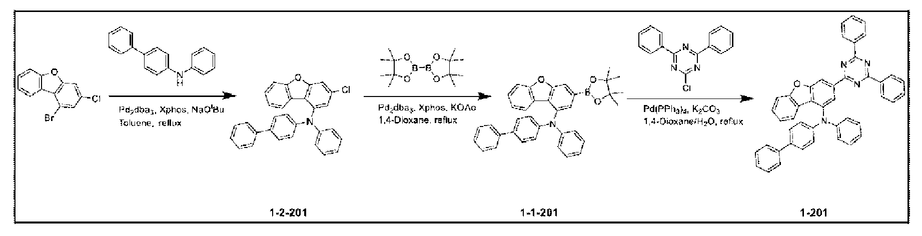

### 7-1) Synthesis of Compound 1-2-201

1-Bromo-3-chlorodibenzo[b,d]furan (10.0 g, 35.5 mM), N-phenyl-[1,1'-biphenyl]-4-amine (8.7 g, 35.5 mM), Pd₂(dba)₃ (1.6 g, 1.8 mM), Xphos (1.7 g, 3.6 mM) and NaO^{t}Bu (6.8 g, 71.0 mM) were dissolved in toluene (100 mL), and refluxed for 1 hour. After the reaction was completed, the result was celite filtered at room temperature, and the solvent was removed from the filtrate using a rotary evaporator. The reaction material was purified by column chromatography (DCM:Hex=1:5), and recrystallized with methanol to obtain Compound 1-2-201 (14.9 g, 94.1%).

### 7-2) Synthesis of Compound 1-1-201

Compound 1-2-201 (10.0 g, 22.4 mM), 4,4,4',4',5,5,5',5'-octamethyl-2,2'-bi(1,3,2-dioxaborolane) (8.5 g, 33.6 mM), Pd₂(dba)₃ (1.0 g, 1.1 mM), Xphos (1.0 g, 2.2 mM) and KOAc (4.4 g, 44.8 mM) were dissolved in 1,4-dioxane (100 mL), and refluxed for 1 hour. After the reaction was completed, the result was celite filtered at room temperature, and the solvent was removed from the filtrate using a rotary evaporator. The reaction material was purified by column chromatography (DCM:Hex=1:3), and recrystallized with methanol to obtain Compound 1-1-201 (11.3 g, 93.8%).

### 7-3) Synthesis of Compound 1-201

Compound 1-1-201 (10.0 g, 18.6 mM), 2-chloro-4,6-diphenyl-1,3,5-triazine (5.5 g, 20.5 mM), Pd(PPh₃)₄ (1.0 g, 0.9 mM) and K₂CO₃ (6.4 g, 46.5 mM) were dissolved in 1,4-dioxane/H₂O (100 mL/20 mL), and refluxed for 1 hour. After the reaction was completed, the result was extracted at room temperature, and the solvent was removed from the filtrate using a rotary evaporator. The reaction material was purified by column chromatography (DCM:Hex=1:1), and recrystallized with methanol to obtain target Compound 1-201 (10.9 g, 91.4%).

Target compounds were prepared in the same manner as in Synthesis Method 7 except that Intermediates M and N of the following Table 7 were used instead of N-phenyl-[1,1'-biphenyl]-4-amine and 2-chloro-4,6-diphenyl-1,3,5-triazine.

**[Table 7]**

| Compound | Intermediate M | Intermediate N | Target Compound | Yield |
|---|---|---|---|---|
| 1-201 | 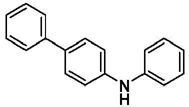 | 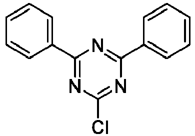 | 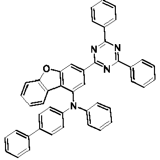 | 91.4% |
| 1-202 | 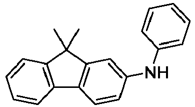 | 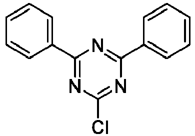 | 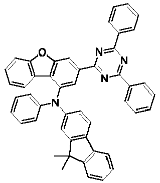 | 90.3% |
| 1-205 | 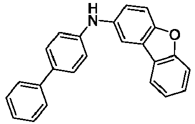 | 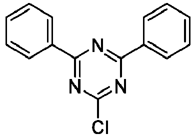 | 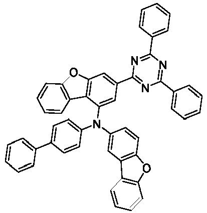 | 88.3% |

### Synthesis Method 8. Synthesis of Compound 1-229

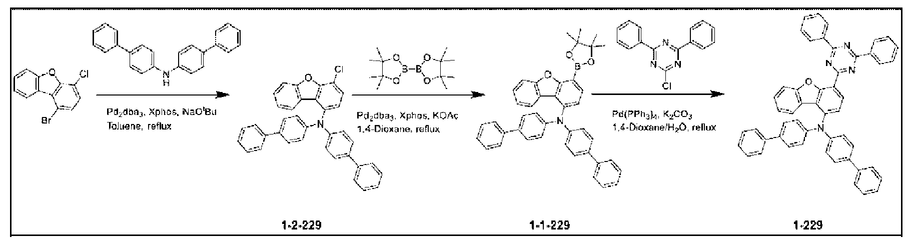

### 8-1) Synthesis of Compound 1-2-229

1-Bromo-4-chlorodibenzo[b,d]furan (20.0 g, 71.0 mM), di([1,1'-biphenyl]-4-yl)amine (22.8 g, 71.0 mM), Pd₂(dba)₃ (3.3 g, 3.6 mM),Xphos (3.4 g, 7.1 mM) and NaO^{t}Bu (13.6 g, 142.0 mM) were dissolved in toluene (200 mL), and refluxed for 1 hour. After the reaction was completed, the result was celite filtered at room temperature, and the solvent was removed from the filtrate using a rotary evaporator. The reaction material was purified by column chromatography (DCM:Hex=1:5), and recrystallized with methanol to obtain Compound 1-2-229 (34.1 g, 92.0%).

### 8-2) Synthesis of Compound 1-1-229

Compound 1-2-229 (20.0 g, 38.3 mM), 4,4,4' ,4',5,5,5',5'-octamethyl-2,2'-bi(1,3,2-dioxaborolane) (14.6 g, 57.5 mM), Pd₂(dba)₃ (1.7 g, 1.9 mM), Xphos (1.8 g, 3.8 mM) and KOAc (7.5 g, 76.6 mM) were dissolved in 1,4-dioxane (200 mL), and refluxed for 1 hour. After the reaction was completed, the result was celite filtered at room temperature, and the solvent was removed from the filtrate using a rotary evaporator. The reaction material was purified by column chromatography (DCM:Hex=1:3), and recrystallized with methanol to obtain Compound 1-1-229 (21.5 g, 91.4%).

### 8-3) Synthesis of Compound 1-229

Compound 1-1-229 (10.0 g, 16.3 mM), 2-chloro-4,6-diphenyl-1,3,5-triazine (4.8 g, 17.9 mM), Pd(PPh₃)₄ (0.9 g, 0.8 mM) and K₂CO₃ (5.6 g, 40.8 mM) were dissolved in 1,4-dioxane/H₂O (100 mL/20 mL), and refluxed for 1 hour. After the reaction was completed, the result was extracted at room temperature, and the solvent was removed from the filtrate using a rotary evaporator. The reaction material was purified by column chromatography (DCM:Hex=1:1), and recrystallized with methanol to obtain target Compound 1-229 (10.1 g, 86.5%).

Target compounds were prepared in the same manner as in Synthesis Method 8 except that Intermediates O and P of the following Table 8 were used instead of di([1,1'-biphenyl]-4-yl)amine and 2-chloro-4,6-diphenyl-1,3,5-triazine.

**[Table 8]**

| Compound | Intermediate O | Intermediate P | Target Compound | Yield |
|---|---|---|---|---|
| 1-229 | 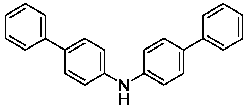 | 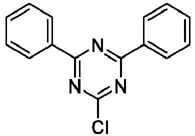 | 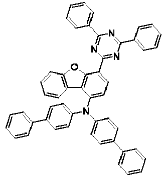 | 86.5% |
| 1-237 | 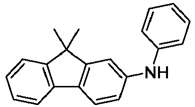 | 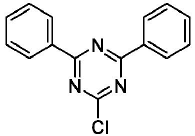 | 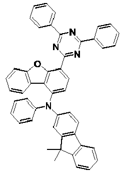 | 83.9% |
| 1-238 | 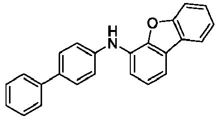 | 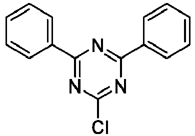 | 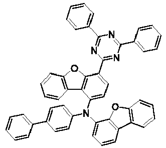 | 84.1% |
| 1-239 | 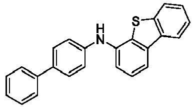 | 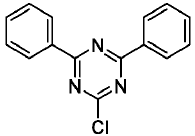 | 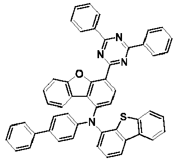 | 84.3% |
| 1-252 | 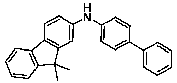 | 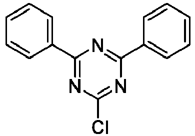 | 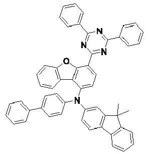 | 84.7% |
| 1-273 | 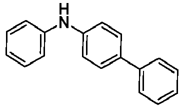 | 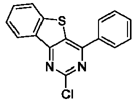 | 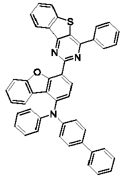 | 80.3% |
| 1-283 | 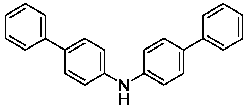 | 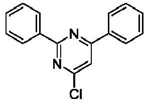 | 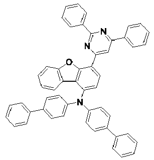 | 81.1% |
| 1-284 | 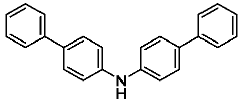 | 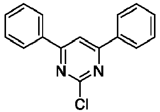 | 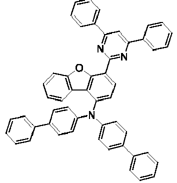 | 81.7% |

### Synthesis Method 9. Synthesis of Compound 1-236

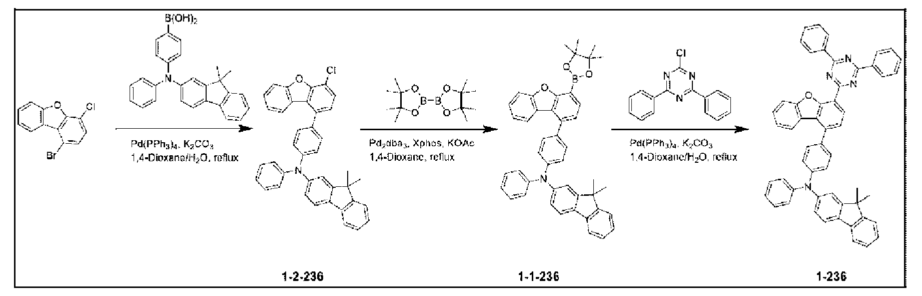

### 9-1) Synthesis of Compound 1-2-236

1-Bromo-4-chlorodibenzo[b,d]furan (10.0 g, 35.5 mM), (4-((9,9-dimethyl-9H-fluoren-2-yl)(phenyl)amino)phenyl)boronic acid (14.4 g, 35.5 mM), Pd(PPh₃)₄ (2.1 g, 1.8 mM) and K₂CO₃ (12.3 g, 88.8 mM) were dissolved in 1,4-dioxane/H₂O (100 mL/20 mL), and refluxed for 1 hour. After the reaction was completed, the result was celite filtered at room temperature, and the solvent was removed from the filtrate using a rotary evaporator. The reaction material was purified by column chromatography (DCM:Hex=1:4), and recrystallized with methanol to obtain Compound 1-2-236 (17.3 g, 86.8%).

### 9-2) Synthesis of Compound 1-1-236

Compound 1-2-236 (17.0 g, 30.2 mM), 4,4,4',4',5,5,5',5'-octamethyl-2,2'-bi(1,3,2-dioxaborolane) (11.5 g, 45.3 mM), Pd₂(dba)₃ (1.4 g, 1.5 mM), Xphos (1.4 g, 3.0 mM) and KOAc (5.9 g, 60.4 mM) were dissolved in 1,4-dioxane (200 mL), and refluxed for 1 hour. After the reaction was completed, the result was celite filtered at room temperature, and the solvent was removed from the filtrate using a rotary evaporator. The reaction material was purified by column chromatography (DCM:Hex=1:3), and recrystallized with methanol to obtain Compound 1-1-236 (18.5 g, 93.7%).

### 9-3) Synthesis of Compound 1-236

Compound 1-1-236 (10.0 g, 15.3 mM), 2-chloro-4,6-diphenyl-1,3,5-triazine (4.5 g, 16.8 mM), Pd(PPh₃)₄ (0.9 g, 0.8 mM) and K₂CO₃ (5.3 g, 38.3 mM) were dissolved in 1,4-dioxane/H₂O (100 mL/20 mL), and refluxed for 1 hour. After the reaction was completed, the result was extracted at room temperature, and the solvent was removed from the filtrate using a rotary evaporator. The reaction material was purified by column chromatography (DCM:Hex=1:1), and recrystallized with methanol to obtain target Compound 1-236 (10.1 g, 86.9%).

Target compounds were prepared in the same manner as in Synthesis Method 9 except that Intermediates Q and R of the following Table 9 were used instead of (4-((9,9-dimethyl-9H-fluoren-2-yl) (phenyl)amino)phenyl)boronic acid and 2-chloro-4,6-diphenyl-1,3,5-triazine.

**[Table 9]**

| Compo und | Intermediate Q | Intermediate R | Target Compound | Yield |
|---|---|---|---|---|
| 1-236 | 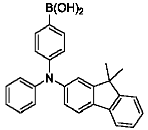 | 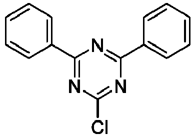 | 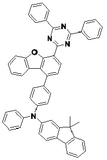 | 86.9% |
| 1-241 | 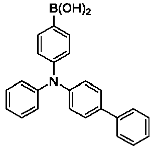 | 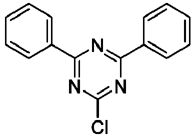 | 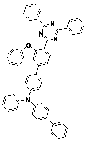 | 85.3% |
| 1-256 | 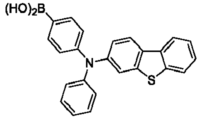 | 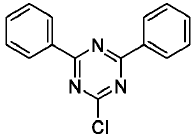 | 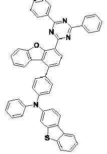 | 85.2% |
| 1-257 | 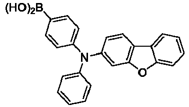 | 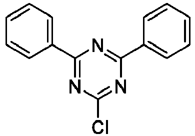 | 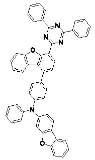 | 84.3% |

### Synthesis Method 10. Synthesis of Compound 1-266

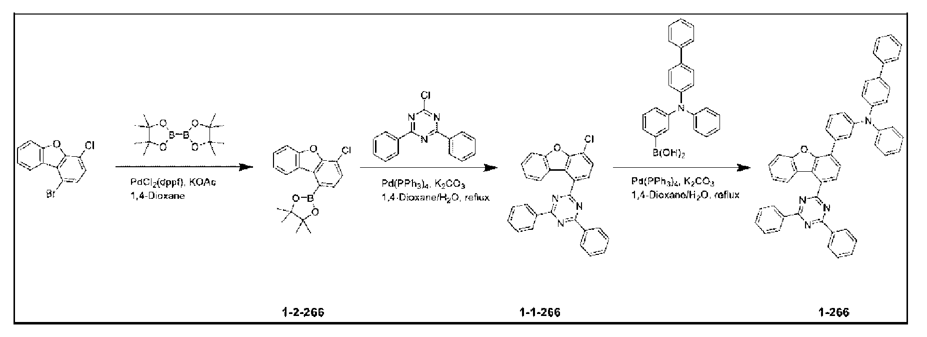

### 10-1) Synthesis of Compound 1-2-266

1-Bromo-4-chlorodibenzo[b,d]furan (20.0 g, 71.0 mM), 4,4,4',4',5,5,5',5'-octamethyl-2,2'-bi(1,3,2-dioxaborolane) (27.0 g, 106.5 mM),PdCl₂(dppf) (2.6 g, 3.6 mM) and KOAc (13.9 g, 142.0 mM) were dissolved in 1,4-dioxane (200 mL), and refluxed for 1 hour. After the reaction was completed, the result was celite filtered at room temperature, and the solvent was removed from the filtrate using a rotary evaporator. The reaction material was purified by column chromatography (DCM:Hex=1:5), and recrystallized with methanol to obtain Compound 1-2-266 (21.5 g, 92.1%).

### 10-2) Synthesis of Compound 1-1-266

Compound 1-2-266 (20.0 g, 60.9 mM), 2-chloro-4,6-diphenyl-1,3,5-triazine (17.9 g, 67.0 mM), Pd(PPh₃)₄ (3.5 g, 3.0 mM) and K₂CO₃ (21.0 g, 152.3 mM) were dissolved in 1,4-dioxane/H₂O (200 mL/40 mL), and refluxed for 1 hour. After the reaction was completed, the result was filtered under vacuum at room temperature. After that, the result was stirred for 30 minutes in distilled water, and then dried to obtain Compound 1-1-266 (24.5 g, 92.8%).

### 10-3) Synthesis of Compound 1-266

Compound 1-1-266 (15.0 g, 34.6 mM), (3-([1,1'-biphenyl]-4-yl(phenyl)amino)phenyl)boronic acid (13.9 g, 38.1 mM), Pd(PPh₃)₄ (2.0 g, 1.7 mM) and K₂CO₃ (12.0 g, 86.5 mM) were dissolved in 1,4-dioxane/H₂O (150 mL/30 mL), and refluxed for 1 hour. After the reaction was completed, the result was extracted at room temperature, and the solvent was removed from the filtrate using a rotary evaporator. The reaction material was purified by column chromatography (DCM:Hex=1:1), and recrystallized with methanol to obtain target Compound 1-266 (22.0 g, 88.4%).

Target compounds were prepared in the same manner as in Synthesis Method 10 except that Intermediates S and T of the following Table 10 were used instead of 2-chloro-4,6-diphenyl-1,3,5-triazine and (3-([1,1'-biphenyl]-4-yl(phenyl)amino)phenyl)boronic acid.

**[Table 10]**

| Compou nd | Intermediate S | Intermediate T | Target Compound | Yield |
|---|---|---|---|---|
| 1-266 | 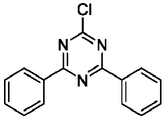 | 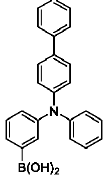 | 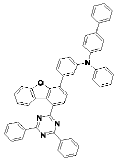 | 88.4% |
| 1-269 | 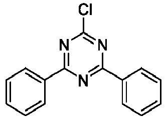 | 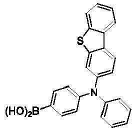 | 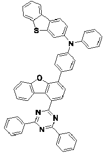 | 86.3% |

### Synthesis Method 11. Synthesis of Compound 1-263

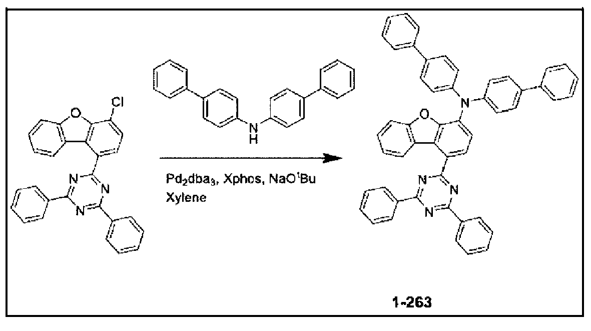

Compound 1-1-266 (15.0 g, 34.6 mM), di([1,1'-biphenyl]-4-yl)amine (12.2 g, 38.1 mM), Pd₂(dba)₃ (1.6 g, 1.7 mM), Xphos (1.7 g, 3.5 mM) and NaO^{t}Bu (6.7 g, 69.2 mM) were dissolved in xylene (150 mL), and refluxed for 1 hour. After the reaction was completed, the result was celite filtered at room temperature, and the solvent was removed from the filtrate using a rotary evaporator. The reaction material was purified by column chromatography (DCM:Hex=1:1), and recrystallized with methanol to obtain target Compound 1-263 (22.1 g, 88.7%).

### Synthesis Method 12. Synthesis of Compound 1-301

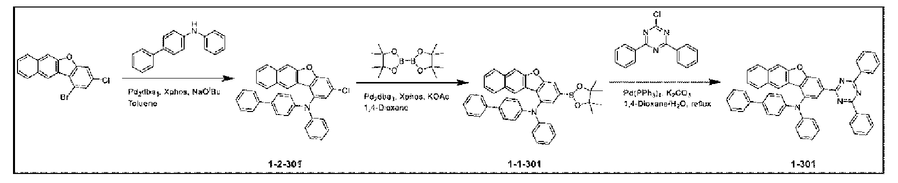

### 12-1) Synthesis of Compound 1-2-301

1-Bromo-3-chloronaphtho[2,3-b]benzofuran (20.0 g, 60.3 mM), N-phenyl-[1,1'-biphenyl]-4-amine (14.8 g, 60.3 mM), Pd₂(dba)₃ (2.7 g, 3.0 mM), Xphos (2.9 g, 6.0 mM) and NaO^{t}Bu (11.6 g, 120.6 mM) were dissolved in toluene (200 mL), and refluxed for 1 hour. After the reaction was completed, the result was celite filtered at room temperature, and the solvent was removed from the filtrate using a rotary evaporator. The reaction material was purified by column chromatography (DCM:Hex=1:5), and recrystallized with methanol to obtain Compound 1-2-301 (27.5 g, 91.9%).

### 12-2) Synthesis of Compound 1-1-301

Compound 1-2-301 (27.0 g, 54.4 mM), 4,4,4',4',5,5,5',5'-octamethyl-2,2'-bi(1,3,2-dioxaborolane) (20.7 g, 81.6 mM), Pd₂(dba)₃ (2.5 g, 2.7 mM), Xphos (2.6 g, 5.4 mM) and KOAc (10.7 g, 108.8 mM) were dissolved in 1,4-dioxane (300 mL), and refluxed for 1 hour. After the reaction was completed, the result was celite filtered at room temperature, and the solvent was removed from the filtrate using a rotary evaporator. The reaction material was purified by column chromatography (DCM:Hex=1:3), and recrystallized with methanol to obtain Compound 1-1-301 (29.8 g, 93.2%).

### 12-3) Synthesis of Compound 1-301

Compound 1-1-301 (15.0 g, 25.5 mM), 2-chloro-4,6-diphenyl-1,3,5-triazine (7.5 g, 28.1 mM), Pd(PPh₃)₄ (1.5 g, 1.3 mM) and K₂CO₃ (8.8 g, 63.8 mM) were dissolved in 1,4-dioxane/H₂O (150 mL/30 mL), and refluxed for 1 hour. After the reaction was completed, the result was extracted at room temperature, and the solvent was removed from the filtrate using a rotary evaporator. The reaction material was purified by column chromatography (DCM:Hex=1:1), and recrystallized with methanol to obtain target Compound 1-301 (15.1 g, 85.5%).

Target compounds were prepared in the same manner as in Synthesis Method 12 except that Intermediates U and V of the following Table 11 were used instead of N-phenyl-[1,1'-biphenyl]-4-amine and 2-chloro-4,6-diphenyl-1,3,5-triazine.

**[Table 11]**

| Compou nd | Intermediate U | Intermediate V | Target Compound | Yield |
|---|---|---|---|---|
| 1-301 | 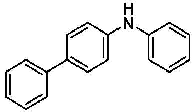 | 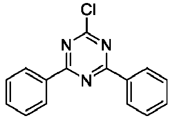 | 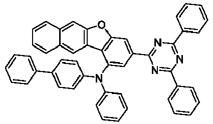 | 85.5% |
| 1-302 | 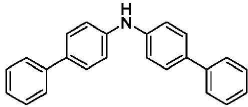 | 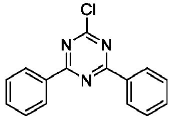 | 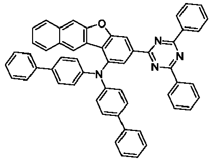 | 84.3% |
| 1-304 | 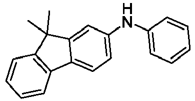 | 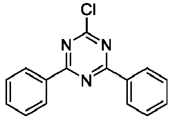 | 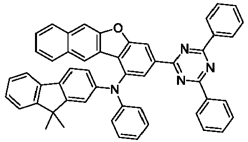 | 84.1% |
| 1-305 | 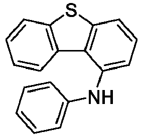 | 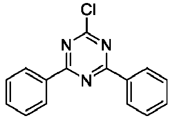 | 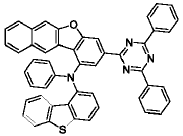 | 83.3% |
| 1-306 | 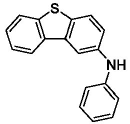 | 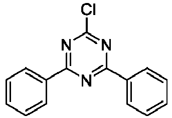 | 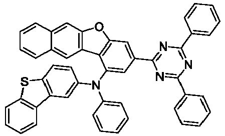 | 83.9% |
| 1-309 | 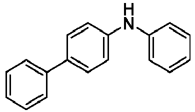 | 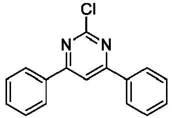 | 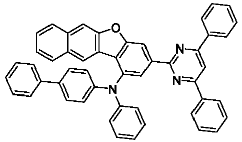 | 82.9% |

### Synthesis Method 13. Synthesis of Compound 1-327

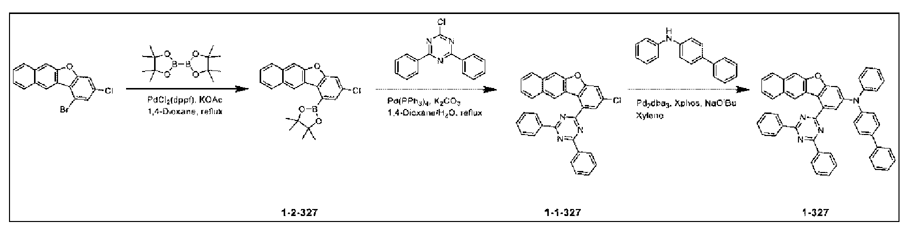

### 13-1) Synthesis of Compound 1-2-327

1-Bromo-3-chloronaphtho[2,3-b]benzofuran (20.0 g, 60.3 mM), 4,4,4',4',5,5,5',5'-octamethyl-2,2'-bi(1,3,2-dioxaborolane) (23.0 g, 90.5 mM), PdCl₂(dppf) (2.2 g, 3.0 mM) and KOAc (14.8 g, 150.8 mM) were dissolved in 1,4-dioxane (200 mL), and refluxed for 1 hour. After the reaction was completed, the result was celite filtered at room temperature, and the solvent was removed from the filtrate using a rotary evaporator. The reaction material was purified by column chromatography (DCM:Hex=1:5), and recrystallized with methanol to obtain Compound 1-2-327 (20.1 g, 88.1%).

### 13-2) Synthesis of Compound 1-1-327

Compound 1-2-327 (10.0 g, 26.4 mM), 2-chloro-4,6-diphenyl-1,3,5-triazine (7.8 g, 29.0 mM), Pd(PPh₃)₄ (1.5 g, 1.3 mM) and K₂CO₃ (9.1 g, 66.0 mM) were dissolved in 1,4-dioxane/H₂O (100 mL/20 mL), and refluxed for 1 hour. After the reaction was completed, the result was filtered under vacuum at room temperature. After that, the result was stirred for 30 minutes in distilled water, and then dried to obtain Compound 1-1-327 (11.5 g, 90.2%).

### 13-3) Synthesis of Compound 1-327

Compound 1-1-327 (11.0 g, 22.7 mM), N-phenyl-[1,1'-biphenyl]-4-amine (6.1 g, 25.0 mM), Pd₂(dba)₃ (1.0 g, 1.1 mM), Xphos (1.1 g, 2.3 mM) and NaO^{t}Bu (5.5 g, 56.8 mM) were dissolved in xylene (150 mL), and refluxed for 1 hour. After the reaction was completed, the result was celite filtered at room temperature, and the solvent was removed from the filtrate using a rotary evaporator. The reaction material was purified by column chromatography (DCM:Hex=1:1), and recrystallized with methanol to obtain target Compound 1-327 (14.0 g, 89.0%).

Target compounds were prepared in the same manner as in Synthesis Method 13 except that Intermediates W and X of the following Table 12 were used instead of 2-chloro-4,6-diphenyl-1,3,5-triazine and N-phenyl-[1,1'-biphenyl]-4-amine.

**[Table 12]**

| Compou nd | Intermediate W | Intermediate X | Target Compound | Yield |
|---|---|---|---|---|
| 1-327 | 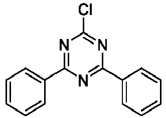 | 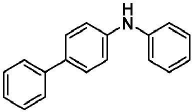 | 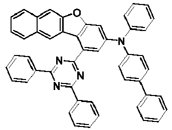 | 89.0% |
| 1-329 | 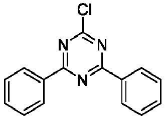 | 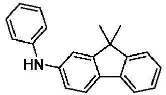 | 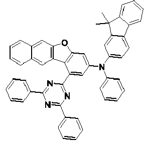 | 88.7% |

### Synthesis Method 14. Synthesis of Compound 1-345

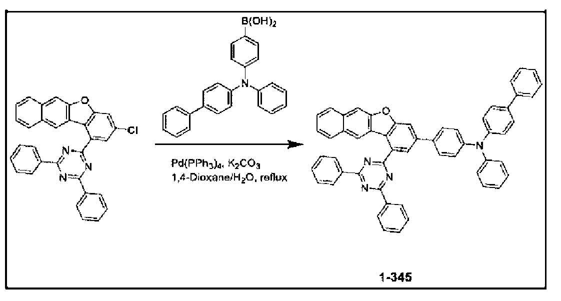

Compound 1-1-327 (11.0 g, 22.7 mM), (4-([1,1'-biphenyl]-4-yl(phenyl)amino)phenyl)boronic acid (9.1 g, 25.0 mM), Pd(PPh₃)₄ (1.3 g, 1.1 mM) and K₂CO₃ (7.9 g, 56.8 mM) were dissolved in 1,4-dioxane/H₂O (150 mL/30 mL), and refluxed for 1 hour. After the reaction was completed, the result was extracted at room temperature, and the solvent was removed from the filtrate using a rotary evaporator. The reaction material was purified by column chromatography (DCM:Hex=1:1), and recrystallized with methanol to obtain target Compound 1-345 (15.1 g, 86.3%).

### Synthesis Method 15. Synthesis of Compound 1-422

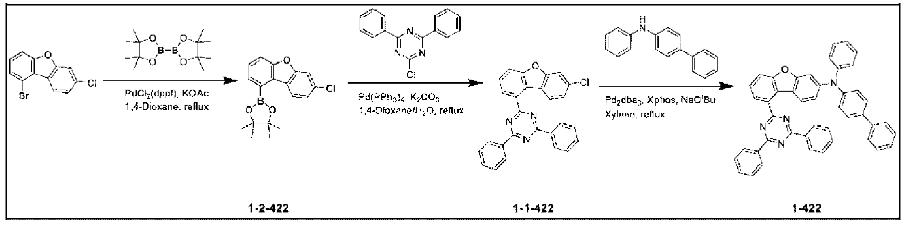

### 15-1) Synthesis of Compound 1-2-422

1-Bromo-7-chlorodibenzo[b,d]furan (20.0 g, 71.0 mM), 4,4,4',4',5,5,5',5'-octamethyl-2,2'-bi(1,3,2-dioxaborolane) (27.0 g, 106.5 mM), PdCl₂(dppf) (2.6 g, 3.6 mM) and KOAc (17.4 g, 177.5 mM) were dissolved in 1,4-dioxane (200 mL), and refluxed for 1 hour. After the reaction was completed, the result was celite filtered at room temperature, and the solvent was removed from the filtrate using a rotary evaporator. The reaction material was purified by column chromatography (DCM:Hex=1:5), and recrystallized with methanol to obtain Compound 1-2-422 (22.1 g, 94.5%).

### 15-2) Synthesis of Compound 1-1-422

Compound 1-2-422 (22.0 g, 67.0 mM), 2-chloro-4,6-diphenyl-1,3,5-triazine (19.7 g, 73.7 mM), Pd(PPh₃)₄ (3.9 g, 3.4 mM) and K₂CO₃ (23.2 g, 167.5 mM) were dissolved in 1,4-dioxane/H₂O (200 mL/40 mL), and refluxed for 1 hour. After the reaction was completed, the result was filtered under vacuum at room temperature. After that, the result was stirred for 30 minutes in distilled water, and then dried to obtain Compound 1-1-422 (26.3 g, 90.4%).

### 15-3) Synthesis of Compound 1-422

Compound 1-1-422 (20.0 g, 46.1 mM), N-phenyl-[1,1'-biphenyl]-4-amine (12.4 g, 50.7 mM), Pd₂(dba)₃ (2.1 g, 2.3 mM), Xphos (2.2 g, 4.6 mM) and NaO^{t}Bu (11.1 g, 115.3 mM) were dissolved in xylene (150 mL), and refluxed for 1 hour. After the reaction was completed, the result was celite filtered at room temperature, and the solvent was removed from the filtrate using a rotary evaporator. The reaction material was purified by column chromatography (DCM:Hex=1:1), and recrystallized with methanol to obtain target Compound 1-422 (27.1 g, 91.5%).

Target compounds were prepared in the same manner as in Synthesis Method 15 except that Intermediates Y and Z of the following Table 13 were used instead of 2-chloro-4,6-diphenyl-1,3,5-triazine and N-phenyl-[1,1'-biphenyl]-4-amine.

**[Table 13]**

| Compou nd | Intermediate Y | Intermediate Z | Target Compound | Yield |
|---|---|---|---|---|
| 1-422 | 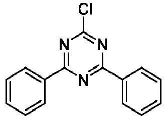 | 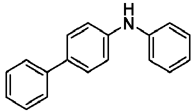 | 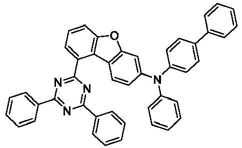 | 91.5% |
| 1-423 | 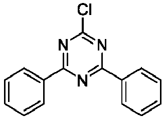 | 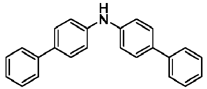 | 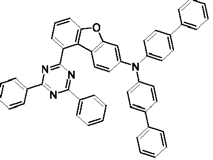 | 90.3% |
| 1-424 | 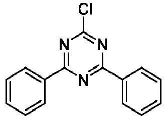 | 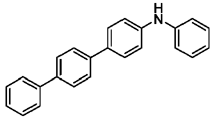 | 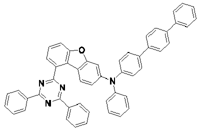 | 90.1% |
| 1-426 | 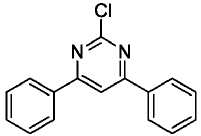 | 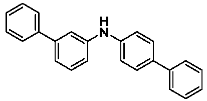 | 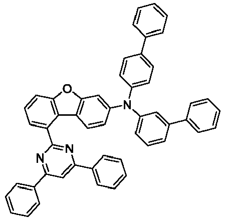 | 85.3% |
| 1-427 | 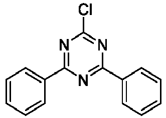 | 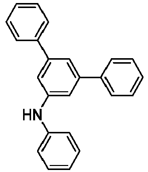 | 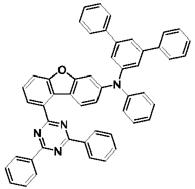 | 91.7% |
| 1-436 | 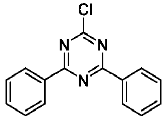 | 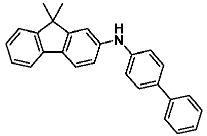 | 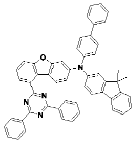 | 90.8% |
| 1-442 | 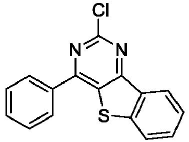 | 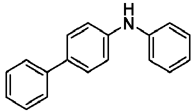 | 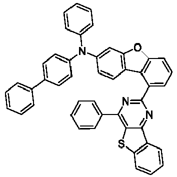 | 83.7% |
| 1-472 | 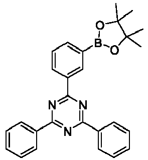 | 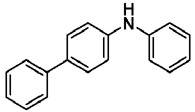 | 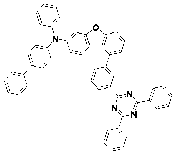 | 85.5% |
| 1-483 | 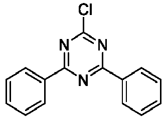 | 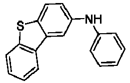 | 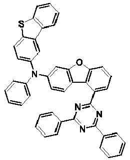 | 91.3% |
| 1-484 | 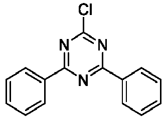 | 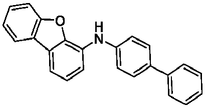 | 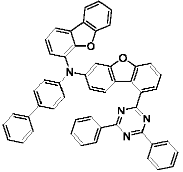 | 90.7% |
| 1-486 | 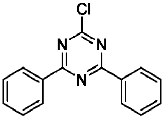 | 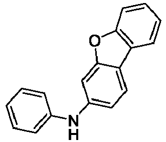 | 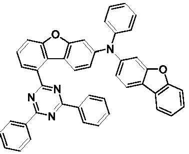 | 90.1% |

### Synthesis Method 16. Synthesis of Compound 1-430

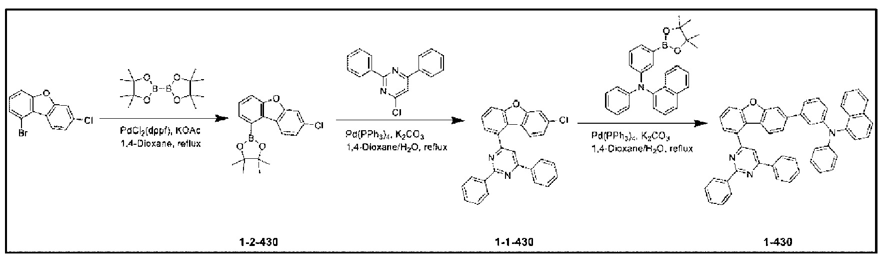

### 16-1) Synthesis of Compound 1-2-430

1-Bromo-7-chlorodibenzo[b,d]furan (20.0 g, 71.0 mM), 4,4,4',4',5,5,5',5'-octamethyl-2,2'-bi(1,3,2-dioxaborolane) (27.0 g, 106.5 mM), PdCl₂(dppf) (2.6 g, 3.6 mM) and KOAc (17.4 g, 177.5 mM) were dissolved in 1,4-dioxane (200 mL), and refluxed for 1 hour. After the reaction was completed, the result was celite filtered at room temperature, and the solvent was removed from the filtrate using a rotary evaporator. The reaction material was purified by column chromatography (DCM:Hex=1:5), and recrystallized with methanol to obtain Compound 1-2-430 (22.1 g, 94.5%).

### 16-2) Synthesis of Compound 1-1-430

Compound 1-2-430 (22.0 g, 67.0 mM), 4-chloro-2,6-diphenylpyrimidine (19.7 g, 73.7 mM), Pd(PPh₃)₄ (3.9 g, 3.4 mM) and K₂CO₃ (23.2 g, 167.5 mM) were dissolved in 1,4-dioxane/H₂O (200 mL/40 mL), and refluxed for 1 hour. After the reaction was completed, the result was filtered under vacuum at room temperature. After that, the result was stirred for 30 minutes in distilled water, and then dried to obtain Compound 1-1-430 (25.1 g, 86.6%).

### 16-3) Synthesis of Compound 1-430

Compound 1-1-430 (15.0 g, 34.6 mM), N-phenyl-N-(3-(4,4,5,5-tetramethyl-1,3,2-dioxaborolan-2-yl)phenyl)naphthalen-1-amine (16.1 g, 38.1 mM), Pd(PPh₃)₄ (2.0 g, 1.7 mM) and K₂CO₃ (12.0 g, 86.5 mM) were dissolved in 1,4-dioxane/H₂O (150 mL/30 mL), and refluxed for 1 hour. After the reaction was completed, the result was extracted at room temperature, and the solvent was removed from the filtrate using a rotary evaporator. The reaction material was purified by column chromatography (DCM:Hex=1:1), and recrystallized with methanol to obtain target Compound 1-430 (21.0 g, 87.6%).

Target compounds were prepared in the same manner as in Synthesis Methods 15 and 16 except that Intermediate A1 of the following Table 14 was used instead of 2-chloro-4,6-diphenyl-1,3,5-triazine in Synthesis Method 15, and Intermediate B1 of the following Table 14 was used instead of N-phenyl-N-(3-(4,4,5,5-tetramethyl-1,3,2-dioxaborolan-2-yl)phenyl)naphthalen-1-amine in Synthesis Method 16.

**[Table 14]**

| Compou nd | Intermediate A1 | Intermediate B1 | Target Compound | Yield |
|---|---|---|---|---|
| 1-430 | 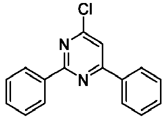 | 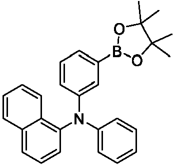 | 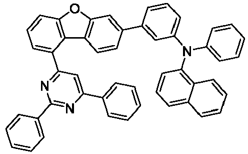 | 87.6% |
| 1-477 | 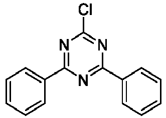 | 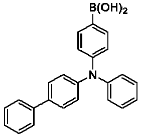 | 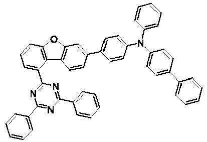 | 86.3% |
| 1-478 | 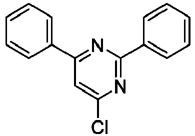 | 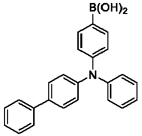 | 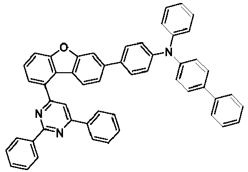 | 86.1% |
| 1-481 | 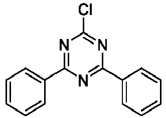 | 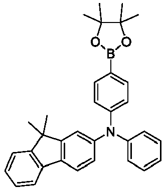 | 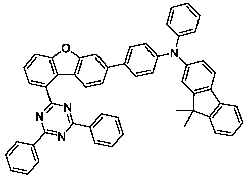 | 86.7% |

### Synthesis Method 17. Synthesis of Compound 2-5

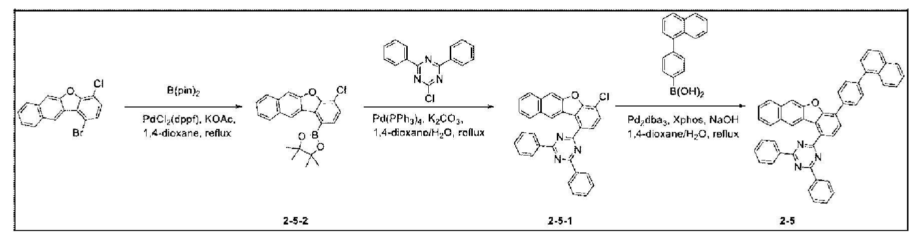

### 17-1) Preparation of Compound 2-5-2

1-Bromo-4-chloronaphtho[2,3-b]benzofuran (30.0 g, 90.5 mM), 4,4,4',4',5,5,5',5'-octamethyl-2,2'-bi(1,3,2-dioxaborolane) (34.5 g, 135.8 mM), PdCl₂(dppf) (3.3 g, 4.5 mM) and KOAc (26.6 g, 271.5 mM) were dissolved in 1,4-dioxane (300 mL), and refluxed for 24 hours. After the reaction was completed, the result was filtered under vacuum at room temperature, and the solvent was removed from the filtrate using a rotary evaporator. The reaction material was purified by column chromatography (DCM:Hex=1:4) to obtain Compound 2-5-2 (31.2 g, 91.0%).

### 17-2) Preparation of Compound 2-5-1

Compound 2-5-2 (30 g, 79.2 mM), 2-chloro-4,6-diphenyl-1,3,5-triazine (23.3 g, 87.1 mM), Pd(PPh₃)₄ (4.6 g, 4.0 mM) and K₂CO₃ (32.8 g, 237.6 mM) were dissolved in 1,4-dioxane/H₂O (300 mL/60 mL), and refluxed for 1 hour. After the reaction was completed, the result was filtered under vacuum at room temperature, and purified by DCB silica. The result was purified by recrystallization with methanol (MeOH) to obtain Compound 2-5-1 (35.3 g, 92.0%).

### 17-3) Preparation of Compound 2-5

Compound 2-5-1 (10.0 g, 20.7 mM), (4-(naphthalen-1-yl)phenyl)boronic acid (6.2 g, 24.8 mM), Pd₂(dba)₃ (0.9 g, 1.0 mM), Xphos (1.0 g, 2.1 mM) and NaOH (2.5 g, 62.1 mM) were dissolved in 1,4-dioxane/H₂O (100 mL/20 mL), and refluxed for 2 hours. After the reaction was completed, the result was filtered under vacuum at room temperature, and purified by DCB silica. The result was purified by recrystallization with methanol to obtain target Compound 2-5 (12.5 g, 92.8%).

Target compounds were prepared in the same manner as in Synthesis Method 17 except that Intermediates C1 and D1 of the following Table 15 were used instead of 2-chloro-4,6-diphenyl-1,3,5-triazine and (4-(naphthalen-1-yl)phenyl)boronic acid.

**[Table 15]**

| Compo und | Intermediate C1 | Intermediate D1 | Target Compound | Yield |
|---|---|---|---|---|
| 2-5 | 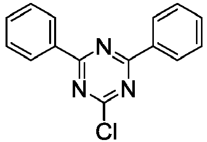 | 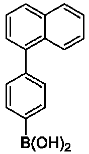 | 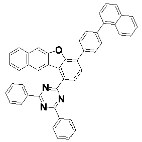 | 92.8% |
| 2-6 | 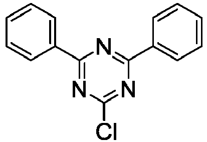 | 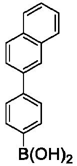 | 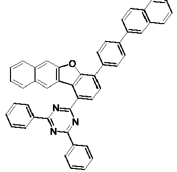 | 91.8% |
| 2-20 | 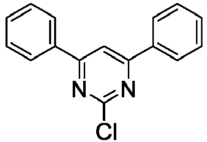 | 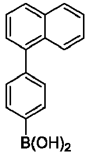 | 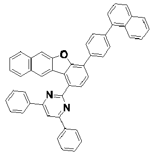 | 90.1% |
| 2-26 | 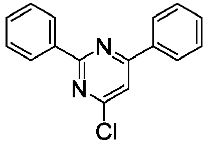 | 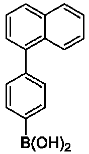 | 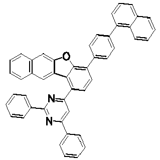 | 85.9% |

### Synthesis Method 18. Synthesis of Compound 2-67

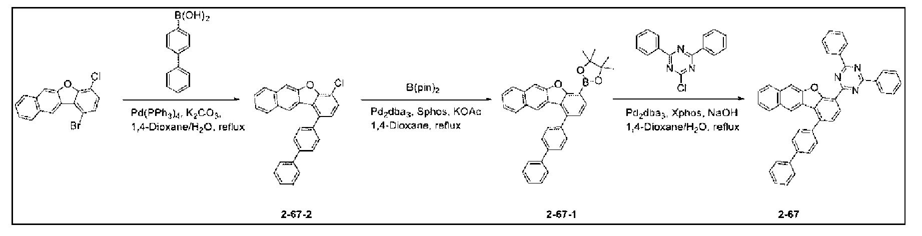

### 18-1) Preparation of Compound 2-67-2

1-Bromo-4-chloronaphtho[2,3-b]benzofuran (30.0 g, 90.5 mM), [1,1'-biphenyl]-4-ylboronic acid (17.9 g, 90.5 mM), Pd(PPh₃)₄ (5.2 g, 4.5 mM) and K₂CO₃ (31.3 g, 226.3 mM) were dissolved in 1,4-dioxane/H₂O (300 mL/60 mL), and refluxed for 2 hours. After the reaction was completed, the result was extracted with DCM at room temperature, and the solvent was removed using a rotary evaporator. The reaction material was purified by column chromatography (DCM:Hex=1:5) to obtain Compound 2-67-2 (29.7 g, 81.1%).

### 18-2) Preparation of Compound 2-67-1

Compound 2-67-2 (29.0 g, 71.6 mM), 4,4,4',4',5,5,5',5'-octamethyl-2,2'-bi(1,3,2-dioxaborolane) (27.3 g, 107.4 mM), Pd₂(dba)₃ (3.3 g, 3.6 mM), Sphos (2-dicyclohexylphosphino-2',6'-dimethoxybiphenyl) (3.0 g, 7.2 mM) and KOAc (21.1 g, 214.8 mM) were dissolved in 1,4-dioxane (300 mL), and refluxed for 1 hour. After the reaction was completed, the result was filtered under vacuum at room temperature, and the solvent was removed from the filtrate using a rotary evaporator. The reaction material was purified by column chromatography (DCM:Hex=1:2) to obtain Compound 2-67-1 (32.7 g, 92.0%).

### 18-3) Preparation of Compound 2-67

Compound 2-67-1 (10.0 g, 20.1 mM), 2-chloro-4,6-diphenyl-1,3,5-triazine (5.9 g, 22.1 mM), Pd₂(dba)₃ (0.9 g, 1.0 mM), Xphos (1.0 g, 2.0 mM) and NaOH (2.4 g, 60.3 mM) were dissolved in 1,4-dioxane/H₂O (100 mL/20 mL), and refluxed for 1 hour. After the reaction was completed, the result was extracted at room temperature, and the solvent was removed from the filtrate using a rotary evaporator. The reaction material was purified by column chromatography (DCM:Hex=1:2), and recrystallized with MeOH to obtain target Compound 2-67 (10.3 g, 85.1%).

Target compounds were prepared in the same manner as in Synthesis Method 18 except that Intermediates E1 and F1 of the following Table 16 were used instead of [1,1'-biphenyl]-4-ylboronic acid and 2-chloro-4,6-diphenyl-1,3,5-triazine.

**[Table 16]**

| Compou nd | Intermediate E1 | Intermediate F1 | Target Compound | Yield |
|---|---|---|---|---|
| 2-67 | 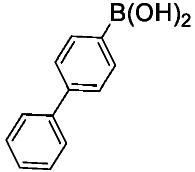 | 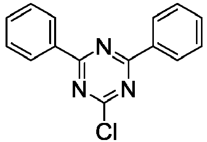 | 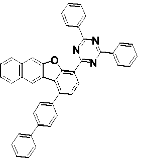 | 85.1% |
| 2-74 | 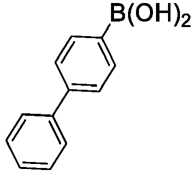 | 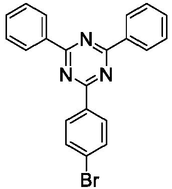 | 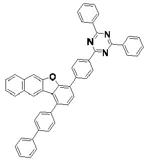 | 80.3% |

### Synthesis Method 19. Synthesis of Compound 3-57

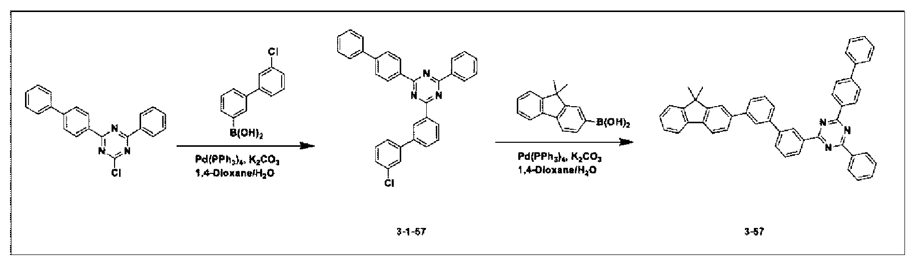

### 19-1) Preparation of Compound 3-1-57

2-([1,1'-Biphenyl]-4-yl)-4-chloro-6-phenyl-1,3,5-triazine (20.0 g, 58.2 mM), (3'-chloro-[1,1'-biphenyl]-3-yl)boronic acid (14.9 g, 64.0 mM), Pd(PPh₃)₄ (3.4 g, 2.9 mM) and K₂CO₃ (20.1 g, 145.5 mM) were dissolved in 1,4-dioxane/H₂O (200 ml/40 ml), and refluxed for 1 hour. After the reaction was completed, the result was filtered under vacuum at room temperature to obtain Compound 3-1-57 (25.7 g, 89.0%).

### 19-2) Preparation of Compound 3-57

Compound 3-1-57 (15.0 g, 30.2 mM), (9,9-dimethyl-9H-fluoren-2-yl)boronic acid (7.9 g, 33.2 mM), Pd(PPh₃)₄ (1.7 g, 1.5 mM) and K₂CO₃ (12.5 g, 90.6 mM) were dissolved in 1,4-dioxane/H₂O (200 ml/40 ml), and refluxed for 1 hour. The reaction material was purified by column chromatography (DCM:Hex=1:1), and recrystallized with methanol to obtain Compound 3-57 (15.9 g, 80.5%).

Target compounds were prepared in the same manner as in Synthesis Method 19 except that Intermediate G1 of the following Table 17 was used instead of (9,9-dimethyl-9H-fluoren-2-yl)boronic acid.

**[Table 17]**

| Compound | Intermediate G1 | Target Compound | Yield |
|---|---|---|---|
| 3-57 | 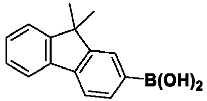 | 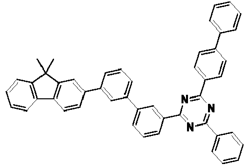 | 80.5% |
| 3-58 | 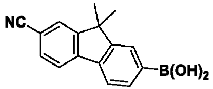 | 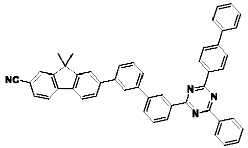 | 75.1% |

### Synthesis Method 20. Synthesis of Compound 4-79

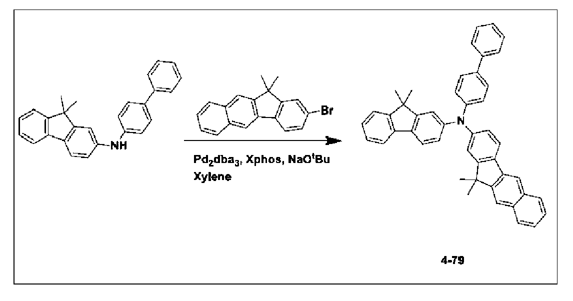

N-([1,1'-biphenyl]-4-yl)-9,9-dimethyl-9H-fluoren-2-amine (15.0 g, 41.5 mM), 2-bromo-11,11-dimethyl-11H-benzo[b]fluorene (14.1 g, 43.6 mM),Pd₂dba₃ (1.9 g, 2.1 mM), Xphos (2.0 g, 4.2 mM) and NaOtBu (8.0 g, 83.0 mM) were dissolved in xylene (150 ml), and refluxed for 1 hour. After the reaction was completed, the result was celite filtered at room temperature, and the filtrate was concentrated. The reaction material was purified by column chromatography (DCM:Hex=1:2), and recrystallized with methanol to obtain Compound 4-79 (10.3 g, 88.2%) .

Target compounds were prepared in the same manner as in Synthesis Method 20 except that Intermediate H1 of the following Table 18 was used instead of N-([1,1'-biphenyl]-4-yl)-9,9-dimethyl-9H-fluoren-2-amine, and Intermediate I1 of the following Table 18 was used instead of 2-bromo-11,11-dimethyl-HH-benzo [b] fluorene.

**Table 18]**

| Compou nd | Intermediate H1 | Intermediate I1 | Target Compound | Yield |
|---|---|---|---|---|
| 4-79 | 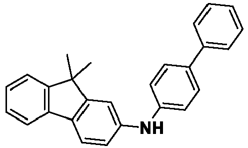 | 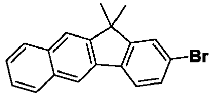 | 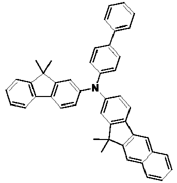 | 88.2% |
| 4-91 | | 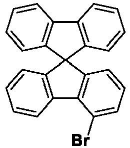 | 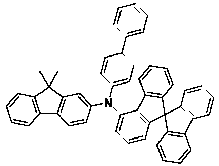 | 87.5% |
| 4-92 | 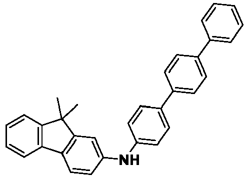 | | 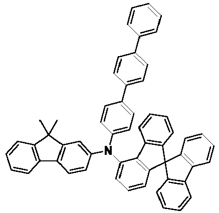 | 87.1% |

Compounds other than the compounds described in Synthesis Methods 1 to 20 were also prepared in the same manner as in the synthesis methods described above, and the synthesis results are shown in the following Tables 19 and 20.

**[Table 19]**

| Compou nd | FD-Mass | Compou nd | FD-Mass |
|---|---|---|---|
| 1-1 | m/z=552.6810(C39H28N4, 552.2314) | 1-2 | m/z=628.7790(C45H32N4, 628.2627) |
| 1-16 | m/z=642. 7620 (C45H30N4O, | 1-28 | m/z=601. 7530 (C44H31N3, |
| | 642.2420) | | 601.2518) |
| 1-29 | m/z=615.7360(C44H29N3, 615.2311) | 1-39 | m/z=657.8350(C46H31N3S, 657.2239) |
| 1-40 | m/z=621.8020(C43H31N3S, 621.2239) | 1-80 | m/z=692.8220(C49H32N4O, 692.2576) |
| 1-82 | m/z=768.9200(C55H36N4O, 768.2889) | 1-84 | m/z=722.8660(C49H30N4S, 722.2140) |
| 1-87 | m/z=767.9320(C56H37N3O, 767.2937) | 1-94 | m/z=589.6980(C42H27N3O, 589.2154) |
| 1-95 | m/z=645.7800(C44H27N3OS , 645.1875) | 1-136 | m/z=692.8220(C49H32N4O, 692.2576) |
| 1-140 | m/z=615.7360(C44H29N3O, 615.2311) | 1-142 | m/z=589.6980(C42H27N3O, 589.2154) |
| 1-176 | m/z=718.8600(C51H34N4O, 718.2733) | 1-177 | m/z=692.8220(C49H32N4O, 692.2576) |
| 1-180 | m/z=794.9580(C57H38N4O, 794.3046) | 1-181 | m/z=732.8430(C51H32N4O2 , 732.2525) |
| 1-182 | m/z=748.9040(C51H32N4OS , 748.2297) | 1-183 | m/z=748.9040(C51H32N4OS , 748.2297) |
| 1-187 | m/z=717.8720(C52H35N3O, 717.2780) | 1-190 | m/z=717.8720(C52H35N3O, 717.2780) |
| 1-193 | m/z=671.8180(C46H29N3OS , 671.2031) | 1-194 | m/z=747.9160(C52H33N3OS , 747.2344) |
| 1-201 | m/z=642.7620(C45H30N4O, 642.2420) | 1-202 | m/z=682.8270(C48H34N4O, 682.2733) |
| 1-205 | m/z=732.8430(C51H32N4O2 , 732.2525) | 1-229 | m/z=718.8600(C51H34N4O, 718.2733) |
| 1-236 | m/z=758.9250(C54H38N4O, 758.3046) | 1-237 | m/z=682.8270(C48H34N4O, 682.2733) |
| 1-238 | m/z=732.8430(C51H32N4O2 , 732.2525) | 1-239 | m/z=748.9040(C51H32N4OS , 748.2297) |
| 1-241 | m/z=718.8600(C51H34N4O, 718.2733) | 1-252 | m/z=758.9250(C54H38N4O, 758.3046) |
| 1-256 | m/z=748.9040(C51H32N4OS , 748.2297) | 1-257 | m/z=732.8430(C51H32N4O2 , 732.2525) |
| 1-263 | m/z=718.8600(C51H34N4O, 718.2733) | 1-266 | m/z=718.8600(C51H34N4O, 718.2733) |
| 1-269 | m/z=748.9040(C51H32N4OS | 1-273 | m/z=671.8180(C46H29N3OS |
| | , 748.2297) | | , 671.2031) |
| 1-283 | m/z=717.8720(C52H35N3O, 717.2780) | 1-284 | m/z=717.8720(C52H35N3O, 717.2780) |
| 1-301 | m/z=692.8220(C49H32N4O, 692.2576) | 1-302 | m/z=768.9200(C55H36N4O, 768.2889) |
| 1-304 | m/z=732.8870(C52H36N4O, 732.2889) | 1-305 | m/z=722.8660(C49H30N4OS , 722.2140) |
| 1-306 | m/z=722.8660(C49H30N4OS , 722.2140) | 1-309 | m/z=691.8340(C50H33N3O, 691.2624) |
| 1-327 | m/z=692.8220(C49H32N4O, 692.2576) | 1-329 | m/z=732.8870(C52H36N4O, 732.2889) |
| 1-345 | m/z=768.9200(C55H36N4O, 768.2889) | 1-422 | m/z=642.7620(C45H30N4O, 642.2420) |
| 1-423 | m/z=718.8600(C51H34N4O, 718.2733) | 1-424 | m/z=718.8600(C51H34N4O, 718.2733) |
| 1-426 | m/z=717.8720(C52H35N3O, 717.2780) | 1-427 | m/z=718.8600(C51H34N4O, 718.2733) |
| 1-430 | m/z=691.8340(C50H33N3O, 691.2624) | 1-436 | m/z=758.9250(C54H38N4O, 758.3046) |
| 1-442 | m/z=671.8180(C46H29N3OS , 671.2031) | 1-472 | m/z=718.8600(C51H34N4O, 718.2733) |
| 1-477 | m/z=718.8600(C51H34N4O, 718.2733) | 1-478 | m/z=717.8720(C52H35N3O, 717.2780) |
| 1-481 | m/z=758.9250(C54H38N4O, 758.3046) | 1-483 | m/z=672.8060(C45H28N4OS , 672.1984) |
| 1-484 | m/z=732.8430(C51H32N4O2 , 732.2525) | 1-486 | m/z=656.7450(C45H28N4O2 , 656.2212) |
| 2-1 | m/z=525.6110(C37H23N3O, 525.1841) | 2-5 | m/z=651.7690(C47H29N3O, 651.2311) |
| 2-6 | m/z=651.7690(C47H29N3O, 651.2311) | 2-8 | m/z=691.7900(C49H29N3O2 , 691.2260) |
| 2-20 | m/z=650.7810(C48H30N2O, 650.2358) | 2-26 | m/z=650.7810(C48H30N2O, 650.2358) |
| 2-67 | m/z=601.7090(C43H27N3O, 601.2154) | 2-74 | m/z=677.8070(C49H31N3O, 677.2467) |
| 2-75 | m/z=651.7690(C47H29N3O, 651.2311) | 2-78 | m/z=524.6230(C38H24N2O, 524.1889) |
| 3-57 | m/z=653. 8290 (C48H35N3, | 3-58 | m/z=678. 8390 (C49H34N4, |
| | 653.2831) | | 678.2783) |
| 4-79 | m/z=603.8090(C46H37N, 603.2926) | 4-91 | m/z=675.8750(C52H37N, 675.2926) |
| 4-92 | m/z=751.9730(C58H41N, 751.3239) | | |

**[Table 20]**

| Compou nd | ¹H NMR (CDCl₃, 400 Mz) |
|---|---|
| 1-1 | δ=8.75∼8.73(d, 4H), 8.63∼8.61(d, 2H), 7.61∼7.54(m, 10H), 7.45∼7.42(t, 2H), 7.37∼7.31(m, 3H), 7.24∼7.20(m, 6H), 7.17∼7.13(t, 1H) |
| 1-2 | δ=8.76∼8.74(d, 4H), 8.67∼8.64(d, 2H), 7.62∼7.54(m, 14H), 7.47∼7.43(t, 4H), 7.36∼7.26(m, 8H) |
| 1-16 | δ=8.81∼8.71(m, 5H), 8.16∼8.14(d, 1H), 7.99∼7.97(d, 1H), 7.74∼7.72(d, 1H), 7.59∼7.46(m, 10H), 7.43∼7.27(m, 12H) |
| 1-28 | δ=8.55∼8.53(d, 2H), 8.13∼8.11(d, 1H), 7.65∼7.46(m, 16H), 7.43-7.27(m, 12H) |
| 1-29 | δ=8.60∼8.55(m, 2H), 8.14∼8.13(d, 1H), 7.71∼7.46(m, 14H), 7.44∼7.27(m, 12H) |
| 1-39 | δ=8.40∼8.35(m, 3H), 8.11-8.09(d, 1H), 7.99∼7.97(d, 2H), 7.75∼7.70(m, 4H), 7.58∼7.49(m, 10H), 7.45∼7.27(m, 11H) |
| 1-40 | δ=8.41∼8.36(m, 3H), 8.13∼8.00(d, 1H), 7.98∼7.96(d, 2H), 7.75∼7.70(m, 4H), 7.59∼7.50(m, 7H), 7.44∼7.27(m, 8H), 1.35(s, 6H) |
| 1-80 | δ=9.25∼9.24(d. 1H), 8.90(s, 1H), 8.78∼8.76(d, 4H), 8.65∼8.63(d, 1H), 7.77∼7.68(m, 5H), 7.60∼7.51(m, 7H), 7.43∼7.30(m, 6H), 7.18∼7.14(t, 2H), 7.07∼6.97(m, 5H) |
| 1-82 | δ=9.26∼9.24(d. 1H), 8.91(s, 1H), 8.79∼8.77(d, 4H), 8.65∼8.63(d, 1H), 7.77∼7.68(m, 5H), 7.60∼7.51(m, 9H), 7.43∼7.30(m, 8H), 7.18∼7.14(t, 2H), 7.07∼6.97(m, 5H) |
| 1-84 | δ=9.25∼9.24(d. 1H), 8.90(s, 1H), 8.78∼8.76(d, 4H), 8.65∼8.63(d, 1H), 7.75∼7.51(m, 10H), 7.42∼7.30(m, 6H), 7.18∼7.14(t, 2H), 7.05∼6.97(m, 5H) |
| 1-87 | δ=8.98∼8.96(d, 1H), 8.62∼8.60 (m, 2H), 8.27∼8.25 (m, 4H), 8.11(s, 1H), 7.76∼7.64(m, 5H), 7.58∼7.49(m, 9H), 7.43∼7.32(m, 8H), 7.18∼7.05(m, 6H), 7.00∼6.96(t, 1H) |
| 1-94 | δ=8.97∼8.96(d, 1H), 8.16∼8.13(m, 2H), 7.71∼7.46(m, 10H), 7.44∼7.27(m, 12H), 7.00∼6.96(t, 2H) |
| 1-95 | δ=8.53∼8.51(m, 2H), 8.30∼8.27(m, 2H), 7.98∼7.68 (m, 10H), 7.52∼7.26 (m, 12H), 7.09∼7.06(t, 1H) |
| 1-136 | δ=9.20∼9.18 (d. 1H), 8.81∼8.76(m, 5H), 8.55∼8.53 (d, 1H), 7.76∼7.68(m, 5H), 7.55∼7.30(m, 13H), 7.18∼7.14(t, 2H), 7.07∼6.97(m, 5H) |
| 1-140 | δ=8.97∼8.96(d, 1H), 8.63∼8.60(m, 2H), 8.28∼8.26(m, 4H), 8.10(s, 1H), 7.76∼7.64(m, 5H), 7.58∼7.35(m, 12H), 7.18∼7.05(m, 3H), 7.00-6.96(t, 1H) |
| 1-142 | δ=8.95∼8.93(d, 1H), 8.13∼8.10(m, 2H), 7.78∼7.49(m, 10H), 7.45∼7.27(m, 12H), 7.00∼6.96(t, 2H) |
| 1-176 | δ=8.84∼8.80(d, 4H), 8.64(s, 1H), 8.58∼8.56(d, 1H), 8.00(s, 1H), 7.75∼7.70(d, 4H), 7.68∼7.41(m, 14H), 7.36∼7.21(m, 8H), 7.12∼7.07(t, 1H), |
| 1-177 | δ=8.84∼8.80(d, 4H), 8.63(s, 1H), 8.57∼8.56(d, 1H), 8.00(s, 1H), 7.70∼7.70(d, 4H), 7.68∼7.41(m, 14H), 7.36∼7.21(m, 7H), 7.12∼7.07(t, 1H), |
| 1-180 | δ=8.83∼8.80(d, 4H), 8.64(s, 1H), 8.58∼8.56(d, 1H), 8.00(s, 1H), 7.75∼7.70(d, 4H), 7.68∼7.41(m, 18H), 7.36∼7.21(m, 8H), 7.12∼7.07(t, 1H), |
| 1-181 | δ=8.82∼8.79(d, 4H), 8.61∼8.55(m, 2H), 8.18∼8.01(m, 3H), 7.73∼7.57(m, 10H), 7.50∼7.37(m, 5H), 7.33∼7.29(t, 2H), 7.25∼7.20(m, 5H), 7.10∼7.06(t, 1H) |
| 1-182 | δ=8.82∼8.80 (d, 4H), 8. 62∼8.55 (m, 2H), 8.19∼8.00 (m, 3H), 7.75-7.57(m, 10H), 7.52∼7.37(m, 5H), 7.33∼7.29(t, 2H), 7.25∼7.20(m, 5H), 7.10∼7.06(t, 1H) |
| 1-183 | δ=8.83∼8.81(d, 4H), 8.63(s, 1H), 8.57∼8.55(d, 1H), 8.01(s, 1H), 7.89∼7.81(m, 2H), 7.74∼7.71(5, 2H), 7.66∼7.57(m, 7H), 7.52∼7.35(m, 3H), 7.31∼7.17(m, 10H), 7.12∼7.09(t, 1H) |
| 1-187 | δ=8.80∼8.78 (d, 4H), 8.67∼8.55 (m, 2H), 8.55∼8.53 (d, 1H), 8.00(s, 1H), 7.75∼7.70(d, 4H), 7.68∼7.41(m, 14H), 7.36∼7.21(m, 8H), 7.12∼7.07(t, 1H), |
| 1-190 | δ=8.82∼8.80(d, 2H), 8.64(s, 1H), 8.55∼8.53(m, 3H), 7.98(s, 1H), 7.74∼7.70(5, 4H), 7.68∼7.41(m, 15H), 7.36∼7.21(m, 8H), 7.05∼7.03(t, 1H), |
| 1-193 | δ=8.53∼8.50(m, 2H), 8.30∼8.27(m, 2H), 7.98∼7.68 (m, 12H), 7.52∼7.26 (m, 12H), 7.10∼7.06(t, 1H) |
| 1-194 | δ=8.54∼8.52(m, 2H), 8.29∼8.27(m, 2H), 7.99∼7.65 (m, |
| | 15H), 7.50∼7.24 (m, 13H), 7.10∼7.06(t, 1H) |
| 1-201 | δ=8.83∼8.79(d, 4H), 8.55(s, 1H), 8.35∼8.33(d, 1H), 7.89∼7.70(m, 5H), 7.65∼7.41(m, 10H), 7.36∼7.21(m, 8H), 7.12∼7.07(t, 1H), |
| 1-202 | δ=8.80(s, 1H), 8.68∼8.66(d, 4H), 8.45(s, 1H), 7.80∼7.75(m, 4H), 7.65∼7.58(m, 3H), 7.49∼7.46(m, 4H), 7.45∼7.29(m, 4H), 7.24∼7.22(m, 4H), 7.15∼7.12(d, 1H), 7.08∼7.00(m, 2H), 1.38(s, 6H) |
| 1-205 | δ=8.83∼8.79(d, 4H), 8.57(s, 1H), 8.33∼8.32(d, 1H), 7.89∼7.70(m, 5H), 7.65∼7.41(m, 10H), 7.38∼7.21(m, 10H), 7.11∼7.07(t, 1H), |
| 1-219 | δ=8.36∼8.35 (d, 4H), 7.98∼7.97 (d, 1H), 7.75∼7.73 (d, 4H), 7.55-7.39 (m, 24H), 7.10∼7.09 (d, 1H) |
| 1-236 | δ=8.36∼8.34 (d, 4H), 7.98∼7.97 (d, 1H), 7.90-7.76 (m, 4H), 7.55-7.50 (m, 10H), 7.39-7.16 (m, 10H), 7.08-7.00(m, 3H), 1.69 (s, 6H) |
| 1-237 | δ=8.36∼8.33 (d, 4H), 7.98∼7.96 (d, 1H), 7.90-7.86 (d, 2H), 7.59-7.50 (m, 9H), 7.39-7.10 (m, 12H), 1.69 (s, 6H) |
| 1-238 | δ=8.36∼8.33 (d, 4H), 7.98∼7.97 (d, 2H), 7.75∼7.73 (d, 2H), 7.55-7.31 (m, 21H), 7.18∼7.14 (t, 1H), 7.10∼7.08 (d, 1H), 6.97∼6.95 (d, 1H) |
| 1-239 | δ=8.45∼8.43 (d, 1H), 8.36∼8.33 (m, 4H), 8.11∼8.09 (d, 1H), 7.98∼7.97 (d, 1H), 7.86∼7.84 (d, 1H), 7.75∼7.73 (d, 2H), 7.56-7.50 (m, 10H), 7.49-7.41 (m, 4H), 7.39-7.27 (m, 7H), 7.10-7.08 (d, 1H) |
| 1-241 | δ=8.36∼8.33 (d, 4H), 7.98∼7.97 (d, 1H), 7.82-7.75 (m, 4H), 7.55-7.50 (m, 11H), 7.49-7.41 (m, 3H), 7.39-7.31 (m, 2H), 7.27-7.24 (m, 6H), 7.08-7.00 (m, 3H) |
| 1-252 | δ=8.36∼8.34 (d, 4H), 7.98∼7.96 (d, 1H), 7.90-7.86 (m, 2H), 7.75∼7.73 (d, 2H), 7.55-7.27 (m, 21H), 7.16∼7.14 (d, 1H), 7.10∼7.08 (d, 1H), 1.69 (s, 6H) |
| 1-256 | δ=8.45∼8.43 (d, 1H), 8.36~8.33 (d, 4H), 7.98∼7.97 (d, 1H), 7.86-7.74 (m, 4H), 7.64 (s, 1H), 7.54-7.24 (m, 17H), 7.24-7.08 (m, 4H) |
| 1-257 | δ=8. 36∼8. 33 (d, 4H), 8.03 (s, 1H), 7.98 (s, 2H), 7.82∼7.80 (d, 1H), 7.76∼7.74 (d, 1H), 7.55-7.50 (m, 11H), 7.39-7.27 (m, 8H), 7.08-7.00 (m, 3H), 6.91∼6.89 |
| | (d, 1H) |
| 1-263 | δ=8.36∼8.34 (d, 4H), 7.98∼7.97 (d, 1H), 7.75∼7.73 (d, 4H), 7.55-7.27 (m, 24H), 7.16~7.14 (d, 1H) |
| 1-266 | δ=8.36∼8.33 (d, 4H), 7.98∼7.97 (d, 1H), 7.82∼7.80 (d, 1H), 7.76∼7.73 (m, 4H), 7.55∼7.53 (d, 4H), 7.50∼7.41 (m, 9H), 7.39∼7.31 (m, 2H), 7.27∼7.24 (m, 6H), 7.08-7.00 (m, 3H) |
| 1-269 | δ=8.45∼8.43 (d, 1H), 8.36∼8.33 (d, 4H), 7.98∼7.97 (d, 1H), 7.86-7.74 (m, 4H), 7.64 (s, 1H), 7.56-7.24 (m, 18H), 7.08-7.00 (m, 3H) |
| 1-273 | δ=7.98∼7.97 (d, 1H), 7.86-7.75 (m, 6H), 7.55-7.27 (m, 18H), 7.10-7.00 (m, 4H) |
| 1-283 | δ=8.35∼8.33 (d, 4H), 8.23 (s, 1H), 7.94∼7.91 (d, 2H), 7.75∼7.73 (d, 2H), 7.55-7.27 (m, 24H), 7.10∼7.08 (d, 2H) |
| 1-284 | δ=8.23 (s, 1H), 7.98~7.97 (d, 1H), 7.94∼7.92 (d, 4H), 7.75∼7.73 (d, 4H), 7.55-7.27 (m, 24H), 7.10∼7.08 (d, 1H) |
| 1-301 | δ=8.77 (s, 1H), 8.70∼8.68(d, 4H), 8.49(s, 1H), 7.95∼7.90(m, 2H), 7.70∼7.49(m, 13H), 7.35∼7.30(m, 9H), 7.18∼7.16(d, 1H), 7.10∼7.07(t, 1H) |
| 1-302 | δ=8.76 (s, 1H), 8.69∼8.68(d, 4H), 8.48(s, 1H), 7.95∼7.93(d, 1H), 7.90(s, 1H), 7.70∼7.49(m, 14H), 7.35∼7.30(m, 12H), 7.18∼7.16(d, 1H), 7.10∼7.07(t, 1H) |
| 1-304 | δ=8.76 (s, 1H), 8.68-8.66(d, 4H), 8.47(s, 1H), 7.91∼7.89 (m, 2H), 7.66∼7.46(m, 13H), 7.35∼7.30(m, 7H), 7.18∼7.16(d, 1H), 7.10∼7.07(t, 1H), 1.42(s, 6H) |
| 1-305 | δ=8.70 (s, 1H), 8.65∼8.63(d, 4H), 8.40(s, 1H), 7.95∼7.93(d, 1H), 7.90(s, 1H), 7.65∼7.49(m, 12H), 7.35∼7.30(m, 8H), 7.18∼7.16(d, 1H), 7.09∼7.07(t, 1H) |
| 1-306 | δ=8.71 (s, 1H), 8.66∼8.63(d, 4H), 8.41(s, 1H), 7.96∼7.95(d, 1H), 7.90(s, 1H), 7.66∼7.50(m, 12H), 7.35∼7.30(m, 8H), 7.17∼7.16(d, 1H), 7.09∼7.07(t, 1H) |
| 1-309 | δ=8.77 (s, 1H), 8.49(s, 1H), 8.27∼8.25(m, 4H), 8.11(s, 1H), 7.93∼7.89 (m, 2H), 7.70∼7.49(m, 13H), 7.35∼7.30(m, 9H), 7.18∼7.16(d, 1H), 7.10∼7.07(t, 1H) |
| 1-327 | δ=8.75 (s, 1H), 8.70∼8.68(d, 4H), 8.48(s, 1H), 7.95∼7.90(m, 2H), 7.70∼7.48(m, 13H), 7.35∼7.30(m, 9H), |
| | 7.18∼7.16(d, 1H), 7.11∼7.08(t, 1H) |
| 1-329 | δ=8.73 (s, 1H), 8.67∼8.65(d, 4H), 8.44(s, 1H), 7.94∼7.90(m, 2H), 7.71∼7.49(m, 11H), 7.35∼7.30(m, 9H), 7.18∼7.16(d, 1H), 7.11∼7.08(t, 1H), 1.48(s, 6H) |
| 1-345 | δ=8.75 (s, 1H), 8.70-8.68(d, 4H), 8.49(s, 1H), 7.95∼7.93(m, 2H), 7.70∼7.50(m, 15H), 7.38∼7.30(m, 11H), 7.18∼7.16(d, 1H), 7.09∼7.07(t, 1H) |
| 1-422 | δ=8.80∼8.79(d, 4H), 8.49-8.39(m, 2H), 7.74∼7.55(m, 13H), 7.48∼7.44(t, 2H), 7.37∼7.32(m, 4H), 7.30∼7.24(m, 3H), 7.12∼7.00(m, 2H) |
| 1-423 | δ=8.81∼8.79(d, 4H), 8.48∼8.40(m, 2H), 7.74∼7.55(m, 17H), 7.48∼7.44(t, 2H), 7.36∼7.32(m, 4H), 7.29∼7.24(m, 3H), 7.12∼7.05(m, 2H) |
| 1-424 | δ=8.81∼8.79(d, 4H), 8.49∼8.39(m, 2H), 7.74∼7.55(m, 17H), 7.48∼7.44(t, 2H), 7.37∼7.32(m, 4H), 7.30∼7.24(m, 3H), 7.12∼7.00(m, 2H) |
| 1-426 | δ=8.81∼8.79(d, 4H), 8.48∼8.40(m, 2H), 7.74∼7.55(m, 17H), 7.48∼7.44(t, 2H), 7.36∼7.32(m, 4H), 7.29∼7.24(m, 3H), 7.12∼7.03(m, 2H) |
| 1-427 | δ=8.79∼8.77(d, 4H), 8.46∼8.39(m, 2H), 7.73∼7.72(d, 1H), 7.60∼7.48(m, 19H), 7.34∼7.31(m, 6H), 7.21∼7.06(m, 2H) |
| 1-430 | δ=8.79∼8.77 (d, 2H), 8.55∼8.53 (d, 2H), 8 .15∼8 .13 (m, 2H), 7.73∼7.72(d, 1H), 7.60∼7.48(m, 18H), 7.34∼7.31(m, 6H), 7.21∼7.06(m, 2H) |
| 1-436 | δ=8.81∼8.79(d, 4H), 8.49∼8.47 (d, 1H), 8.41∼8.39 (d, 1H), 7.74∼7.52(m, 14H), 7.46∼7.27(m, 10H), 7.18∼7.16(d, 1H), 7.07∼7.04(d, 1H), 1.51(s, 6H) |
| 1-442 | δ=8.50∼8.46(m, 2H), 8.28∼8.26(m, 2H), 7.99∼7.68 (m, 12H), 7.52∼7.26 (m, 12H), 7.10∼7.06(t, 1H) |
| 1-472 | δ=9.06(s, 1H), 8.86∼8.84(d, 1H), 8.78∼8.76(d, 4H), 7.90∼7.88(d, 1H), 7.75∼7.49(m, 12H), 7.45∼7.37(m, 5H), 7.32∼7.24(m, 4H), 7.17∼7.15(d, 4H), 7.05∼7.02(d, 1H), 6.92∼6.89(d, 1H) |
| 1-477 | δ=8.80∼8.79(m, 4H), 8.30∼8.27(m, 2H), 7.89∼7.75(m, 3H), 7.72∼7.45(m, 18H), 7.20∼7.15(m, 6H), 7.09∼7.07(t, 1H) |
| 1-478 | δ=8.77∼8.74(m, 2H), 8.37∼8.35(m, 2H), 8.16∼8.06(m, 2H), 7.83∼7.70(m, 3H), 7.63∼7.41(m, 19H), 7.22∼7.19(m, 6H), 7.09∼7.07(t, 1H) |
| 1-481 | δ=8.83∼8.82 (d, 4H), 8.63∼8.61 (d, 1H), 8.43∼8.41 (d, 1H), 7.85∼7.81(m, 3H), 7.67∼7.39(m, 12H), 7.34∼7.20(m, 9H), 7.11∼7.05(m, 2H), 1.44(s, 6H) |
| 1-483 | δ=8.80∼8.79(d, 4H), 8.47∼8.39(m, 2H), 8.00∼7.70(m, 6H), 7.62∼7.54(m, 7H), 7.45∼7.23(m, 7H), 7.11∼7.07(t, 1H), 7.03∼7.00(t, 1H) |
| 1-484 | δ=8.79∼8.77(d, 4H), 8.49∼8.47(d, 1H), 8.44∼8.42(d, 1H), 7.89∼7.75(m, 3H), 7.64∼7.53(m, 8H), 7.41∼7.22(m, 8H), 7.20∼7.17(d, 1H), 7.12∼7.09(t, 1H), 7.02∼6.99(d, 1H) |
| 1-486 | δ=8.80∼8.78(d, 4H), 8.48∼8.39(m, 2H), 7.88∼7.71(m, 3H), 7.63∼7.50(m, 8H), 7.41∼7.22(m, 8H), 7.20∼7.17(d, 1H), 7.12∼7.09(t, 1H), 7.02∼6.99(d, 1H) |
| 2-1 | δ=9.35(s, 1H), 8.90∼8.88(d, 4H), 8.61∼8.60(d, 1H), 8.01∼7.92(m, 4H), 7.77∼7.75(d, 2H), 7.70∼7.67(t, 3H), 7.65∼7.50(m, 7H), 7.40∼7.37(t, 1H) |
| 2-5 | δ=9.36(s, 1H), 8.90∼8.88(d, 4H), 8.62∼8.60(d, 1H), 8.17∼8.08(m, 4H), 8.00∼7.92(m, 4H), 7.77∼7.75(d, 2H), 7.70∼7.67(t, 3H), 7.64∼7.50(m, 9H), 7.40∼7.37(t, 1H) |
| 2-6 | δ=9.35(s, 1H), 8.90∼8.88(d, 4H), 8.61∼8.59(d, 1H), 8.19∼8.15 (m, 3H), 8.06∼7.88 (m, 9H), 7.70∼7.52(m, 10H), 7.40∼7.36(t, 1H) |
| 2-8 | δ=9.36(s, 1H), 8.91∼8.89(d, 4H), 8.60∼8.58(d, 1H), 8.10∼7.95(m, 8H), 7.78∼7.76(d, 2H), 7.70∼7.50(m, 12H), 7.40∼7.37(t, 1H) |
| 2-20 | δ=8.82∼8.79(m, 3H), 8.42∼8.39(d, 2H), 8.16∼8.06(m, 5H), 7.98∼7.84(m, 5H), 7.76∼7.74(d, 2H), 7.67∼7.49(m, 12H), 7.38∼7.25(t, 1H) |
| 2-26 | δ=8.81∼8.79(m, 3H), 8.41∼8.39(d, 2H), 8.15∼8.07 (m, 5H), 7.97∼7.84(m, 5H), 7.75∼7.73(d, 2H), 7.63∼7.49(m, 12H), 7.38∼7.25(t, 1H) |
| 2-67 | δ=8.93∼8.92(d, 4H), 8.89∼8.87(d, 1H), 8.25(s, 1H), 8.13(s, 1H), 8.04∼8.00(m, 4H), 7.95∼7.89(m, 4H), 7.85∼7.82(d, 1H), 7.67∼7.65(m, 6H), 7.60∼7.52(m, 4H), 7.41∼7.39(t, 1H) |
| 2-74 | δ=8.81∼8.80(d, 4H), 8.77∼8.76(d, 2H), 8.20(s, 1H), 8.10(s, 1H), 8.08∼7.97(m, 6H), 7.93∼7.85(m, 4H), 7.80∼7.75(d, 1H), 7.67∼7.65(m, 7H), 7.60∼7.52(m, 4H), 7.41∼7.39(t, 1H) |
| 2-75 | δ=8.81∼8.80(d, 4H), 8.77∼8.76(d, 2H), 8.20∼8.05(m, 4H), 8.00∼7.97 (m, 5H), 7.93∼7.85 (m, 4H), 7.80∼7.75(d, 1H), 7.67∼7.55(m, 8H), 7.29∼7.26(t, 1H) |
| 2-78 | δ=8.82∼8.79(m, 3H), 8.42∼8.39(d, 2H), 8.16∼8.06(m, 3H), 7.98∼7.84(m, 5H), 7.76∼7.74(d, 2H), 7.67∼7.49(m, 8H), 7.38∼7.25(t, 1H) |
| 3-57 | δ=9.05(s, 1H), 8.80∼8.78(m, 4H), 8.03(s, 1H), 7.94∼7.81(m, 5H), 7.78∼7.69(m, 8H), 7.62∼7.55(m, 7H), 7.48∼7.46(d, 1H), 7.38∼7.32(m, 2H), 1.58(s, 6H) |
| 3-58 | δ=9.05(s, 1H), 8.88∼8.81(m 4H), 7.93∼7.79(m, 10H), 7.74∼7.60(m, 10H), 7.53∼7.49(t, 2H), 7.44∼7.41(t, 1H), 1.61(s, 6H) |
| 4-79 | δ=8.35∼8.33(m, 2H), 8.00∼7.95(m, 3H), 7.90∼7.87(m, 3H), 7.76∼7.75(d, 2H), 7.55∼7.46(m, 9H), 7.38∼7.32 (m, 5H), 7.16∼7.15(d, 1H), 1.75(s, 6H), 1.69(s, 6H) |
| 4-91 | δ=7.99∼7.96(m, 5H), 7.75∼7.74(d, 2H), 7.58∼7.55(m, 4H), 7.49∼7.41(m, 3H), 7.38∼7.33(m, 7H), 7.28∼7.24(m, 8H), 7.17∼7.16(m, 2H), 1.69(s, 6H) |
| 4-92 | δ=7.99∼7.96(m, 5H), 7.75∼7.74(d, 2H), 7.55∼7.53(m, 4H), 7.49∼7.41(m, 5H), 7.37∼7.28(m, 17H), 7.16∼7.15(m, 2H), 1.68(s, 6H) |

### <Experimental Example 1>

### 1) Manufacture of Organic Light Emitting Device (Red Single Host & Mixed Host)

A glass substrate on which ITO was coated as a thin film to a thickness of 1,500 Å was cleaned with distilled water ultrasonic waves. After the cleaning with distilled water was finished, the substrate was ultrasonic cleaned with solvents such as acetone, methanol and isopropyl alcohol, then dried, and UVO treatment was conducted for 5 minutes using UV in a UV cleaner. After that, the substrate was transferred to a plasma cleaner (PT), and after conducting plasma treatment under vacuum for ITO work function and residual film removal, the substrate was transferred to a thermal deposition apparatus for organic deposition.

On the transparent ITO electrode (anode), a hole injection layer (2-TNATA (4,4',4"-tris[2-naphthyl(phenyl)amino]triphenylamine)) was formed to a thickness of 100 Å, and a hole transfer layer was formed to a thickness of 1100 Å using a compound described in the following Table 21.

A light emitting layer was thermal vacuum deposited thereon as follows. The light emitting layer was deposited to a thickness of 500 Å using a compound described in the following Table 21 as a host, and when using two types of compounds, these were pre-mixed and then deposited in one source of supply, and (piq)₂(Ir) (acac) was used as a red phosphorescent dopant and doped to the host by 3%. After that, BCP was deposited to a thickness of 60 Å as a hole blocking layer, and, as an electron transfer layer, a compound described in the following Table 21 was deposited thereon to a thickness of 200 Å. Lastly, an electron injection layer was formed on the electron transfer layer by depositing lithium fluoride (LiF) to a thickness of 10 Å, and then a cathode was formed on the electron injection layer by depositing an aluminum (Al) cathode to a thickness of 1,200 Å, and as a result, an organic electroluminescent device was manufactured.

Meanwhile, all the organic compounds required to manufacture the OLED were vacuum sublimation purified under 10⁻⁸ torr to 10⁻⁶ torr for each material to be used in the OLED manufacture.

### 2) Evaluation on Organic Light Emitting Device (Red Single Host & Mixed Host)

For each of the organic electroluminescent devices manufactured as above, electroluminescent (EL) properties were measured using M7000 manufactured by McScience Inc., and with the measurement results, T₉₀ was measured when standard luminance was 6,000 cd/m² through a lifetime measurement system (M6000) manufactured by McScience Inc.. Properties of the organic electroluminescent devices of the present disclosure are as shown in the following Table 22.

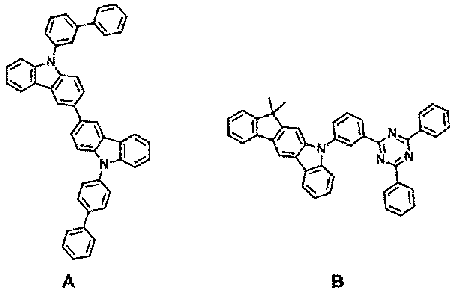

**[Table 21]**

| | Hole Transfer Layer | Electron Transfer Layer | Light Emitting Layer | Content Ratio (Weight Ratio) of Chemical Formula 1:Chemical Formula 2 |
|---|---|---|---|---|
| Comparative Example 1 | NPB | Alq₃ | 1-1 | - |
| Comparative Example 2 | 4-91 | 3-57 | 1-1 | - |
| Comparative Example 3 | NPB | Alq₃ | 1-2 | - |
| Comparative Example 4 | NPB | Alq₃ | 1-176 | - |
| Comparative Example 5 | NPB | Alq₃ | 1-187 | - |
| Comparative Example 6 | 4-91 | 3-57 | 2-5 | - |
| Comparative Example 7 | 4-91 | 3-57 | A:1-187 | 1:1 |
| Comparative Example 8 | 4-91 | 3-57 | B:2-5 | 1:1 |
| Example 1 | 4-91 | 3-58 | 1-84:2-8 | 1:1 |
| Example 2 | 4-92 | 3-58 | 1-176:2-5 | 1:1 |
| Example 3 | 4-92 | 3-58 | 1-187:2-8 | 1:1 |
| Example 4 | 4-79 | 3-57 | 1-266:2-26 | 1:1 |
| Example 5 | 4-79 | 3-58 | 1-269:2-26 | 1:1 |
| Example 6 | 4-92 | 3-58 | 1-301:2-5 | 1:1 |
| Example 7 | 4-92 | 3-58 | 1-305:2-5 | 1:1 |
| Example 8 | 4-79 | 3-57 | 1-484:2-74 | 3:1 |
| Example 9 | 4-79 | 3-57 | 1-484:2-74 | 1:1 |
| Example 10 | 4-79 | 3-57 | 1-484:2-74 | 1:3 |

**[Table 22]**

| | Turn-on (V) | Driving Voltage (V) | Efficienc y (cd/A) | Color Coordinate (x, y) | Lifet ime (T₉₀) |
|---|---|---|---|---|---|
| Comparative Example 1 | 3.41 | 5.91 | 27.10 | (0.686. 0.313) | 40 |
| Comparative Example 2 | 3.05 | 5.47 | 33.55 | (0.686. 0.313) | 39 |
| Comparative Example 3 | 3.39 | 5.93 | 28.00 | (0.686. 0.313) | 43 |
| Comparative Example 4 | 2.75 | 4.17 | 45.98 | (0.687, 0.312) | 250 |
| Comparative Example 5 | 2.99 | 4.40 | 45.53 | (0.686, 0.313) | 109 |
| Comparative Example 6 | 2.45 | 3.90 | 40.21 | (0.686, 0.313) | 40 |
| Comparative Example 7 | 2.69 | 4.25 | 46.12 | (0.686, 0.313) | 61 |
| Comparative Example 8 | 2.50 | 3.99 | 40.10 | (0.686, 0.313) | 35 |
| Example 1 | 2.30 | 3.59 | 52.94 | (0.686. 0.313) | 450 |
| Example 2 | 2.20 | 3.30 | 78.11 | (0.686, 0.313) | 700 |
| Example 3 | 2.20 | 3.60 | 70.35 | (0.686, 0.313) | 750 |
| Example 4 | 2.60 | 3.81 | 55.75 | (0.680, 0.319) | 400 |
| Example 5 | 2.58 | 3.85 | 56.85 | (0.687, 0.312) | 410 |
| Example 6 | 2.25 | 4.00 | 57.81 | (0.686, 0.313) | 455 |
| Example 7 | 2.30 | 4.37 | 57.88 | (0.686, 0.313) | 452 |
| Example 8 | 2.35 | 3.58 | 68.38 | (0.687, 0.312) | 690 |
| Example 9 | 2.30 | 3.55 | 80.11 | (0.686, 0.313) | 850 |
| Example 10 | 2.28 | 3.53 | 67.98 | (0.686, 0.313) | 700 |

The compound of [Chemical Formula 1] of the present disclosure has proper molecular weight and band gap while having high thermal stability. A proper band gap of a light emitting layer prevents a loss of electrons and holes helping with effective formation of a recombination zone. Accordingly, as shown in the device evaluations, the compounds of the present disclosure exhibit improved performance compared to the compounds of the comparative examples.

When using a combination of [Chemical Formula 1] and [Chemical Formula 2] in the light emitting layer, improved driving and lifetime properties are obtained, and when using a combination of the hole transfer layer [Chemical Formula 4], the electron transfer layer [Chemical Formula 3] and the light emitting layer [combination of Chemical Formula 1 and Chemical Formula 2], improved lifetime properties are obtained. When using a donor (p-host) having a favorable hole transfer ability and an acceptor (n-host) having a favorable electron transfer ability each as the hole transfer layer, the electron transfer layer and a host of the light emitting layer, a driving voltage at which electrons and holes are injected may be lowered, and through effective formation of a recombination zone, efficiency and lifetime are enhanced.

## Claims

1. An organic light emitting device comprising:
a first electrode;
a second electrode; and
an organic material layer provided between the first electrode and the second electrode,
wherein the organic material layer includes a compound of the following Chemical Formula 1 and a compound of the following Chemical Formula 2: 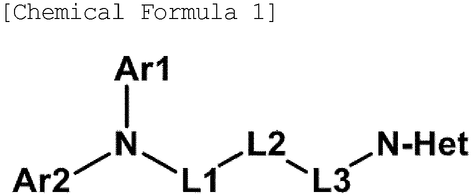 in Chemical Formula 1,
L1 to L3 are the same as or different from each other, and each independently a direct bond; a C6 to C60 arylene group; a monocyclic heteroarylene group including N; or a tricyclic or higher heteroarylene group including O,
Ar1 and Ar2 are the same as or different from each other, and each independently a substituted or unsubstituted C1 to C60 alkyl group; a substituted or unsubstituted C3 to C60 cycloalkyl group; a substituted or unsubstituted C6 to C60 aryl group; or a substituted or unsubstituted C2 to C60 heteroaryl group, and
N-Het is a C2 to C60 heteroaryl group substituted or unsubstituted and including N, 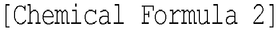 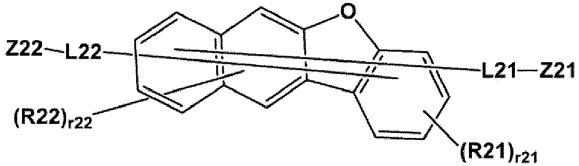 in Chemical Formula 2,
L21 and L22 are the same as or different from each other, and each independently a direct bond; a C6 to C60 arylene group; or a C2 to C60 heteroarylene group,
Z21 and Z22 are the same as or different from each other, and each independently a substituted or unsubstituted C6 to C60 aryl group; or a substituted or unsubstituted C2 to C60 heteroaryl group,
at least one of Z21 and Z22 is a C2 to C60 heteroaryl group substituted or unsubstituted and including N,
R21 and R22 are the same as or different from each other, and each independently hydrogen; deuterium; a halogen group; a cyano group; a substituted or unsubstituted C1 to C60 alkyl group; a substituted or unsubstituted C6 to C60 aryl group; or a substituted or unsubstituted C2 to C60 heteroaryl group,
r21 is an integer of 0 to 4,
r22 is an integer of 0 to 6, and
when r21 and r22 are each 2 or greater, substituents in the parentheses are the same as or different from each other.

2. The organic light emitting device of Claim 1, wherein N-Het is represented by any one of the following Chemical Formulae 1-1 to 1-4: 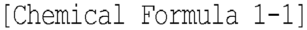 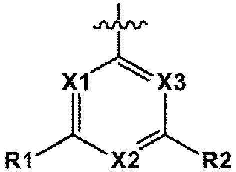 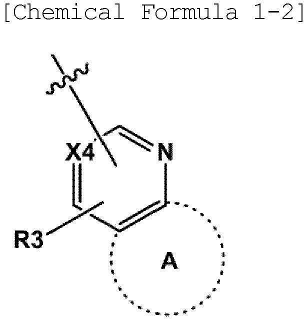 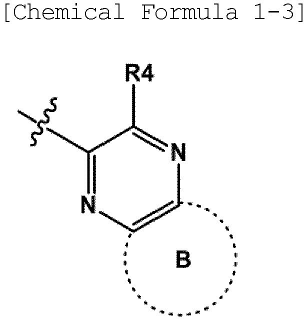 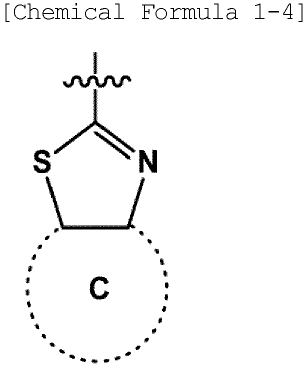 in Chemical Formulae 1-1 to 1-4,
X1 to X4 are each N or CR,
at least one of X1 to X3 is N,
A to C are the same as or different from each other, and each independently a substituted or unsubstituted monocyclic or polycyclic C6 to C60 aryl ring; or a substituted or unsubstituted monocyclic or polycyclic C2 to C60 heteroring, and
R and R1 to R4 are the same as or different from each other, and each independently hydrogen; deuterium; a halogen group; a cyano group; a substituted or unsubstituted C1 to C60 alkyl group; a substituted or unsubstituted C6 to C60 aryl group; or a substituted or unsubstituted C2 to C60 heteroaryl group.

3. The organic light emitting device of Claim 1, wherein Chemical Formula 2 is represented by the following Chemical Formula 2-1: 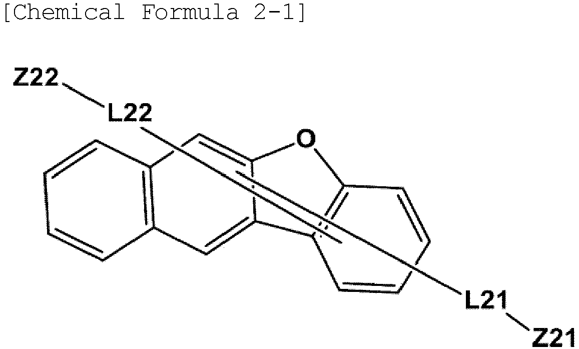 in Chemical Formula 2-1,
each substituent has the same definition as in Chemical Formula 2.

4. The organic light emitting device of Claim 1, wherein the organic material layer includes a light emitting layer, and the light emitting layer includes the compound of Chemical Formula 1 and the compound of Chemical Formula 2.

5. The organic light emitting device of Claim 1, wherein Chemical Formula 1 is represented by any one of the following compounds:

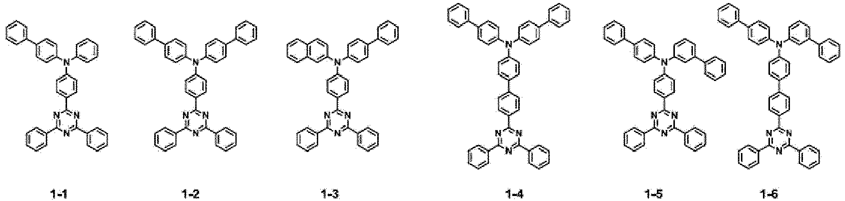

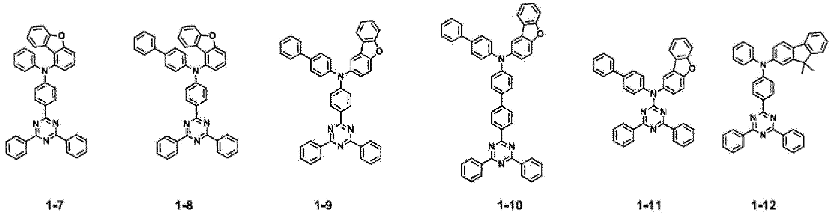

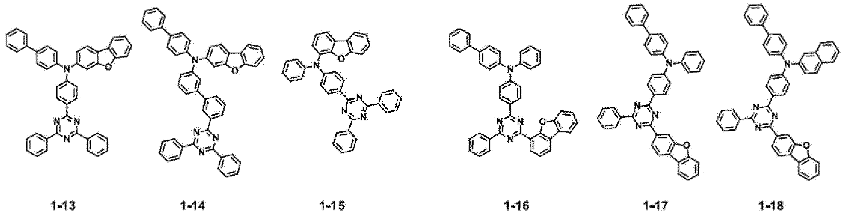

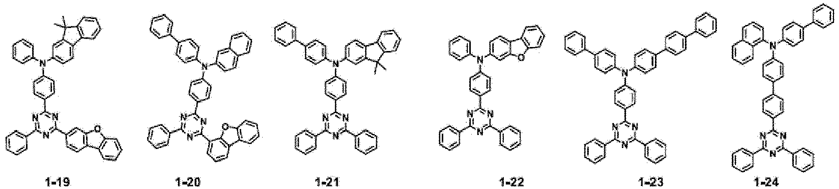

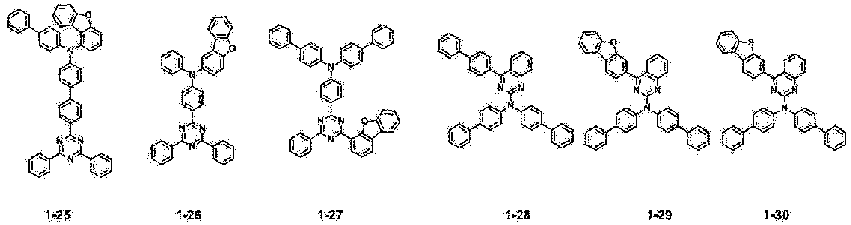

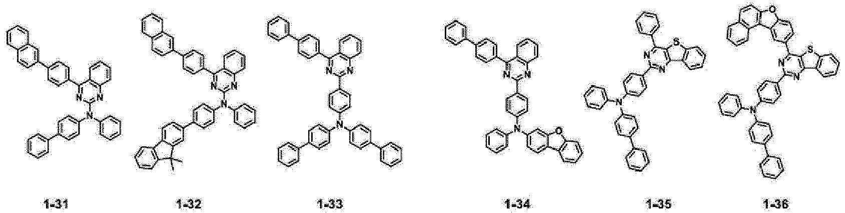

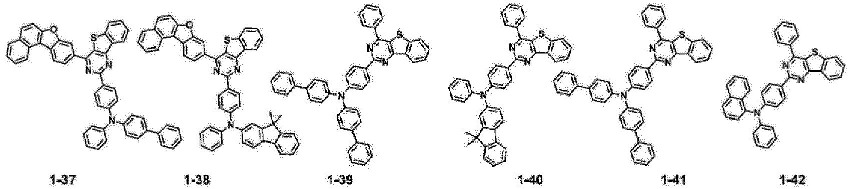

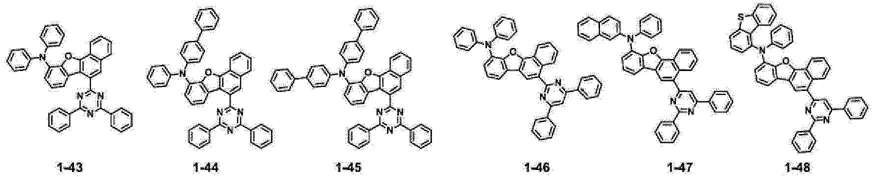

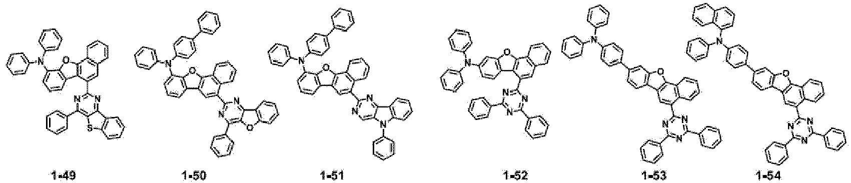

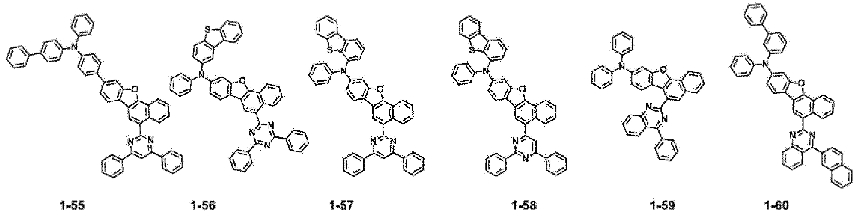

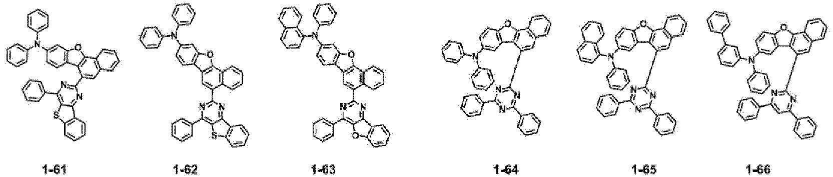

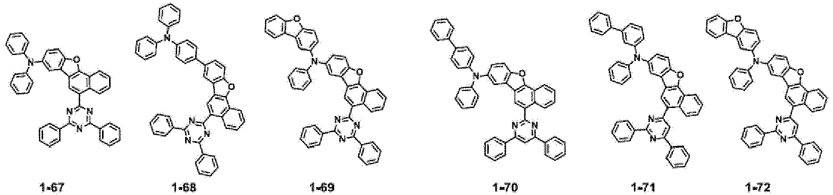

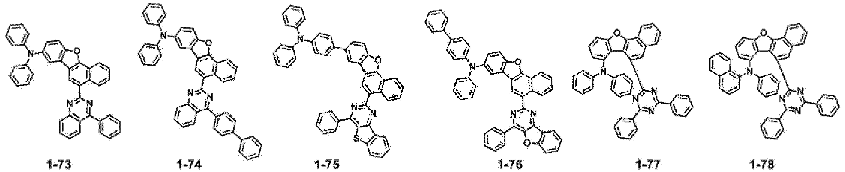

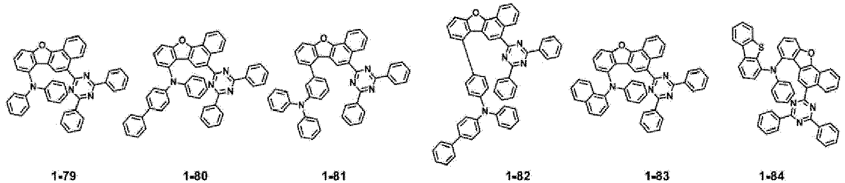

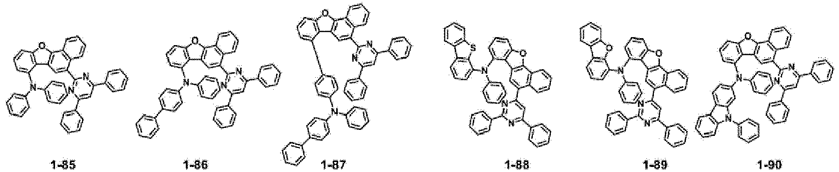

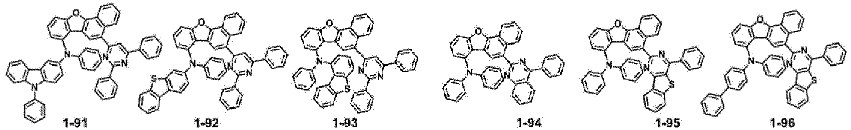

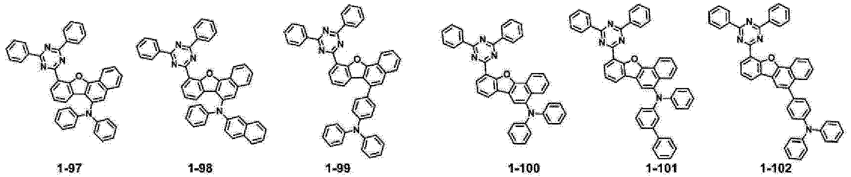

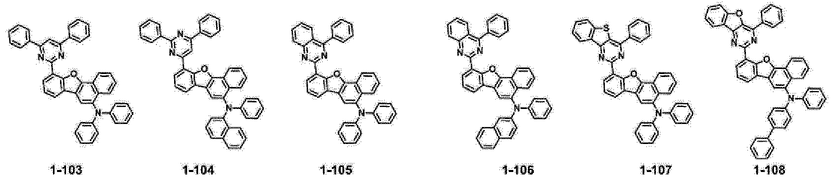

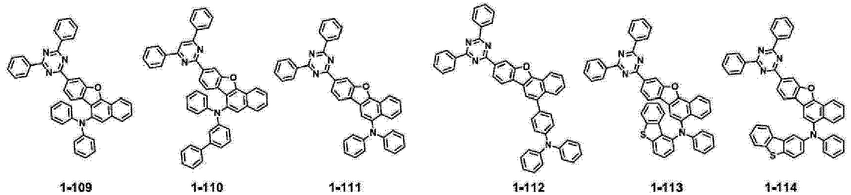

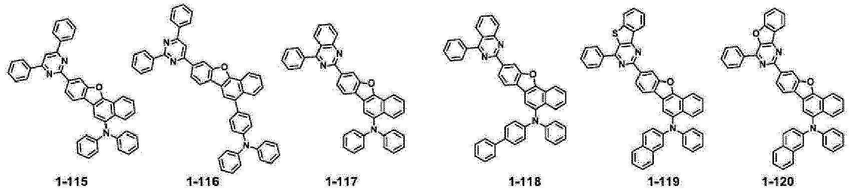

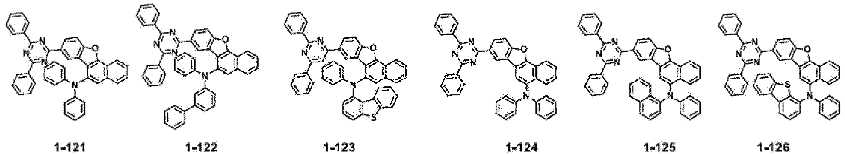

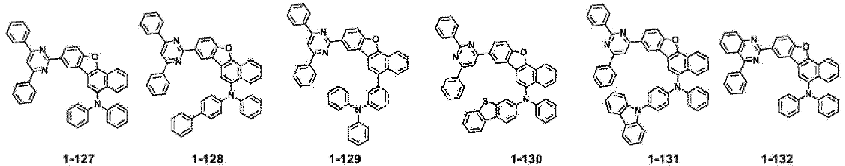

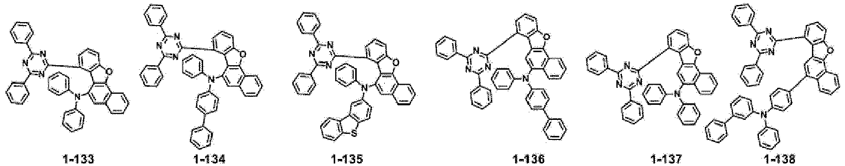

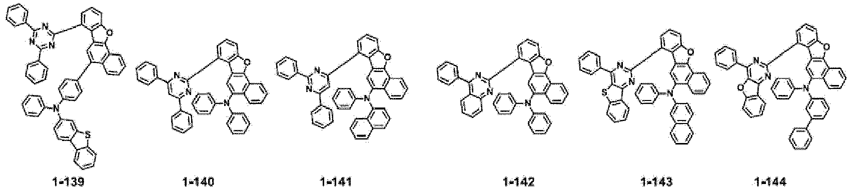

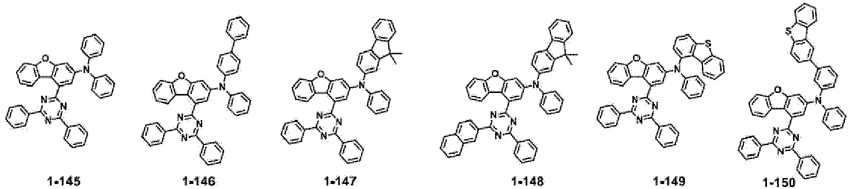

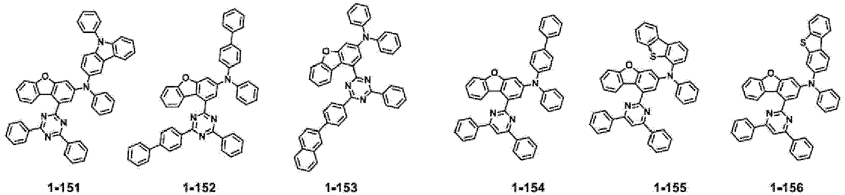

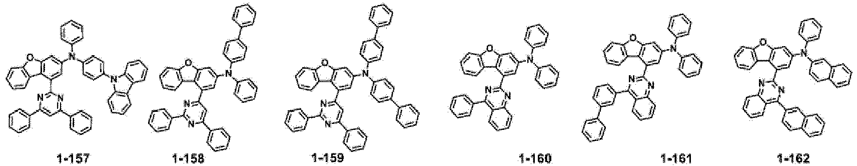

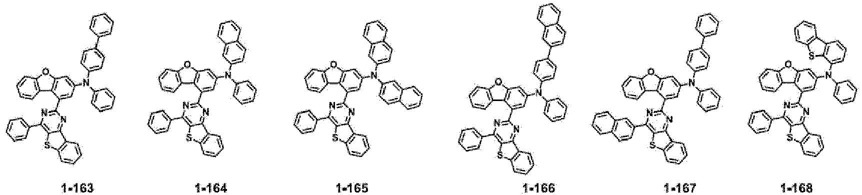

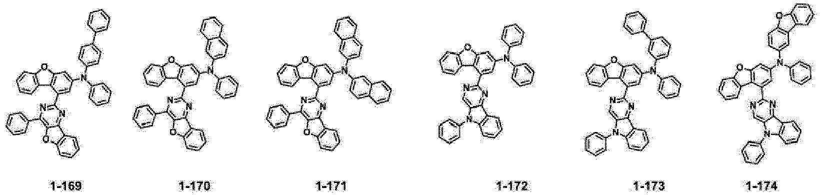

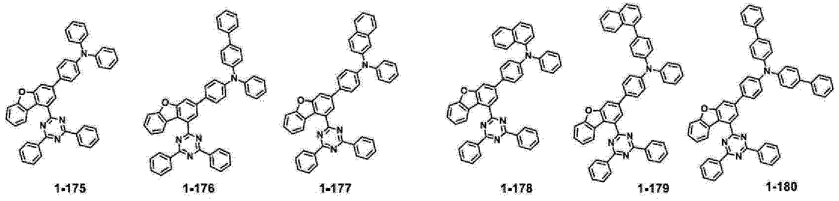

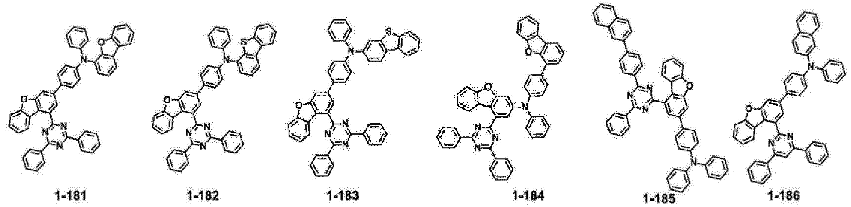

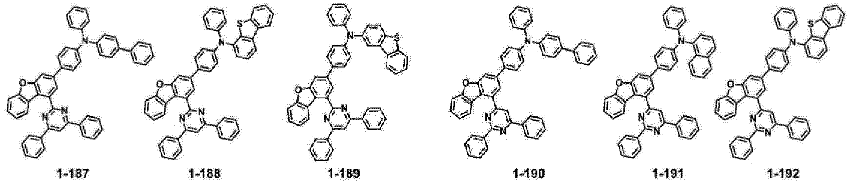

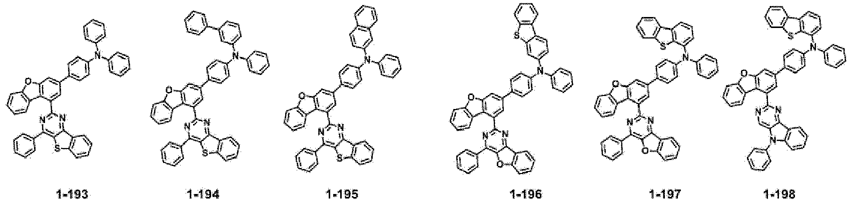

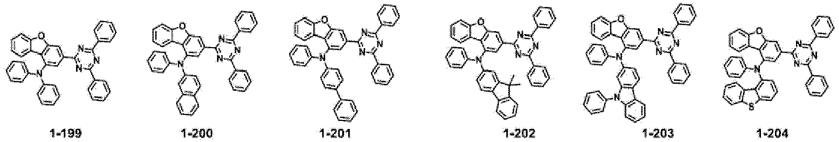

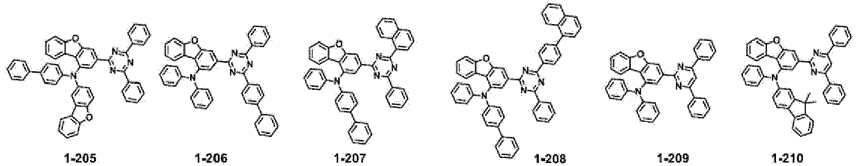

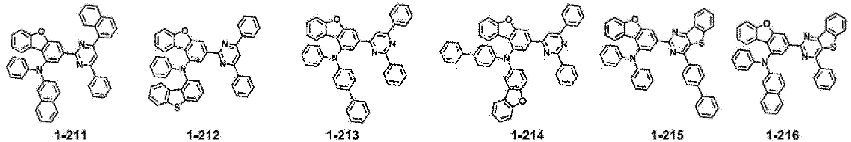

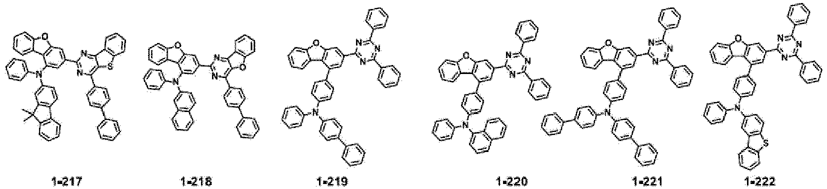

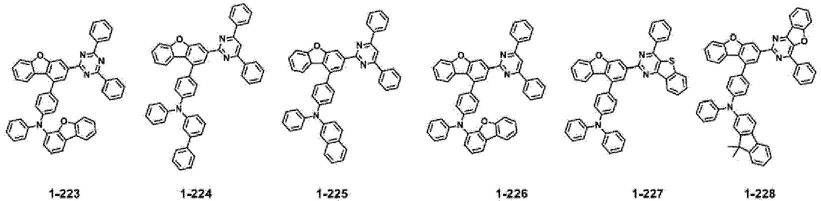

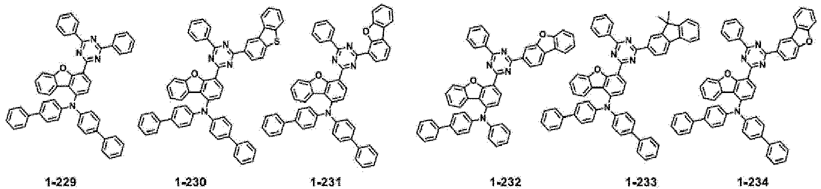

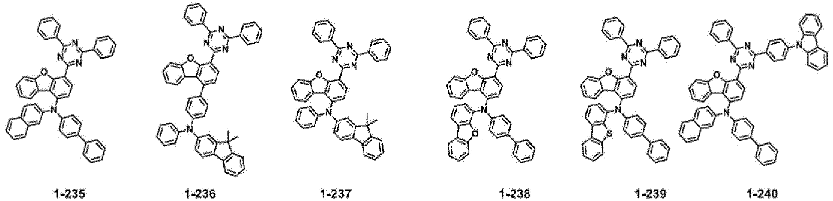

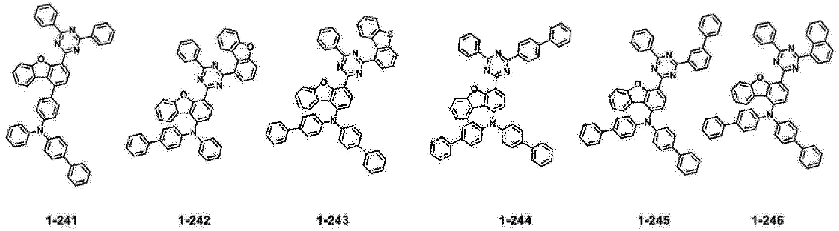

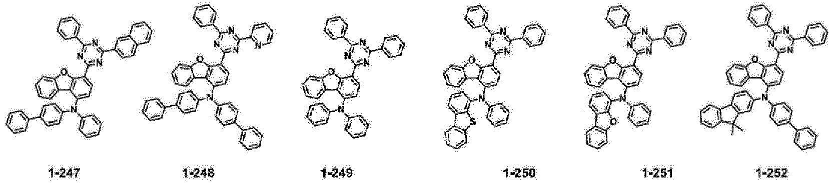

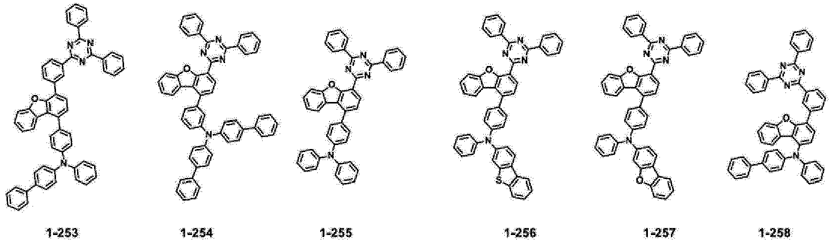

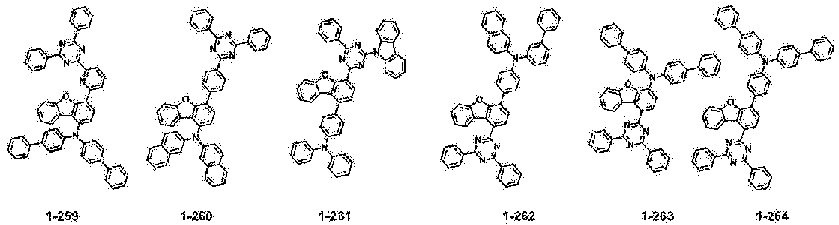

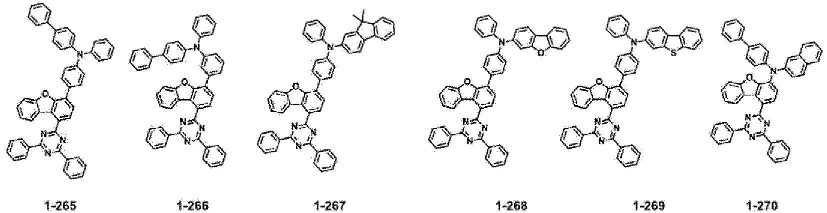

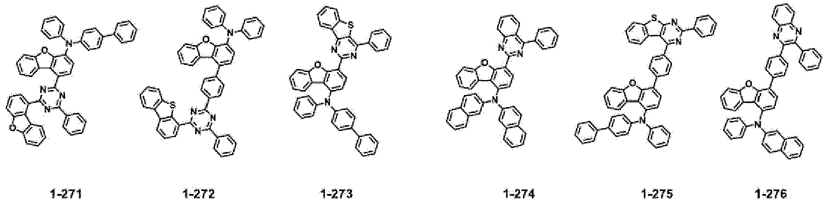

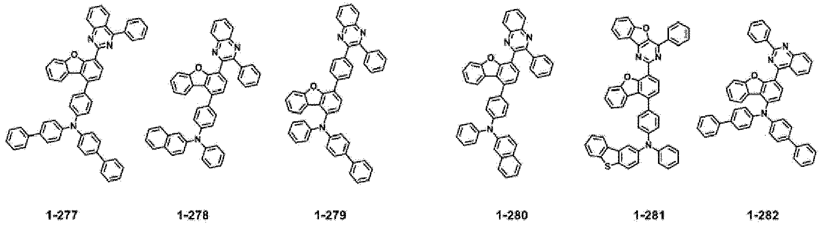

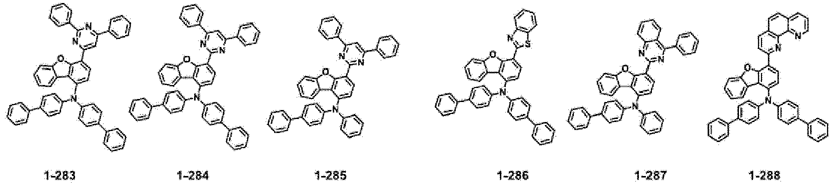

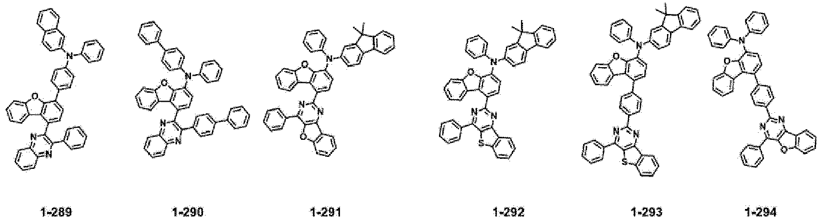

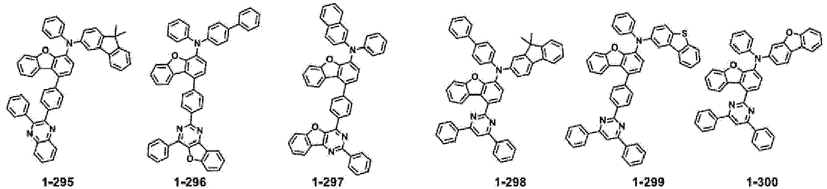

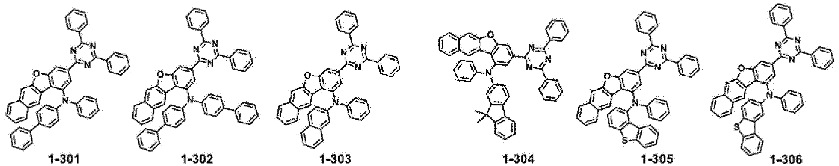

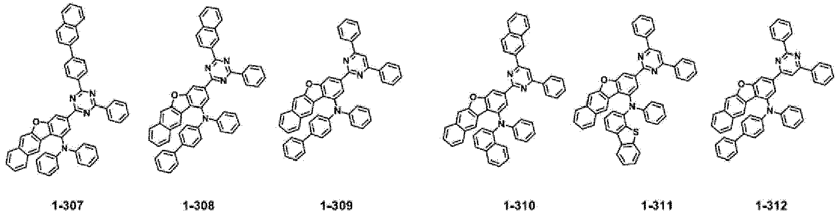

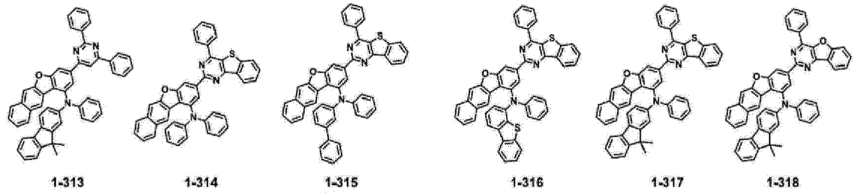

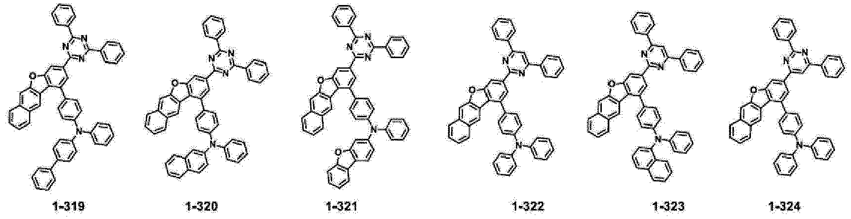

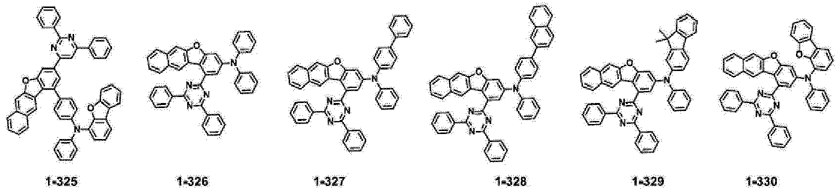

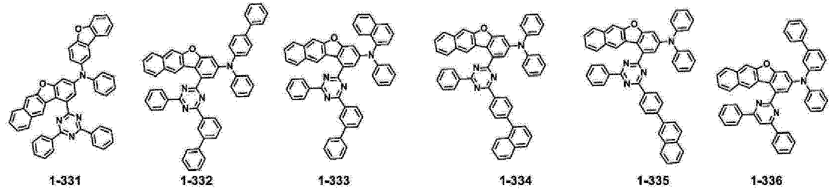

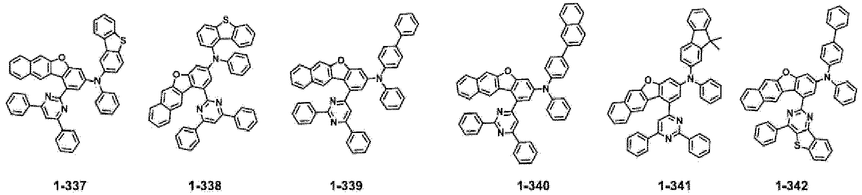

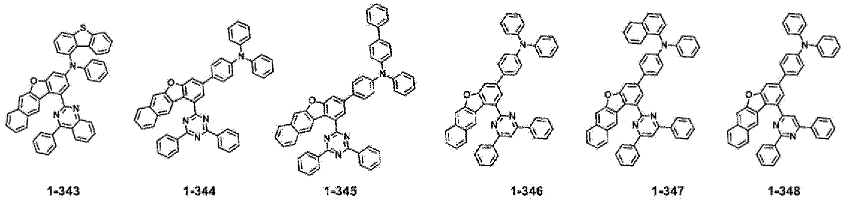

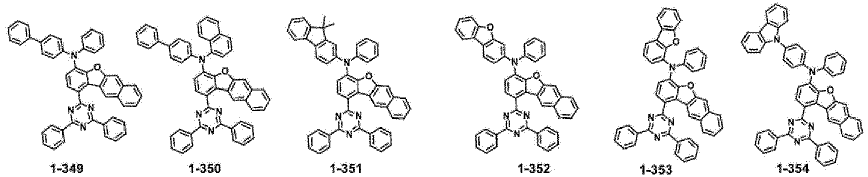

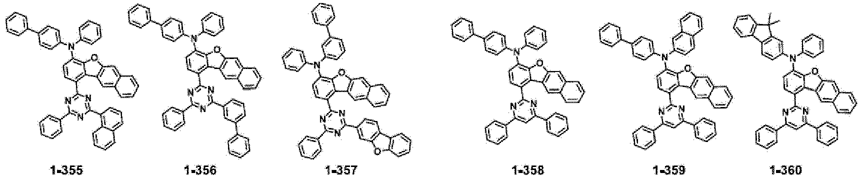

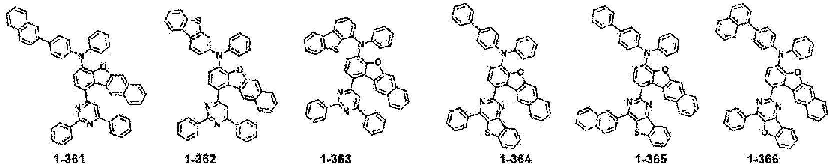

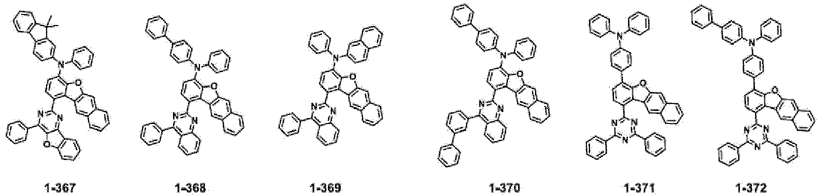

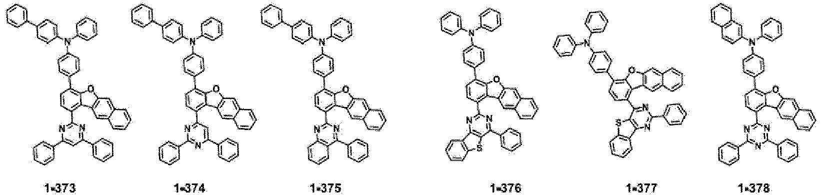

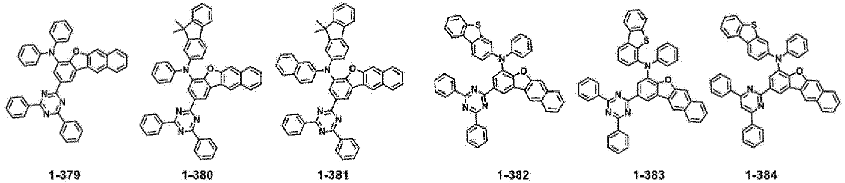

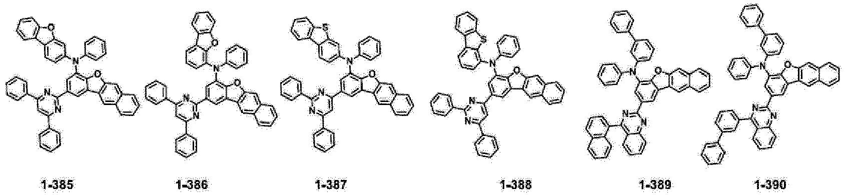

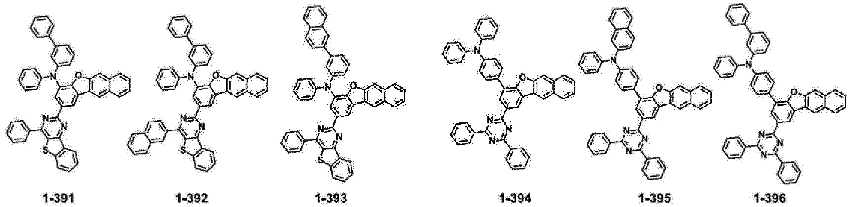

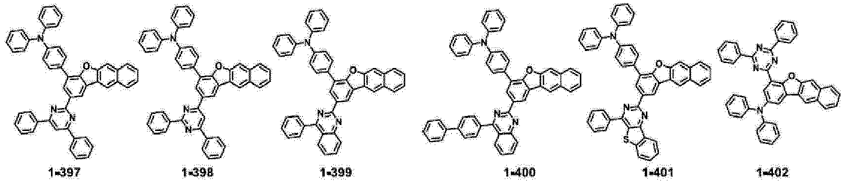

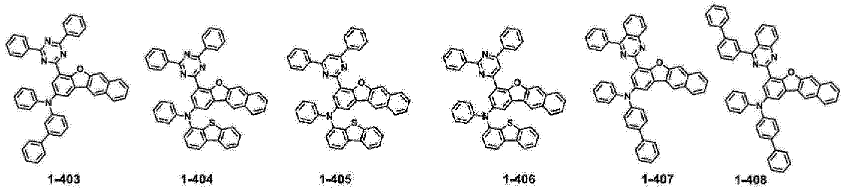

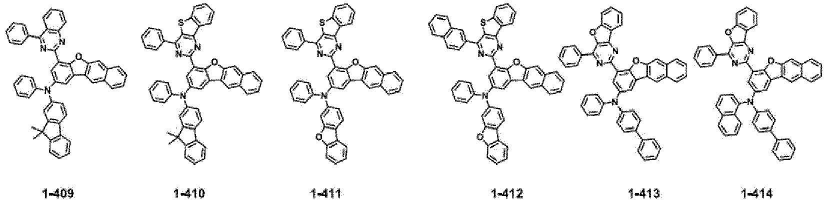

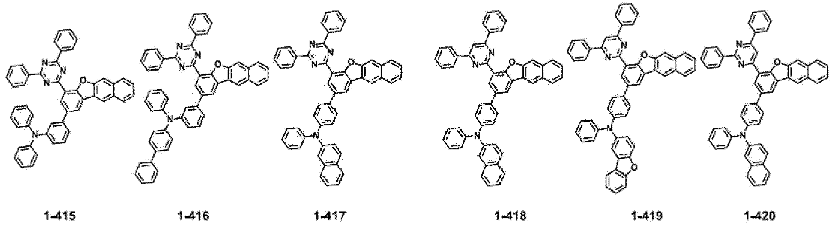

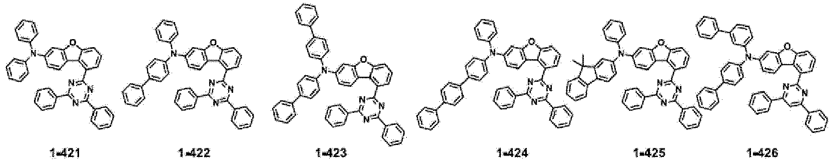

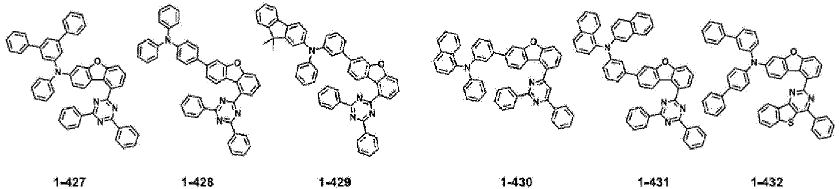

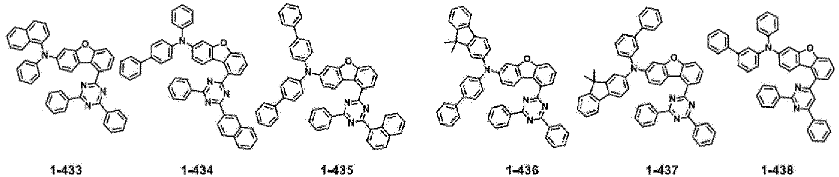

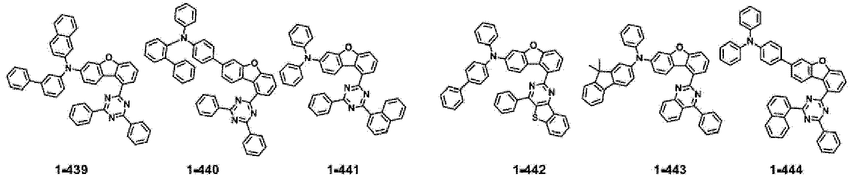

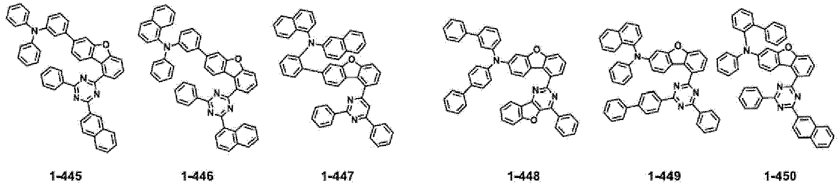

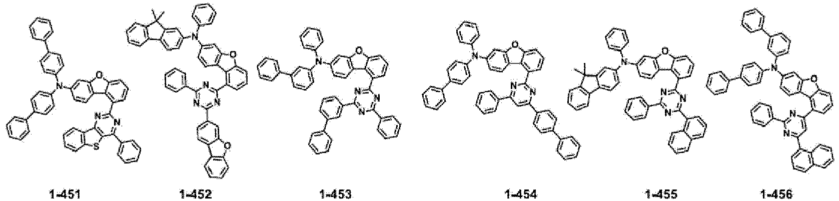

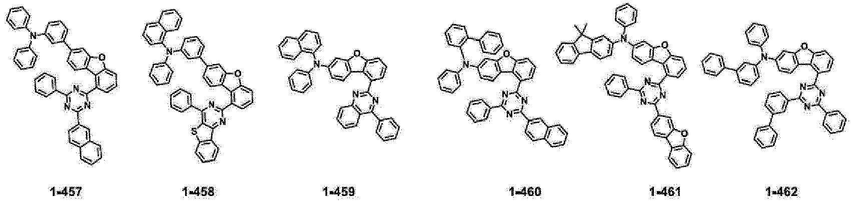

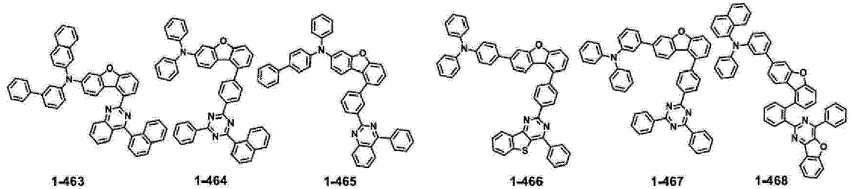

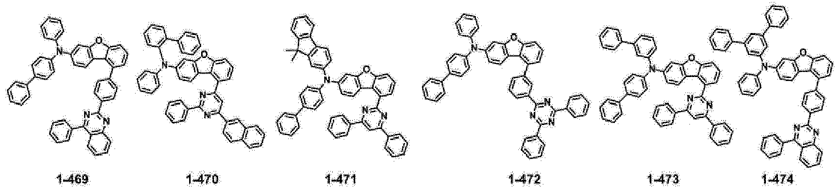

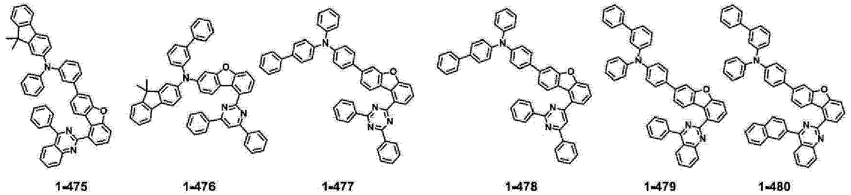

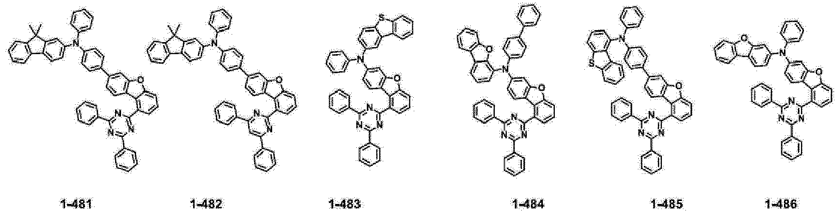

6. The organic light emitting device of Claim 1, wherein Chemical Formula 2 is represented by any one of the following compounds:

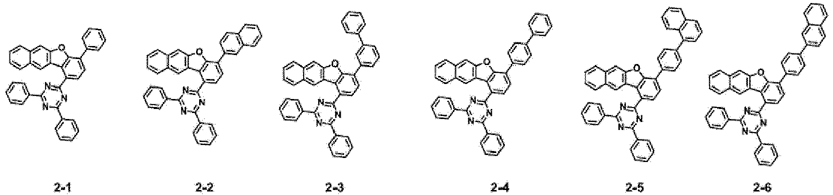

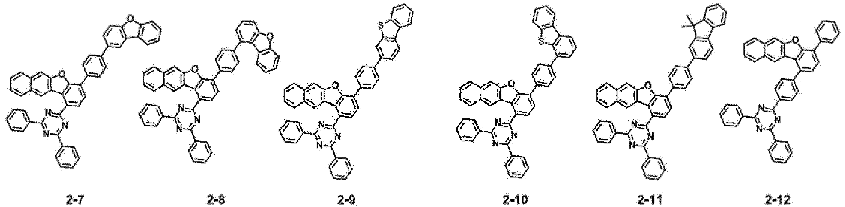

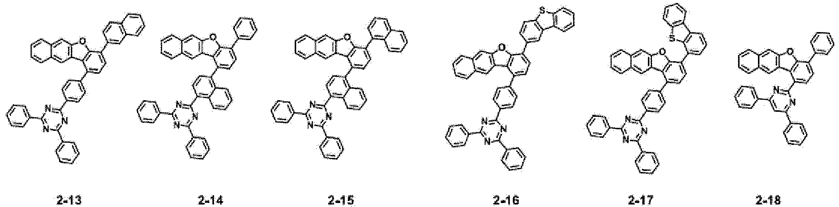

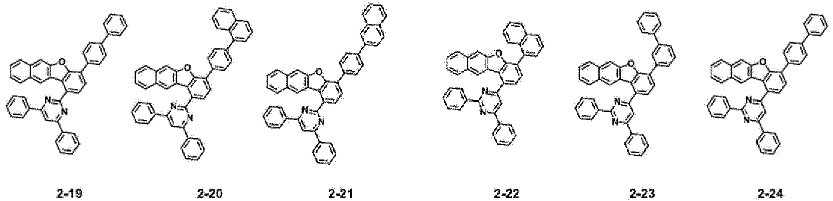

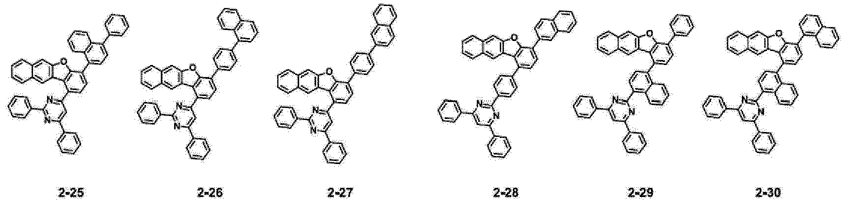

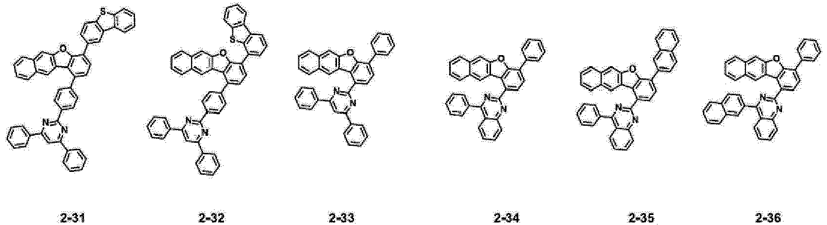

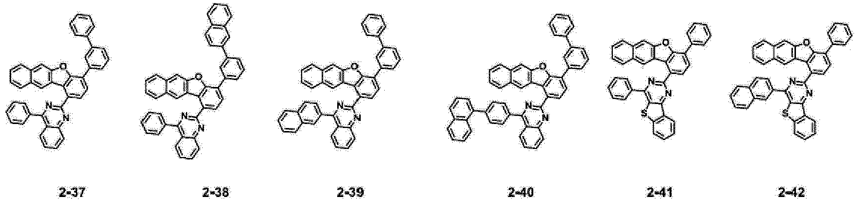

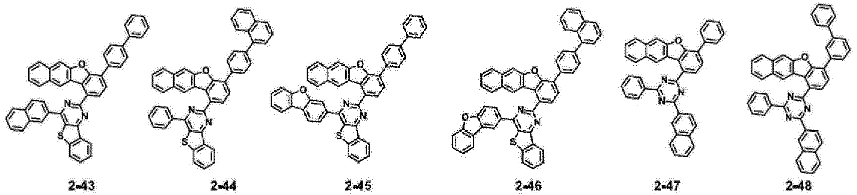

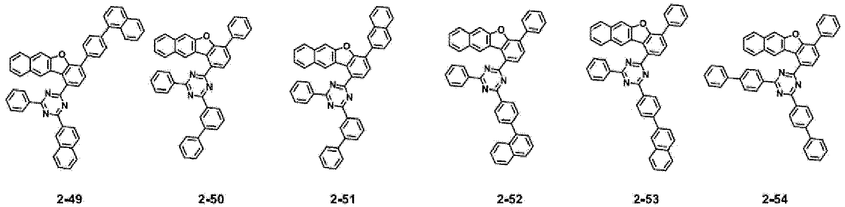

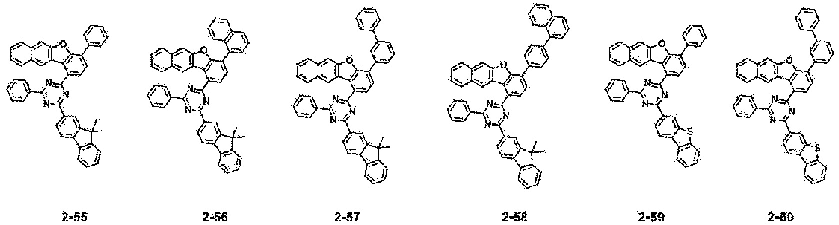

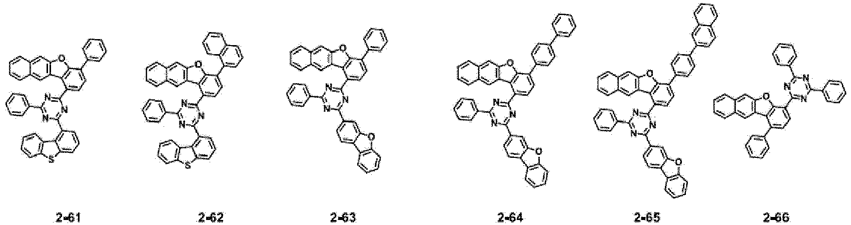

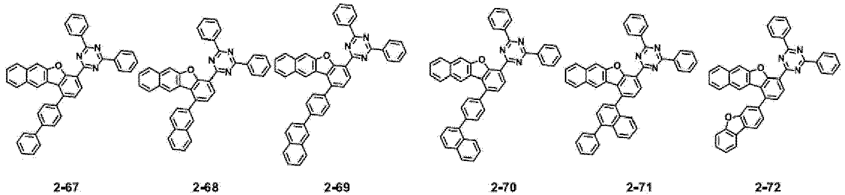

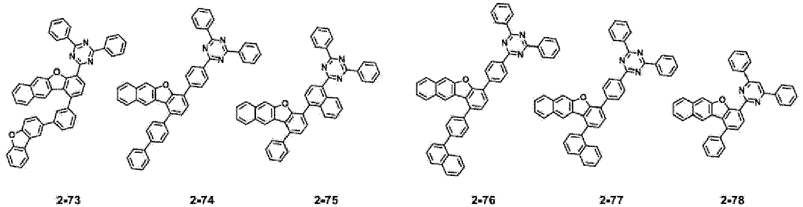

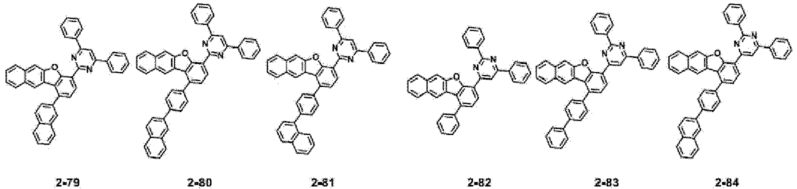

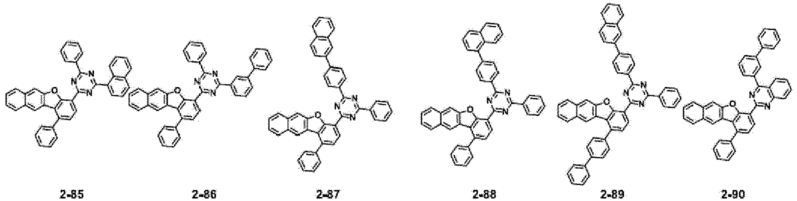

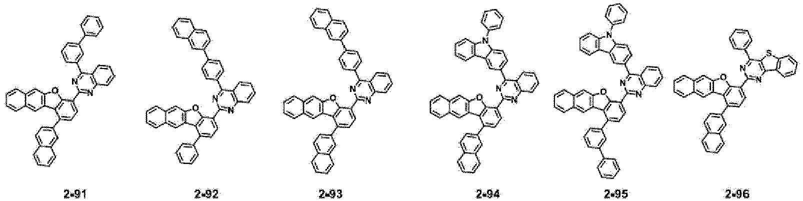

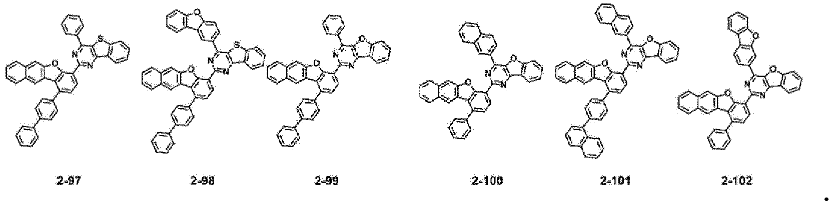

7. The organic light emitting device of Claim 1, wherein the organic material layer includes an electron transfer layer, and the electron transfer layer includes a compound of the following Chemical Formula 3: 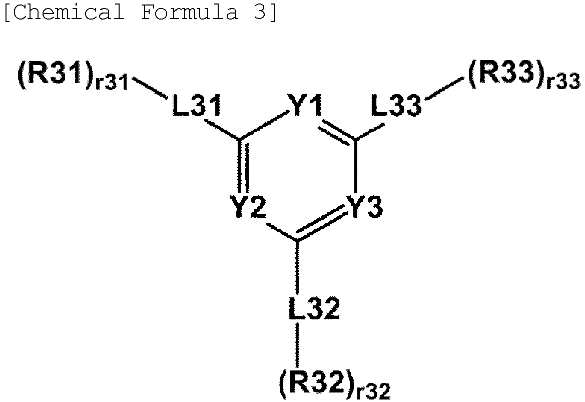 in Chemical Formula 3,
Y1 to Y3 are the same as or different from each other, and each independently N or CH,
at least one of Y1 to Y3 is N,
L31 to L33 are the same as or different from each other, and each independently a direct bond; a C6 to C60 arylene group; or a C2 to C60 heteroarylene group,
R31 to R33 are the same as or different from each other, and each independently a cyano group; a substituted or unsubstituted C6 to C60 aryl group; or a substituted or unsubstituted C2 to C60 heteroaryl group, and
r31 to r33 are each an integer of 0 to 5, and when each 2 or greater, substituents in the parentheses are the same as or different from each other.

8. The organic light emitting device of Claim 7, wherein Chemical Formula 3 is represented by any one of the following compounds:

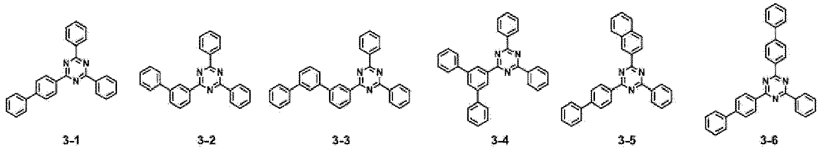

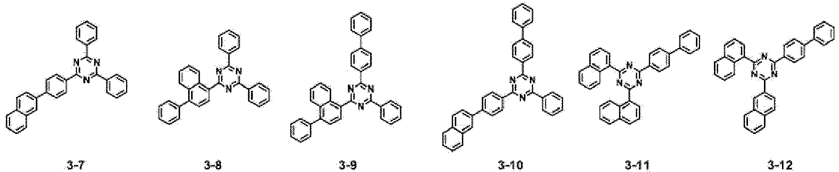

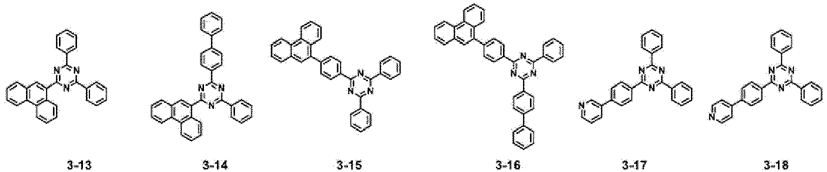

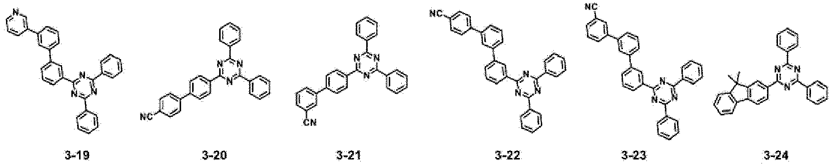

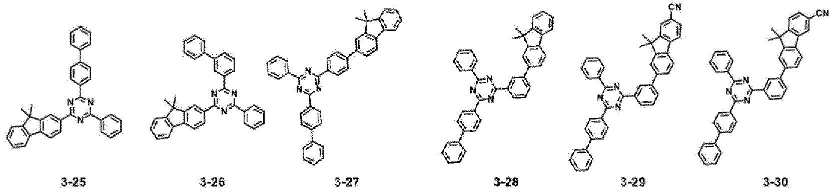

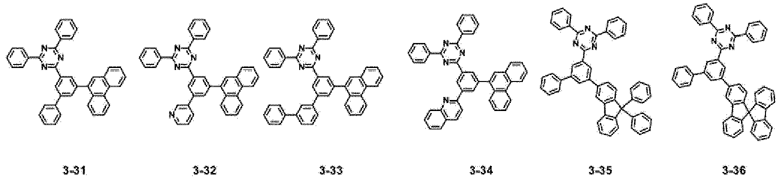

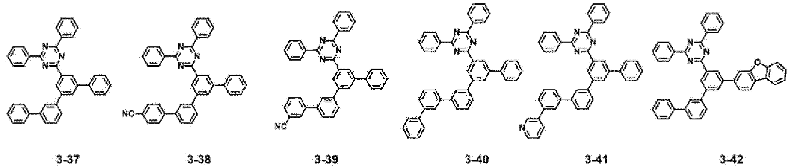

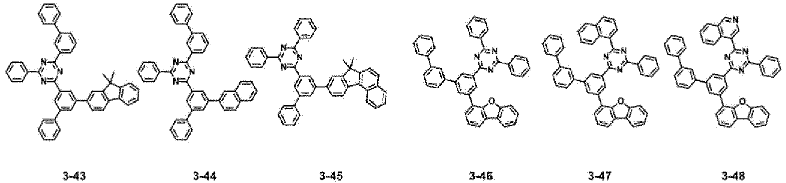

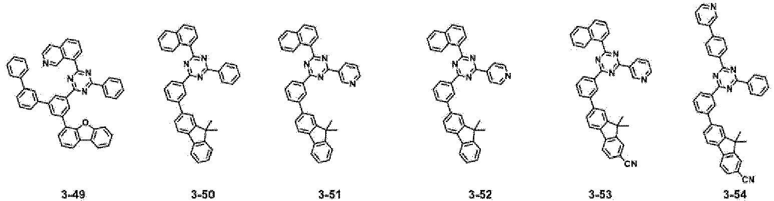

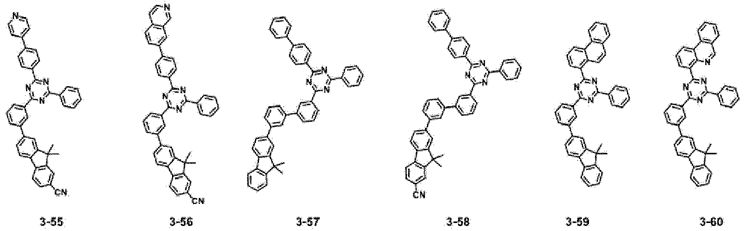

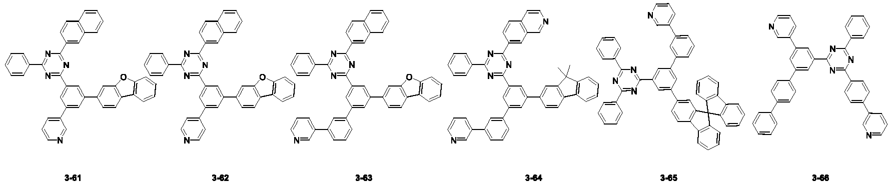

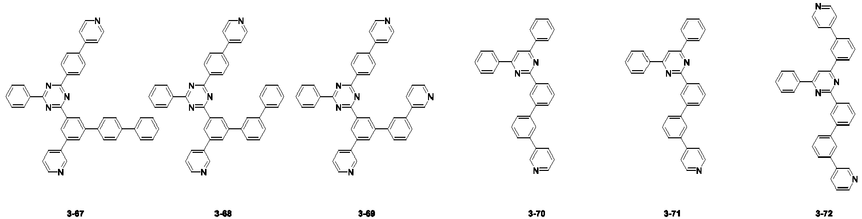

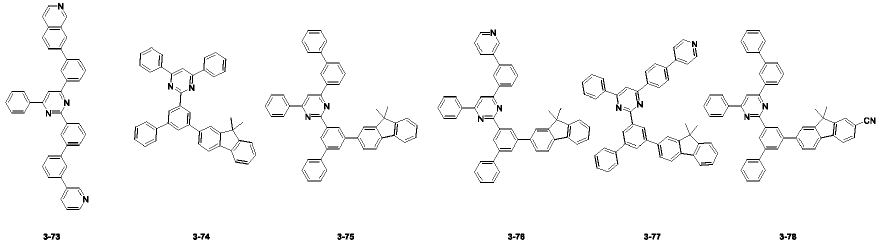

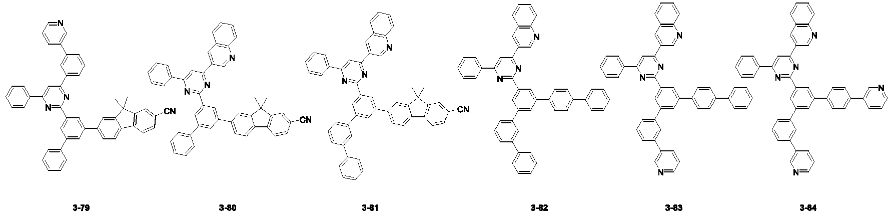

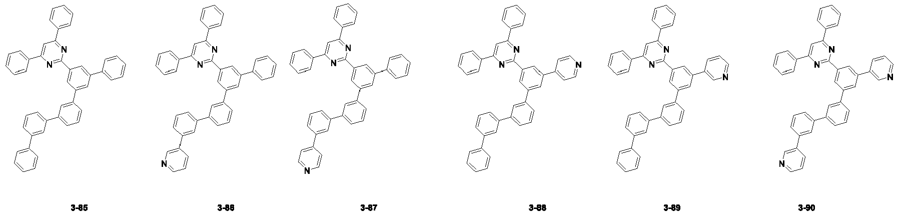

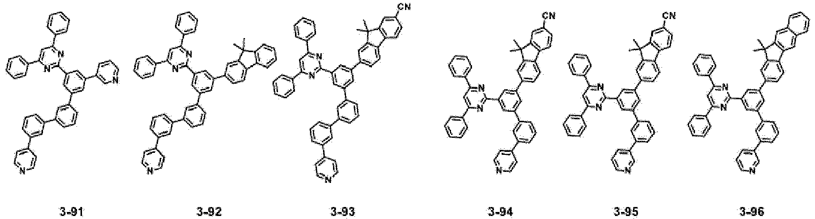

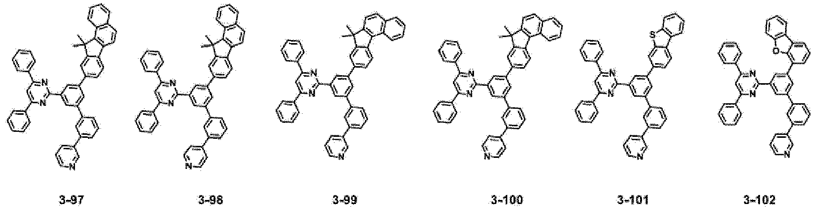

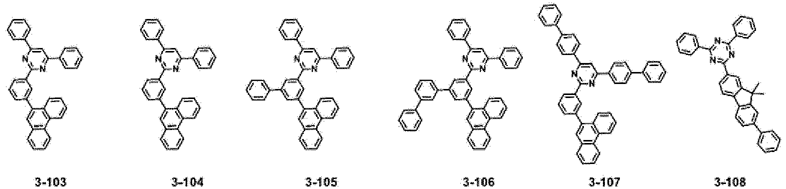

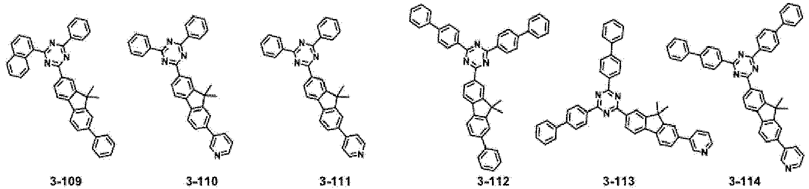

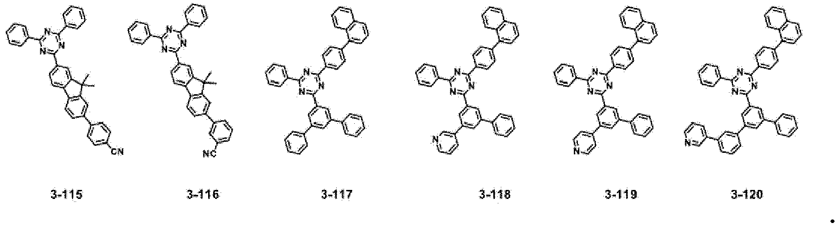

9. The organic light emitting device of Claim 1, wherein the organic material layer includes a hole transfer layer, and the hole transfer layer includes a compound of the following Chemical Formula 4: 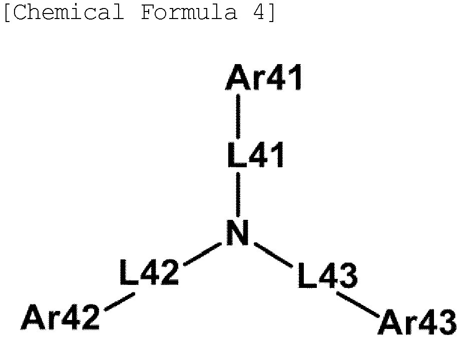 in Chemical Formula 4,
L41 to L43 are the same as or different from each other, and each independently a direct bond; or a C6 to C60 arylene group, and
Ar41 to Ar43 are the same as or different from each other, and each independently a substituted or unsubstituted C6 to C60 aryl group; or a substituted or unsubstituted C2 to C60 heteroaryl group.

10. The organic light emitting device of Claim 9, wherein Chemical Formula 4 is represented by any one of the following compounds:

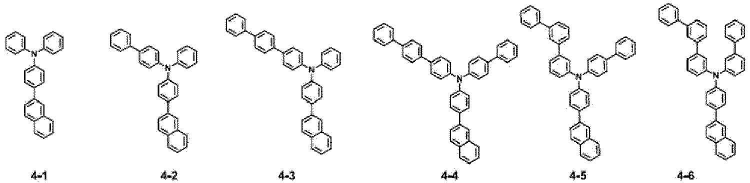

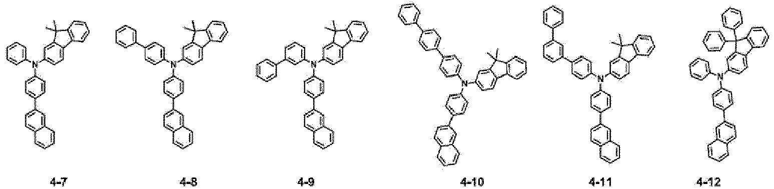

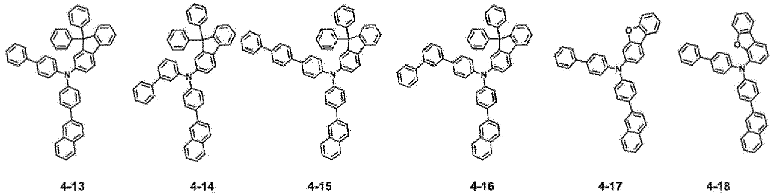

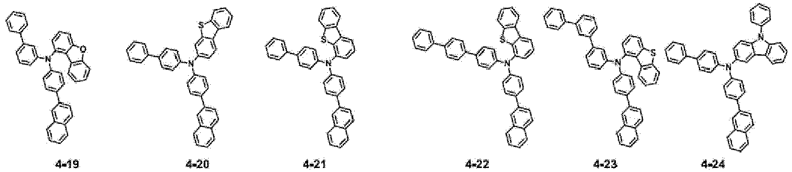

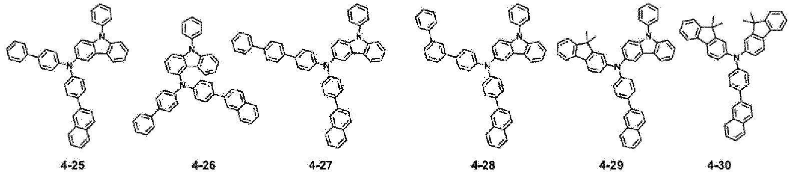

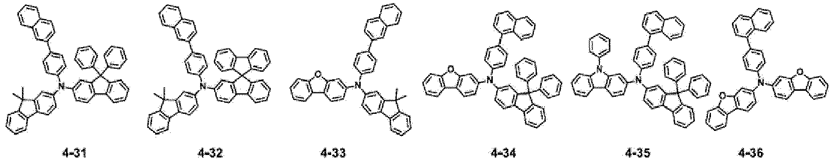

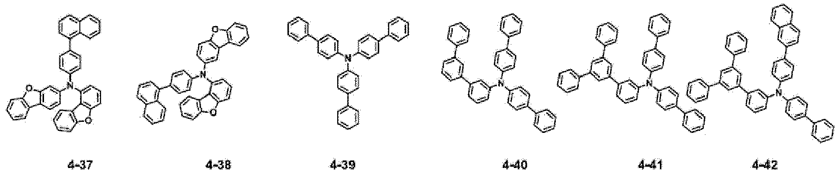

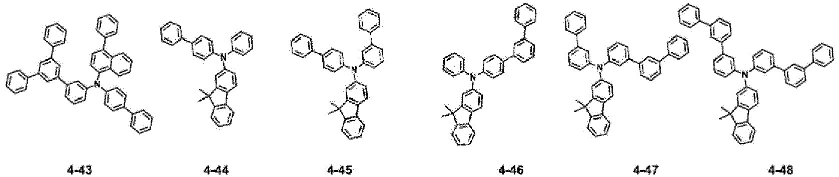

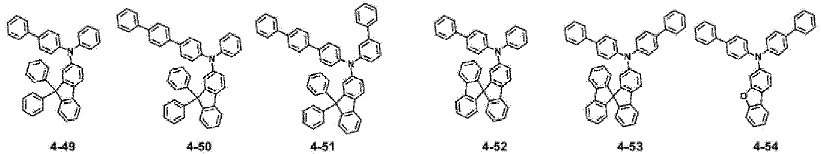

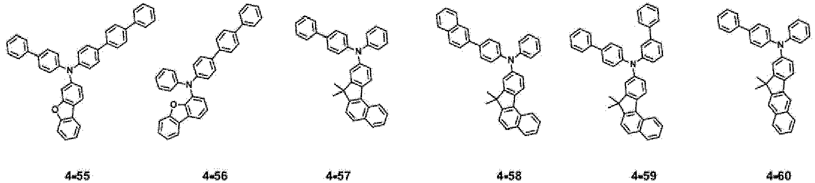

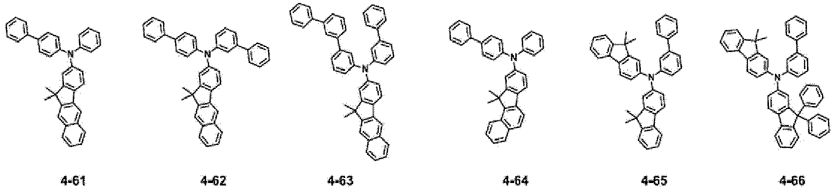

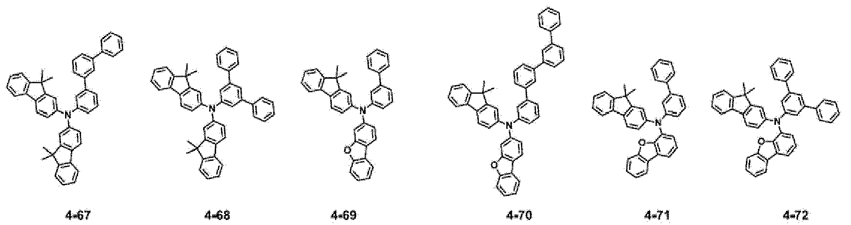

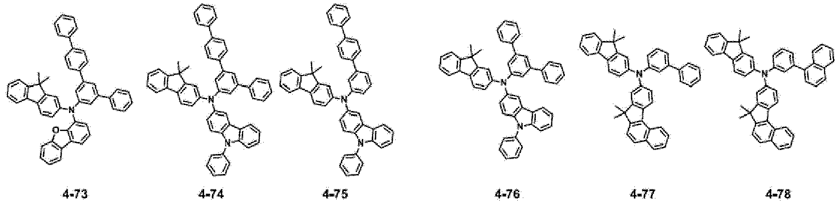

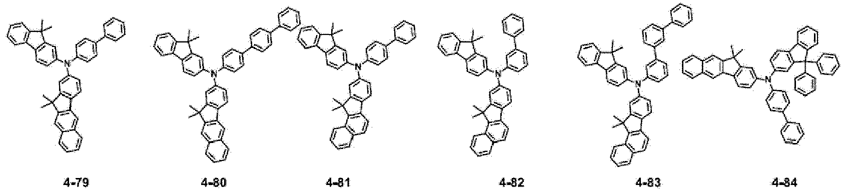

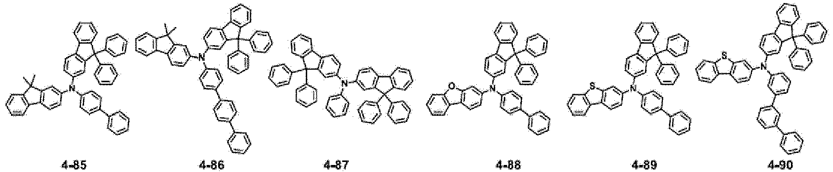

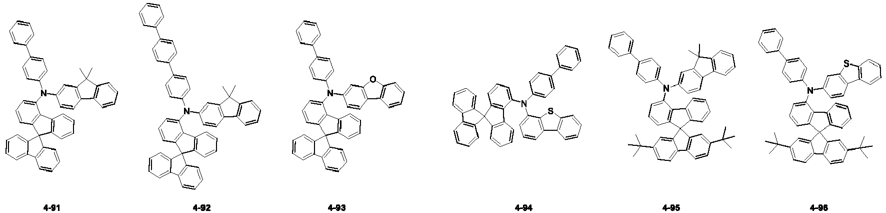

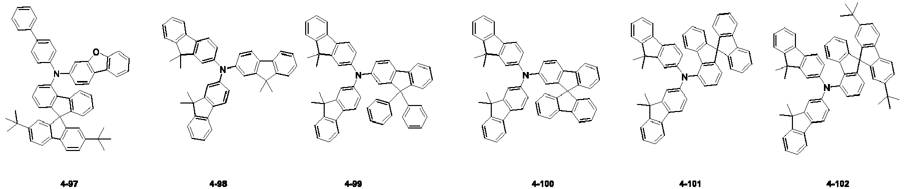

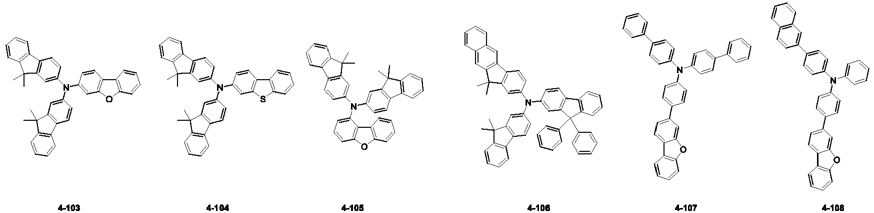

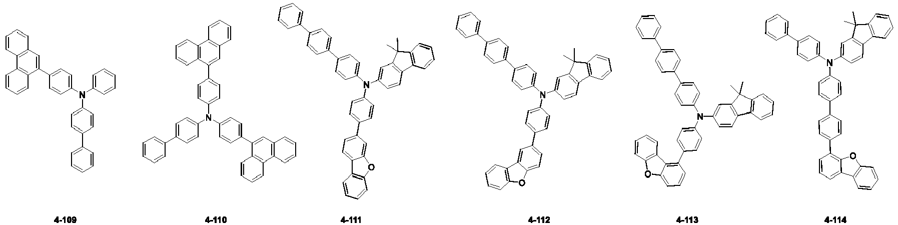

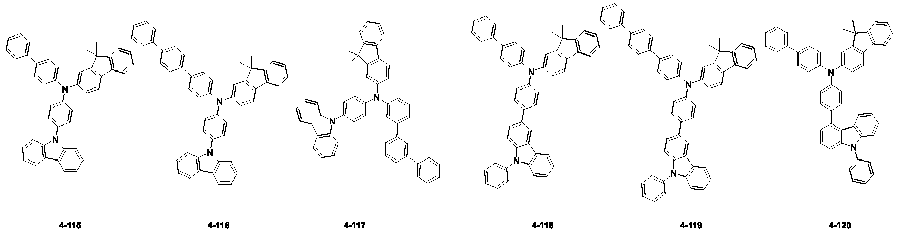

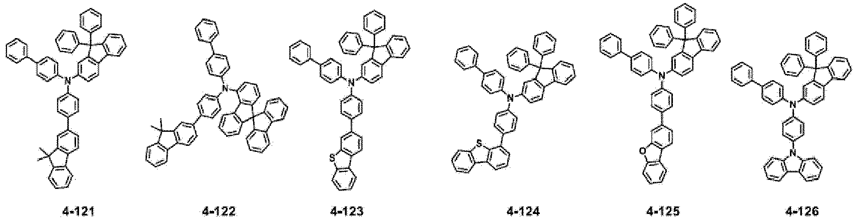

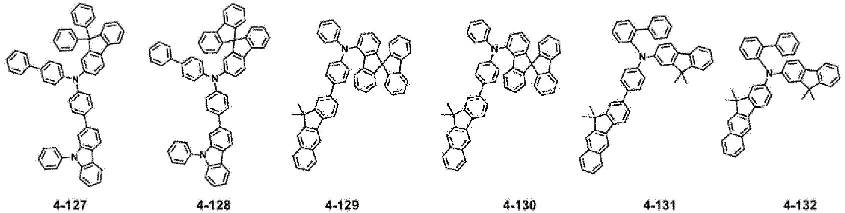

11. A composition for forming an organic material layer, the composition comprising:
a compound of the following Chemical Formula 1; and
a compound of the following Chemical Formula 2: 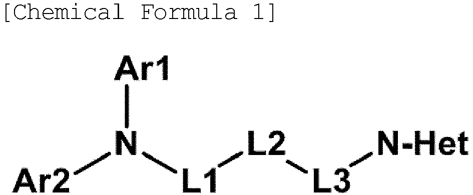
wherein, in Chemical Formula 1,
L1 to L3 are the same as or different from each other, and each independently a direct bond; a C6 to C60 arylene group; a monocyclic heteroarylene group including N; or a tricyclic or higher heteroarylene group including O,
Ar1 and Ar2 are the same as or different from each other, and each independently a substituted or unsubstituted C1 to C60 alkyl group; a substituted or unsubstituted C3 to C60 cycloalkyl group; a substituted or unsubstituted C6 to C60 aryl group; or a substituted or unsubstituted C2 to C60 heteroaryl group, and
N-Het is a C2 to C60 heteroaryl group substituted or unsubstituted and including N, 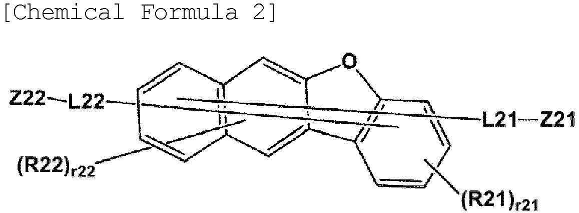 in Chemical Formula 2,
L21 and L22 are the same as or different from each other, and each independently a direct bond; a C6 to C60 arylene group; or a C2 to C60 heteroarylene group,
Z21 and Z22 are the same as or different from each other, and each independently a substituted or unsubstituted C6 to C60 aryl group; or a substituted or unsubstituted C2 to C60 heteroaryl group,
at least one of Z21 and Z22 is a C2 to C60 heteroaryl group substituted or unsubstituted and including N,
R21 and R22 are the same as or different from each other, and each independently hydrogen; deuterium; a halogen group; a cyano group; a substituted or unsubstituted C1 to C60 alkyl group; a substituted or unsubstituted C6 to C60 aryl group; or a substituted or unsubstituted C2 to C60 heteroaryl group,
r21 is an integer of 0 to 4,
r22 is an integer of 0 to 6, and
when r21 and r22 are each 2 or greater, substituents in the parentheses are the same as or different from each other.

12. The composition for forming an organic material layer of Claim 11, wherein the compound of Chemical Formula 1 and the compound of Chemical Formula 2 have a weight ratio of 1:10 to 10:1.
